(19) Europäisches Patentamt
European Patent Office
Office européen des brevets

(11) EP 4 741 402 A1

(12) **EUROPEAN PATENT APPLICATION**

(43) Date of publication:
**13.05.2026 Bulletin 2026/20**

(21) Application number: **25212713.9**

(22) Date of filing: **31.10.2025**

(51) International Patent Classification (IPC):
***C07F 5/02*** *(2006.01)* ***C07F 7/08*** *(2006.01)*
***C09K 11/06*** *(2006.01)* ***H10K 50/11*** *(2023.01)*

(52) Cooperative Patent Classification (CPC):
**C07F 7/0812; C07F 5/027; C09K 11/06; H10K 50/11;** C07B 2200/05

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **06.11.2024 CN 202411574952**

(71) Applicants:
- **TCL China Star Optoelectronics Technology Co., Ltd.**
  **Shenzhen, Guangdong 518132 (CN)**
- **Guangzhou Chinaray Optoelectronic Materials Ltd.**
  **Guangzhou, Guangdong 510663 (CN)**

(72) Inventors:
- **SONG, Xinlong**
  **Shenzhen, Guangdong, 518132 (CN)**
- **LEI, Jinlong**
  **Shenzhen, Guangdong, 518132 (CN)**
- **DENG, Wenhong**
  **Shenzhen, Guangdong, 518132 (CN)**
- **FAN, Huaqiang**
  **Shenzhen, Guangdong, 518132 (CN)**
- **LIU, Fangyi**
  **Shenzhen, Guangdong, 518132 (CN)**
- **HE, Ruifeng**
  **Shenzhen, Guangdong, 518132 (CN)**
- **SONG, Jingyao**
  **Shenzhen, Guangdong, 518132 (CN)**

(74) Representative: **Berggren Oy**
**P.O. Box 16**
**Fabianinkatu 21**
**00101 Helsinki (FI)**

(54) **ORGANIC COMPOUND, MIXTURE, COMPOSITION, ORGANIC LIGHT-EMITTING DEVICE, AND DISPLAY PANEL**

(57) An organic compound having a structure represented by the following formula (1) or (2), where $Ar_1$ and $Ar_2$ are independently selected from a substituted or unsubstituted aryl group having 6-60 carbon atoms, or a substituted or unsubstituted heteroaryl group having 5-60 carbon atoms; $Ar_3$ and $Ar_4$ are independently selected from an aryl group having 6-60 carbon atoms; and at least one of $Ar_1$, $Ar_2$, $Ar_3$, $Ar_4$, $R_1$, and $R_2$ contains a linear silanyl group having 1-20 carbon atoms, a branched silanyl group having 1-20 carbon atoms, or a deuterated phenyl group.

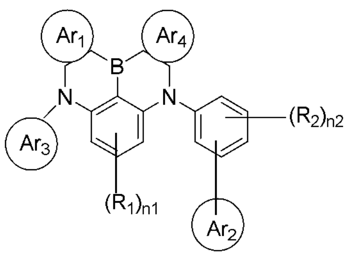
(1),

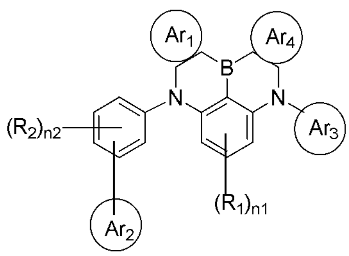
(2)

EP 4 741 402 A1

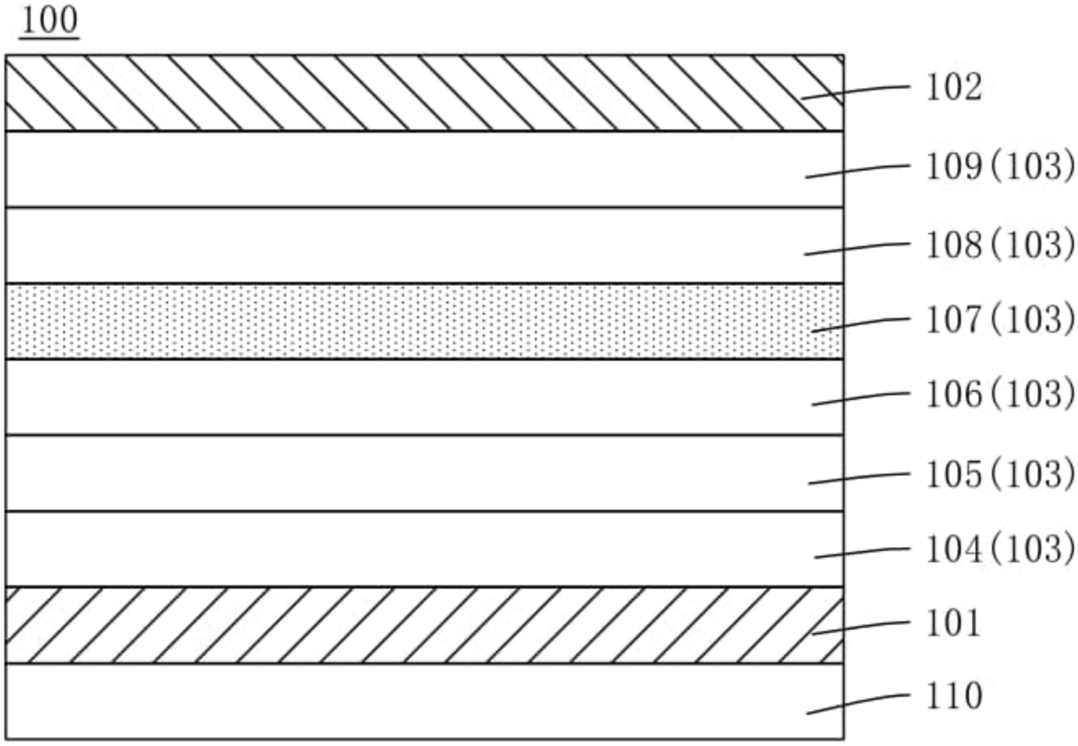


FIG. 4

## Description

### TECHNICAL FIELD

The present application relates to the field of display technologies, and in particular, to an organic compound, a mixture, a composition, an organic light-emitting device, and a display panel.

### BACKGROUND

At present, an organic electroluminescent device includes an anode, a cathode, and an organic layer disposed between the anode and the cathode. Organic substances in the organic layer convert electrical energy into light energy to achieve organic electroluminescence. In order to improve the luminous efficiency and service life of the organic electroluminescent device, the organic layer is often composed of multiple layers and organic compounds in different layer are different. Specifically, the organic layer includes a hole injection layer, a hole transport layer, a light-emitting layer, an electron transport layer, an electron injection layer, and the like. A voltage is applied between the anode and the cathode of the organic electroluminescent device, holes in the anode are injected into the organic layer, and electrons in the cathode are injected into the organic layer, the injected holes meet with the injected electrons to form excitons, and the excitons emit light when transitioning back to the ground state, thereby achieving the luminescence of the organic electroluminescent device. The organic electroluminescent device has wide application prospect due to its characteristics of autonomous luminescence, high brightness, high efficiency, low driving voltage, wide viewing angle, high contrast ratio, high responsiveness, and the like.

In order to improve the luminous efficiency of the organic electroluminescent device, various light-emitting material systems based on fluorescence and phosphorescence have been developed. The organic electroluminescent device using a fluorescence material has the characteristic of high reliability, but its internal electroluminescence quantum efficiency is limited to 25% under electrical excitation due to the fact that the branch ratio of excitons in a singlet excited-state and a triplet excited-state is 1:3. The organic electroluminescent device using a phosphorescence material has achieved almost 100% internal electroluminescence quantum efficiency. However, the phosphorescence material is a metal complex containing iridium and platinum that are expensive raw materials, the synthesis of the metal complex is complicated, and the organic electroluminescent device using the phosphorescence material may produce a roll-off effect, that is, the luminous efficiency of the organic electroluminescent device using the phosphorescence material may rapidly decrease with an increase of current or brightness, which limit the use of the phosphorescence material in the organic electroluminescent device at high brightness.

Furthermore, in order to solve the above problems, at present, light-emitting materials usually use a combination of various materials based on organic compounds, such as a composite excited state material, a thermally activated delayed fluorescence (TADF) material, and the like, attempting to achieve higher luminous efficiency of the organic electroluminescent device comparable to the organic electroluminescent device using the phosphorescence material by using reverse internal conversion. However, the improvement of properties of traditional organic compounds including the TADF material is limited in terms of luminous efficiency and service life, making it difficult to improve the luminous efficiency and service life of the organic electroluminescent device using the organic compound including the TADF material.

### SUMMARY

The present application provides an organic compound, a mixture, a composition, an organic light-emitting device, and a display panel, which can improve the luminous efficiency and the service life of the organic light-emitting device.

The present application is set out in the appended set of claims.

By introducing aromatic rings and at least one of a silanyl group and a deuterated phenyl group into the organic compound, the embodiments of the present application effectively increase the relative molecular mass of the organic compound, make the molecular configuration and the molecular gap of the organic compound larger, and enable the organic compound to have better solubility, thereby facilitating the purification of the organic compound in the preparation process, improving the purity of the organic compound, and improving the luminous efficiency and service life of an organic light-emitting device using the organic compound.

### BRIEF DESCRIPTION OF THE DRAWINGS

FIG. 1 is a hydrogen nuclear magnetic resonance spectra (HNMR) of an organic compound M165 according to some

embodiments of the present application.

FIG. 2 is a HNMR of an organic compound M166 according to some embodiments of the present application.

FIG. 3 is a HNMR of an organic compound M167 according to some embodiments of the present application.

FIG. 4 is a schematic structural diagram of an organic light-emitting device according to some embodiments of the present application.

FIG. 5 is another schematic diagram of the organic light-emitting device according to some embodiments of the present application.

DETAILED DESCRIPTION

The following will provide detailed descriptions of the present application in conjunction with the drawings. It should be understood that the embodiments described herein are for the purpose of explaining the present application and are not intended to limit the present application. The order of description of the following embodiments below is not intended to limit the preferred order of the embodiments.

Unless otherwise specified, all terms (including technical and scientific terms) used herein have the same meanings as understood by an ordinary person skill in the art to which the inventive concept of the present application belongs. It can be understood that terms, such as those defined in commonly used dictionaries, should be construed to have the meanings consistent with their meanings in related art and the present application, and will not be construed in an idealized or overly formal sense unless clearly so defined herein.

In the present application, an aryl group, an aromatic group, and an aromatic ring system have the same meaning and may be interchanged.

In the present application, a heteroaryl group, a heteroaromatic group, and a heteroaromatic ring system have the same meaning and may be interchanged.

In the present application, a cycloalkyl group and a cyclic alkyl group have the same meaning and may be interchanged.

In the present application, "substituted" means that a hydrogen atom in a group to be substituted is substituted by a substituent group.

In the present application, a same substituent group at different substituent site may be independently selected from the same group or different groups. For example, if a formula includes multiple R groups, each of the R groups may be independently selected from the same group or different groups.

In the present application, "number of ring atoms" refers to a number of atoms constituting a ring of a structural compound obtained by atomic bonding, for example, a monocyclic compound, a fused ring compound, a cross-linked compound, a carbon ring compound, or a heterocyclic compound. In a ring substituted by a substituent group, the atoms contained in the substituent group are not included in the atoms forming the ring. The same applies to "number of ring atoms" described below unless otherwise specified. For example, the number of ring atoms in benzene is 6, the number of ring atoms in naphthalene is 10, and the number of ring atoms in thiophene is 5.

In the present application, "substituted or unsubstituted" means that a defined group may be substituted or not be substituted. When the defined group is substituted, it can be understood that the defined group may be substituted by one or more substituent R groups. The R groups are independently selected from, but not limited to, a deuterium atom, a cyanoyl group, an isocyanoyl group, a nitro group, a halogen atom (for example, F, Cl, Br, or I), an alkyl group having 1-20 carbon atoms, a heterocyclic group having 3-20 ring atoms, an aromatic group having 6-20 ring atoms, a heteroaromatic group having 5-20 ring atoms, -NR’R", a silanyl group, a carbonyl group, an alkoxycarbonyl group, an aryloxycarbonyl group, an aminoformyl group, a haloformyl group, a formyl group, an isocyanate group, a thiocyanate group, an isothiocyanate group, a hydroxyl group, or a trifluoromethyl group, and the groups may further be substituted by acceptable substituent groups in the art. Understandably, R’ and R" in the NR’R" are independently selected from, but not limited to, H, a deuterium atom, a cyanoyl group, an isocyanoyl group, a nitro group, a halogen atom (for example, F, Cl, Br, or I), an alkyl group having 1-10 carbon atoms, a heterocyclic group having 3-20 ring atoms, an aromatic group having 6-20 ring atoms, or a heteroaromatic group having 5-20 ring atoms. In some embodiments, R is selected from, but not limited to, a deuterium atom, a cyanoyl group, an isocyanoyl group, a nitro group, a halogen atom (for example, F, Cl, Br, or I), an alkyl group having 1-10 carbon atoms, a heterocyclic group having 3-10 ring atoms, an aromatic group having 6-20 ring atoms, a heteroaromatic group having 5-20 ring atoms, a silanyl group, a carbonyl group, an alkoxycarbonyl group, an aryloxycarbonyl group, an aminoformyl group, a haloformyl group, a formyl group, an isocyanate group, a thiocyanate group, an isothiocyanate group, a hydroxyl group, or a trifluoromethyl group, and the groups may further be substituted by acceptable substituent groups in the art.

In the present application, "an aryl group or an aromatic group" refers to an aromatic hydrocarbon group derived from a basis of an aromatic ring compound removing one hydrogen atom. The aromatic hydrocarbon group may be a monocyclic aryl group, a fused ring aryl group, or a polycyclic aryl group. For a polycyclic ring type, at least one ring is an aromatic ring system. For example, "a substituted or unsubstituted aryl group having 6-40 ring atoms" refers to an aryl group having 6-40 ring atoms, a substituted or unsubstituted aryl group having 6-30 ring atoms, a substituted or unsubstituted aryl group having 6-18 ring atoms, or a substituted or unsubstituted aryl group having 6-14 ring atoms, and the aryl group is optionally further substituted. Suitable examples of the aryl group or the aromatic group include, but not limited to, a phenyl group, a biphenyl group, a triphenyl group, a naphthyl group, an anthracyl group, a phenanthryl group, a fluoranthenyl group, a triphenylene group, a pyrenyl group, a perylene group, a tetraphenyl group, a fluorenyl group, an acenaphthenyl group, and derivatives thereof. Understandably, multiple aryl groups may further be disconnected by short non-aromatic units (for example, a non-hydrogenium atom contenting less than 10%, such as C, N, or O). In some embodiments, a 9,9-diarylfluorene group, a triarylamine group, or a diaryl ether system may be further included in the definition of the aryl group.

In the present application, "a heteroaryl group or a heteroaromatic group" refers to a basis of an aryl group with at least one carbon atom replaced by a non-carbon atom, and the non-carbon atom may be N, O, S, or the like. For example, "a substituted or unsubstituted heteroaryl group having 5-40 ring atoms" refers to a heteroaryl group having 5-40 ring atoms, a substituted or unsubstituted heteroaryl group having 6-30 ring atoms, a substituted or unsubstituted heteroaryl group having 6-18 ring atoms, or a substituted or unsubstituted heteroaryl group having 6-14 ring atoms, and the heteroaryl group is optionally further substituted. Suitable examples of the heteroaryl group or the heteroaromatic group include, but not limited to, a thienyl group, a furyl group, a pyrrolyl group, an imidazolyl group, a diazole group, a triazole group, a pyridinyl group, a bipyridyl group, a pyrimidinyl group, a triazinyl group, an acridinyl group, a pyridazinyl group, a pyrazinyl group, a quinolinyl group, an isoquinolinyl group, a quinazolinyl group, a quinoxalinyl group, a phthalazinyl group, a pyridino pyrimidinyl group, a pyridino pyrazinyl group, a benzothiophenyl group, a benzofuranyl group, an indolyl group, a pyrrolo imidazolyl group, a pyrrolopyrrolyl group, a thiophenopyrrolyl group, a thiophenothiophenyl group, a furanopyrrolyl group, a furanofuranyl group, a thiophenofuranyl group, a benzoisoxazolyl group, a benzoisothiazolyl group, a benzimidazolyl group, an ortho-diazonaphthalyl group, a phenanthridinyl group, a berberine group, a quinazolinketone group, a dibenzothiophenyl group, a dibenzofuranyl group, a carbazolyl group, and derivatives thereof.

In the present application, "an alkyl group" refers to a linear alkyl group, a branched alkyl group, or a cyclic aliphatic hydrocarbon group. The number of carbon atoms in the alkyl group may range from 1 to 50, 1 to 30, 1 to 20, 1 to 10, or 1 to 6. The term having the alkyl group, such as "a $C_{1-9}$ alkyl group", refers to an alkyl group having 1 to 9 carbon atoms. The $C_{1-9}$ alkyl group is independently selected from a $C_1$ alkyl group, a $C_2$ alkyl group, a $C_3$ alkyl group, a $C_4$ alkyl group, a $C_5$ alkyl group, a $C_6$ alkyl group, a $C_7$ alkyl group, a $C_8$ alkyl group, or a $C_9$ alkyl group at each occurrence. Examples of the alkyl group include, but not limited to, methyl, ethyl, n-propyl, isopropyl, n-butyl, sec-butyl, tert-butyl, isobutyl, 2-ethylbutyl, 3,3-dimethylbutyl, n-pentyl, isopentyl, neopentyl, tert-pentyl, cyclopentyl, 1-methylpentyl, 3-methylpentyl, 2-ethylpentyl, 4-methyl-2-pentyl, n-hexyl, 1-methylhexyl, 2-ethylhexyl, 2-butyhexyl, cyclohexyl, 4-methylcyclohexyl, 4-tert-butylcyclohexyl, n-heptyl, 1-methylheptyl, 2,2-dimethylheptyl, 2-ethylheptyl, 2-butyl-heptyl, n-octyl, tert-octyl, 2-ethyloctyl, 2-butyloctyl, 2-hexyl-octyl, 3,7-dimethyloctyl, cyclooctyl, n-nonyl, n-decanyl, an adamantine group, 2-ethyldecyl, 2-butyldecyl 2-hexyldecyl, 2-octyldecyl, n-undecyl, n-dodecyl, 2-ethyldodecyl 2-butyldodecyl, 2-hexyldodecyl, 2-octyldodecyl, n-tridecyl, n-tetradecyl, n-pentadecyl, n-hexadecyl, 2-ethylhexadecyl, 2-butylhexadecyl, 2-hexylhexadecyl, 2-octylhexadecyl, n-heptadecyl, n-octadecyl, n-nonadecyl, n-eicosyl, 2-ethyleicosyl, 2-butyeicosyl, 2-hexyleicosyl, 2-octyleicosyl, n-heneicosyl, n-docosyl, n-tricosyl, n-tetracosyl, n-pentacosyl, n-hexacosyl, n-heptacosyl, n-octacosyl, n-nonacosyl, n-triacontyl, and the like.

In the present application, abbreviations of substituent groups are as follows: normal (n-), secondary (sec-), iso- (i-), tert- (t-), ortho- (o-), meta- (m-), para- (p-), methyl (Me), ethyl (Et), propyl (Pr), butyl (Bu), n-amyl (Am), hexyl (Hx), cyclohexyl (Cy), and phenyl (-Ph).

In the present application, "an amino group" refers to a derivative of the amine and has a structural feature of a group represented by formula $-N(X)_2$, where X is independently selected from -H, a substituted or unsubstituted alkyl group, a substituted or unsubstituted cycloalkyl group, a substituted or unsubstituted heterocyclic group, or the like. Examples of the amino group include, but not limited to, $-NH_2$, $-N(alkyl)_2$, -NH(alkyl), - $N(cycloalkyl)_2$, -NH(cycloalkyl), $-N(heterocyclic)_2$, -NH(heterocyclic), $-N(aryl)_2$, -NH(aryl), -N(alkyl)(aryl), - N(alkyl)(heterocyclic), -N(cycloalkyl)(heterocyclic), -N(aryl)(heteroaryl), -N(alkyl)(heteroaryl), and the like.

**In** the present application, "a cycloalkyl group" or "a cyclic alkyl group" refers to a monovalent group having one or more saturated rings in which all ring atoms are carbon atoms. "Alkyl groups" in the "cycloalkyl group" and the "cyclic alkyl group" have the same meaning as the "alkyl group" as defined above.

In the present application, "a heterocyclic group" or "heterocyclic" refers to a non-aromatic cyclic group that is fully saturated or partially unsaturated. The non-aromatic cyclic group has one or more heteroatoms, such as an oxygen atom, a sulfur atom, a silicon atom, or a nitrogen atom, where the nitrogen atom and the sulfur atom are optionally oxidized and the nitrogen atom is optionally quaternized. In some embodiments, the heterocyclic group is connected to any atom or any

carbon atom in a ring or a ring system, and the heterocyclic group is unsubstituted or substituted by one or more aryl groups as described above.

**In** the present application, unless otherwise specified, a hydroxyl group refers to -OH, a carboxyl group refers to -COOH, a carbonyl group refers to -C(=O)-, an amino group refers to $-NH_2$, a formyl group refers to -C(=O)H, a haloformyl group refers to -C(=O)Z (Z refers to a halogen atom, such as F, Cl, Br or I), a carbamoyl group refers to $-C(=O)NH_2$, an isocyanate group refers to -NCO, and an isothiocyanate group refers to-NCS.

**In** the present application, "an alkoxy group" refers to a group having a structure of "-O-alkyl", that is, the alkyl group as defined above is connected to other groups through an oxygen atom to form the alkoxy group. Suitable examples of the alkoxy group include, but not limited to, a methoxy group ($-O-CH_3$ or -OMe), an ethoxy group ($-O-CH_2CH_3$ or -OEt), and a tert-butoxy group ($-O-C(CH_3)_3$ or -OtBu).

In the present application, "*" connected to a single bond indicates a linking site or a fused site.

**In** the present application, when a linking site in a group is not specified, it means that any of connectable sites in the group may be selected as the linking site.

**In** the present application, when a fused site in a group is not specified, it means that any of fusible sites in the group may be selected as the fused site. For example, two or more adjacent sites in the group form a fused site.

In the present application, when there are more than one substituent groups with the same symbol on the same group, the substituent groups may be the same or different. For example, in formula

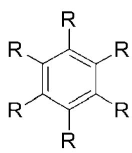

,

six R groups in a benzene ring may be the same or different.

In the present application, a single bond connected to a substituent group and penetrated a corresponding ring indicates that the substituent group may be connected to any site of the ring. For example,

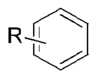

means that R may be connected to any substituent site of the benzene ring, and

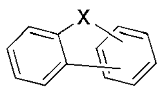

means that

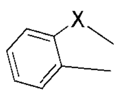

may be connected to any substituent site of

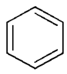

to form two rings connected to each other.

In the present application, "adjacent two groups" refer to two groups absent of substitutable sites between the two groups.

In the present application, "adjacent two $R_1$, adjacent two $R_3$, or adjacent two $R_5$ form a ring with each other" indicates that adjacent two $R_1$, adjacent two $R_3$, or adjacent two $R_5$ are connected to each other to form a ring system. In some embodiments, the ring system is selected from an aliphatic hydrocarbon ring, an aliphatic heterocyclic ring, an aromatic hydrocarbon ring, or an aromatic heterocyclic ring. For example, the ring system is

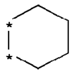, 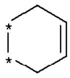, or 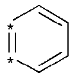.

Some embodiments of the present application provide an organic compound having a structure represented by the following formula (1) or (2):

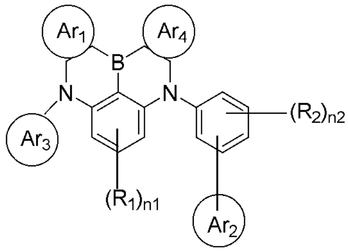 (1), 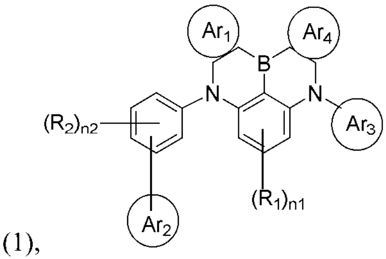 (2);

where $Ar_1$ and $Ar_2$ are independently selected from a substituted or unsubstituted aryl group having 6-60 carbon atoms, or a substituted or unsubstituted heteroaryl group having 5-60 carbon atoms;

$Ar_3$ and $Ar_4$ are independently selected from an aryl group having 6-60 carbon atoms;

$R_1$ and $R_2$ are independently selected from -H, -D, a $C_{1-20}$ linear alkyl group, a linear silanyl group having 1-20 carbon atoms, a branched silanyl group having 1-20 carbon atoms, a linear alkoxyl group having 1-20 carbon atoms, a linear thioalkoxyl group having 1-20 carbon atoms, a $C_{3-20}$ branched alkyl group, a $C_{3-20}$ cyclic alkyl group, a branched alkoxyl group having 3-20 carbon atoms, a cyclic alkoxyl group having 3-20 carbon atoms, a branched thioalkoxyl group having 3-20 carbon atoms, a cyclic thioalkoxyl group having 3-20 carbon atoms, a ketone group having 1-20 carbon atoms, an alkoxycarbonyl group having 2-20 carbon atoms, an aryloxycarbonyl group having 7-20 carbon atoms, an alkenyl group having 2-20 carbon atoms, a cyanoyl group, a carbamoyl group, a haloformyl group, a formyl group, an isocyanoyl group, an isocyanate group, a thiocyanate group, an isothiocyanate group, a hydroxyl group, a nitro group, $-CF_3$, -Cl, -Br, -F, a substituted or unsubstituted aromatic group having 6-30 ring atoms, a substituted or unsubstituted heteroaromatic group having 5-30 ring atoms, a substituted or unsubstituted aryloxy group having 6-30 ring atoms, or a substituted or unsubstituted heteroaryloxy group having 5-30 ring atoms;

at least one of $Ar_1$, $Ar_2$, $Ar_3$, $Ar_4$, $R_1$, and $R_2$ contains a linear silanyl group having 1-20 carbon atoms, a branched silanyl group having 1-20 carbon atoms, or a deuterated phenyl group;

n1 is independently selected from 0, 1, 2, or 3; and

n2 is independently selected from 0, 1, 2, 3, or 4.

By introducing aromatic rings and at least one of a silanyl group and a deuterated phenyl group into the organic compound, the embodiments of the present application effectively increase the relative molecular mass of the organic compound, make the molecular configuration and the molecular gap of the organic compound larger, and enable the organic compound to have better solubility, thereby facilitating the purification of the organic compound in the preparation process, improving the purity of the organic compound, and improving the luminous efficiency and service life of an organic light-emitting device using the organic compound.

In some embodiments, $R_1$ and $R_2$ are independently selected from a methylsilanyl group; and at least one of $Ar_1$, $Ar_2$, $Ar_3$, $Ar_4$, $R_1$, and $R_2$ contains a methylsilanyl group or a deuterated phenyl group.

In some embodiments, $R_1$ and $R_2$ are independently selected from a trimethylsilanyl group or a triphenylsilanyl group; and at least one of $Ar_1$, $Ar_2$, $Ar_3$, $Ar_4$, $R_1$, and $R_2$ contains a trimethylsilanyl group, a triphenylsilanyl group, or a deuterated phenyl group.

In some embodiments, $Ar_1$ is a group represented by any one of the following formulae (X-1) to (X-4):

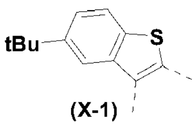
(X-1)
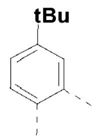
(X-2)
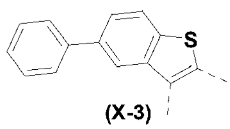
(X-3)
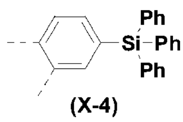
(X-4)
;

$Ar_2$ is a group represented by any one of the following formulae (A-1) to (A-4):

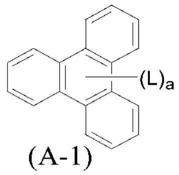
(A-1)
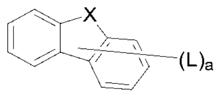
(A-2)
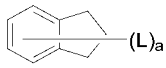
(A-3)
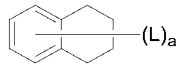
(A-4) ;

and

$Ar_3$ and $Ar_4$ are independently a group represented by any one of the following formulae (B-1) to (B-5):

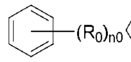
(B-1)
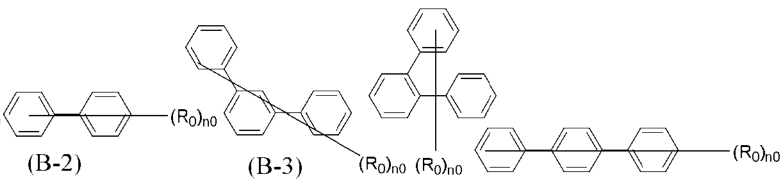
(B-2) (B-3) (B-4) (B-5) ;

where a linking site of $Ar_2$ is a carbon atom of a ring of $Ar_2$, a linking site of $Ar_3$ is a carbon atom of a ring of $Ar_3$, and a fused site of $Ar_4$ is two adjacent carbon atoms of a ring of $Ar_4$;

X is selected from O, S, N-$CH_3$, N-Ph, or $C(CH_3)_2$;

$R_0$ and L independently have the same definitions as those for $R_1$ and $R_2$;

n0 is any integer from 0 to 14;

a is any integer from 0 to 12; and

--- in the formulae (X-1) to (X-4) refers to a bond to connect with the formula (1) or (2).

It can be understood that $R_0$ groups in the formulae (B-1) to (B-5) are independently selected from the same group or different groups at each occurrence, and L groups in the formulae (A-1) to (A-4) are independently selected from the same group or different groups at each occurrence. The same applies to the selections of $R_1$ and $R_2$ in formula (1) and formula (2).

In some embodiments, at least one of $Ar_1$, $Ar_2$, $Ar_3$, $Ar_4$, $R_0$, $R_1$, $R_2$, and L contains a silanyl group or a deuterated phenyl group, for example, a trimethylsilanyl group, a triphenylsilanyl group, or a deuterated phenyl group. $Ar_2$ contains L group., and when L is independently selected from -D or a deuterated phenyl group, $Ar_2$ contains a deuterated phenyl group. Moreover, both of $Ar_3$ and $Ar_4$ contain $R_0$ groups, when $R_0$ is independently selected from -D or a deuterated phenyl group, both of $Ar_3$ and $Ar_4$ contain deuterated phenyl groups.

In some embodiments, at least one of $Ar_1$, $Ar_2$, $Ar_3$, $Ar_4$, $R_0$, $R_1$, $R_2$, and L contains a triphenylsilanyl group, so as to increase the molecular configuration of the organic compound, make the molecular gap larger, and enable the organic compound to have better solubility, thereby facilitating the purification of the organic compound in the preparation process, improving the purity of the organic compound, and improving the luminous efficiency and service life of the organic light-emitting device using the organic compound.

In some embodiments, $Ar_1$ is the group represented by the formula (X-2), and $Ar_4$ is the group represented by any one of the formulae (B-2) to (B-5).

In some embodiments, when n1 is greater than or equal to 2, adjacent two $R_1$ groups and ring atoms connected thereto form a ring or do not form a ring together; when n2 is greater than or equal to 2, adjacent two $R_2$ groups and ring atoms connected thereto form a ring or do not form a ring together; and when a is greater than or equal to 2, adjacent two L groups and atoms connected thereto form or do not form a ring with each other.

In some embodiments, adjacent two $R_1$ groups form a ring. For example, adjacent two $R_1$ groups form a six-membered aromatic ring or an aliphatic ring, such as

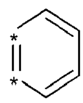,

where * indicates a linking site.

In some embodiments, adjacent two $R_2$ groups form a ring. For example, adjacent two $R_2$ groups form a six-membered aromatic ring or an aliphatic ring, such as

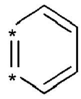

,

where * indicates a linking site.

In some embodiments, adjacent two L groups form a ring. For example, adjacent two L groups form a six-membered aromatic ring or an aliphatic ring, such as

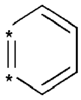

,

where * indicates a linking site.

In some embodiments, the organic compound has a structure represented by any one of the following formulae (2-1) to (2-31):

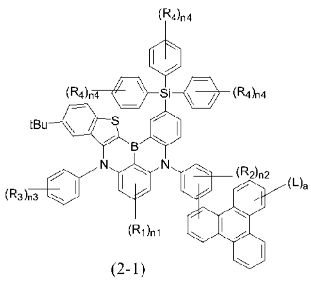

(2-1)

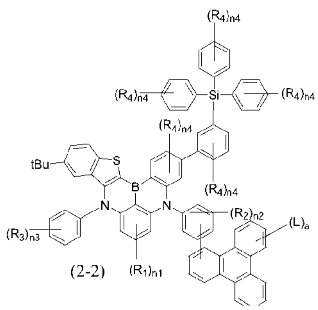

(2-2)

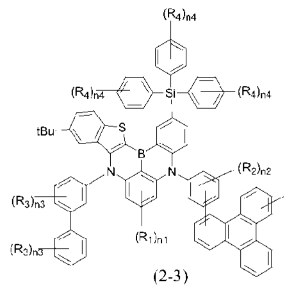

(2-3)

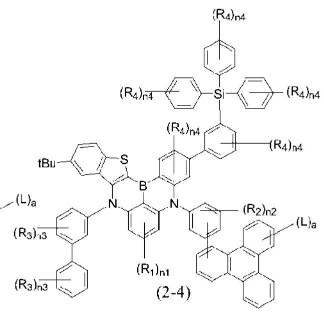

(2-4)

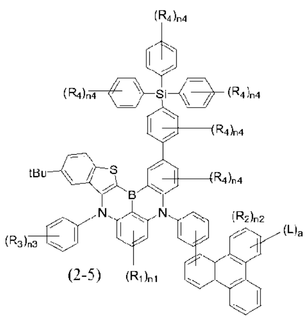

(2-5)

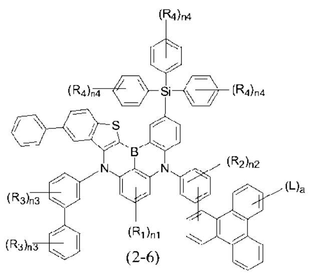

(2-6)

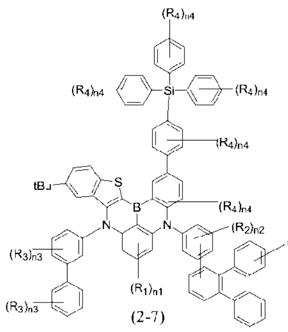

(2-7)

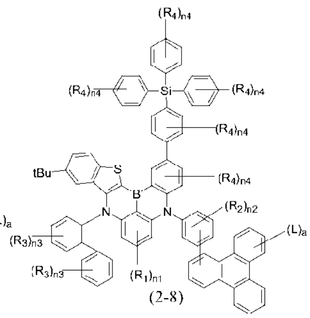

(2-8)

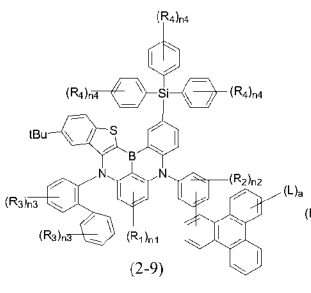

(2-9)

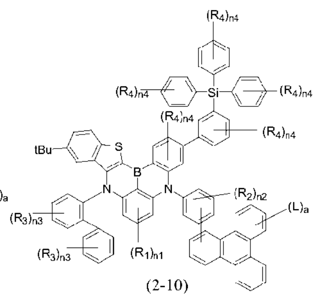

(2-10)

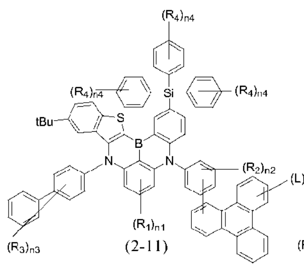

(2-11)

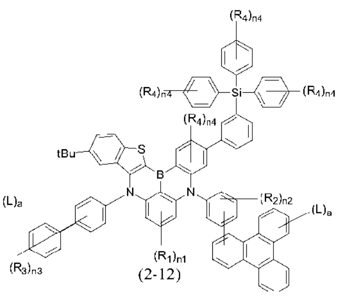

(2-12)

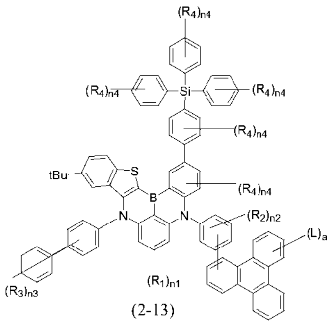

(2-13)

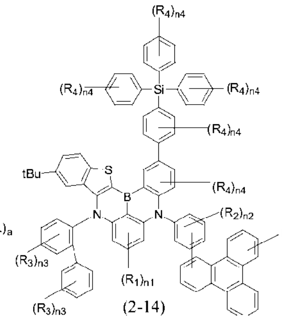

(2-14)

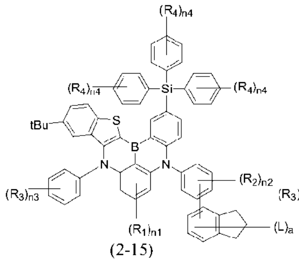

(2-15)

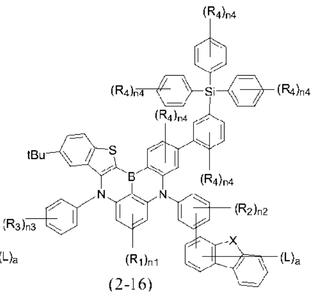

(2-16)

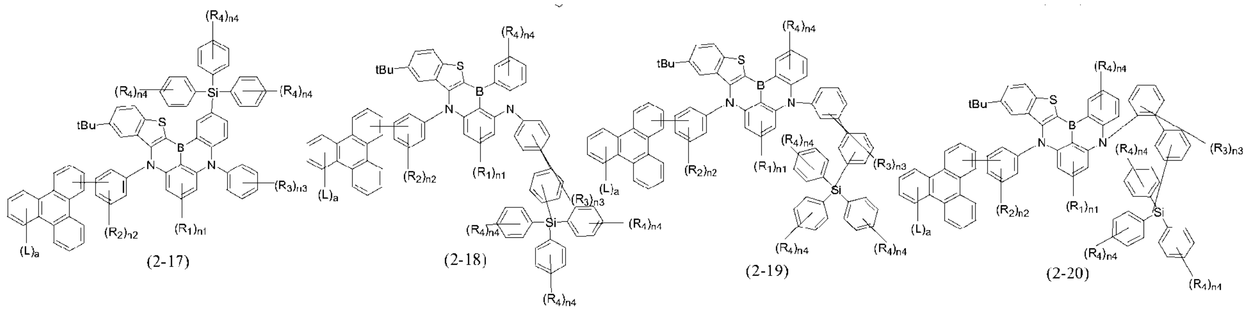

(2-17) (2-18) (2-19) (2-20)

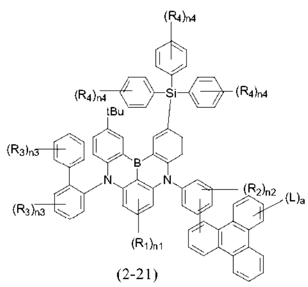

(2-21)

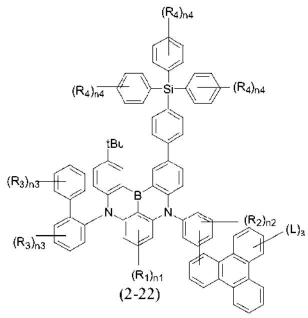

(2-22)

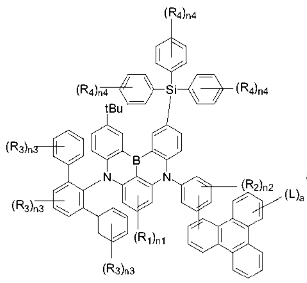

(2-23)

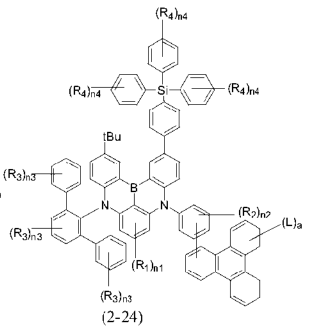

(2-24)

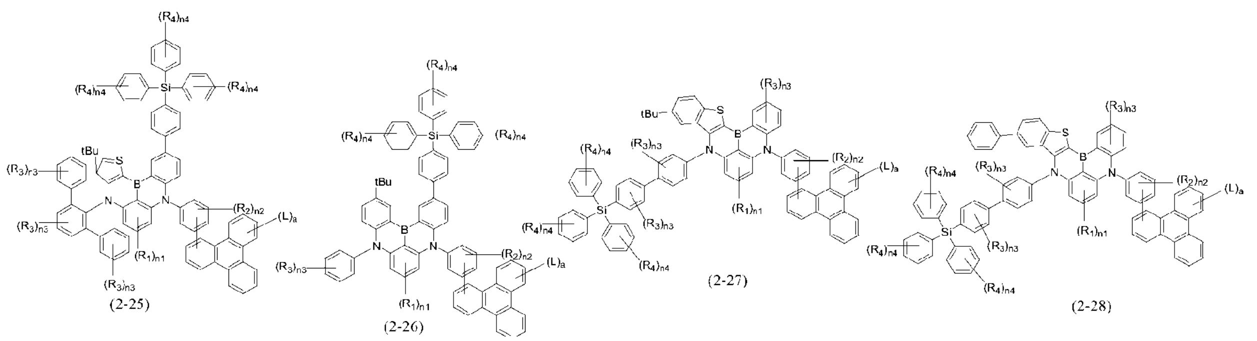

(2-25) (2-26) (2-27) (2-28)

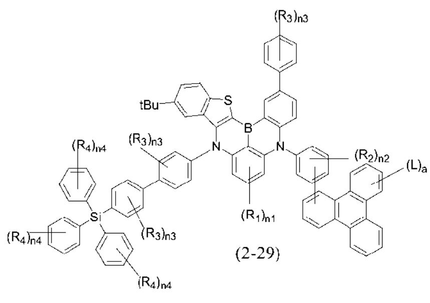

(2-29)

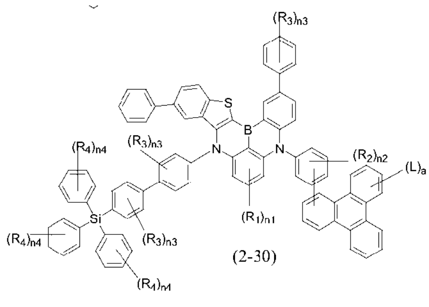

(2-30)

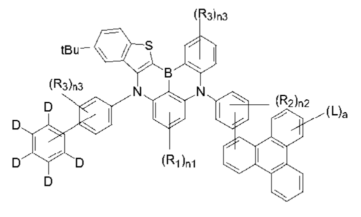

(2-31)

;

where $R_1$, $R_2$, $R_3$, $R_4$, and L in the formulae (2-1) to (2-31) independently have the same definitions as those for $R_1$ and $R_2$ in the formula (1) and formula (2);

a is any integer from 0 to 12;

n0 is any integer from 0 to 14;

n1 and n2 in the formulae (2-1) to (2-31) independently have the same definitions as those for n1 and n2 in the formula (1) and formula (2);

n3 is greater than or equal to 0 and less than or equal to 5, where when n3 is greater than or equal to 2, adjacent two $R_3$ groups and ring atoms connected thereto form a ring or do not form a ring together; and

n4 is greater than or equal to 0 and less than or equal to 5, where when n4 is greater than or equal to 2, adjacent two $R_4$ groups and ring atoms connected thereto form a ring or do not form a ring together.

It can be understood that $R_3$ groups in the formulae (2-1) to (2-31) are independently selected from the same group or different groups at each occurrence, and $R_4$ groups in the formulae (2-1) to (2-31) are independently selected from the same group or different groups at each occurrence.

In some embodiments, adjacent two $R_3$ groups form a ring. For example, adjacent two $R_3$ groups form a six-membered aromatic ring or an aliphatic ring, such as

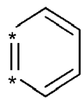,

where * indicates a linking site.

In some embodiments, adjacent two $R_4$ groups form a ring. For example, adjacent two $R_4$ groups form a six-membered aromatic ring or an aliphatic ring, such as

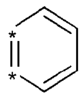,

where * indicates a linking site.

In some embodiments, $R_1$, $R_2$, $R_3$, $R_4$, and L are independently selected from -H, -D, a $C_{1-10}$ linear alkyl group, a $C_{3-10}$ branched alkyl group, or a $C_{3-10}$ cyclic alkyl group.

In some embodiments, $R_1$, $R_2$, $R_3$, $R_4$, and L are independently selected from -H, -D, a $C_{1-4}$ linear alkyl group or a $C_{3-5}$ branched alkyl group.

In the embodiments of the present application, by introducing the alkyl group into the organic compound, it is conducive to improving the solubility of the organic compound in processes such as inkjet printing, thereby enhancing the quality of the organic light-emitting device using the organic compound.

In some embodiments, at least one of $Ar_1$, $Ar_2$, $Ar_3$, $Ar_4$, $R_1$, $R_2$, $R_3$, $R_4$, and L contains a silanyl group or a deuterated phenyl group, for example, a trimethylsilanyl group, a triphenylsilanyl group, or a deuterated phenyl group. $Ar_2$ contains L group, and when L is independently selected from -D or a deuterated phenyl group, $Ar_2$ contains a deuterated phenyl group. Moreover, both of $Ar_3$ and $Ar_4$ contain $R_3$ and $R_4$, when $R_3$ and $R_4$ are independently selected from -D or a deuterated phenyl group, both of $Ar_3$ and $Ar_4$ contain deuterated phenyl groups.

In some embodiments, $Ar_2$ is the group represented by the formula (A-2). For example, the formula (A-2) is selected from

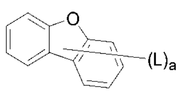, 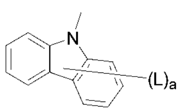, or 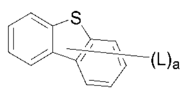,

and L and a in the formulae independently have the same definitions as those for L and a in the formulae (A-1) to (A-4). By introducing at least one of an oxygen atom, a sulfur atom, and a nitrogen atom, hole transport performance of the organic

compound can be improved, and the luminous efficiency and service life of the organic light-emitting device using the organic compound can be further improved.

In some embodiments, the organic compound is a blue light-emitting material.

In some embodiments, the organic compound is selected from any one of a group consisting of the following compounds 1 to 168:

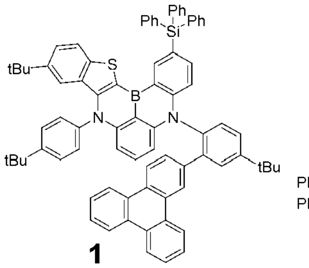
**1**

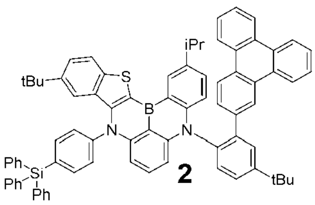
**2**

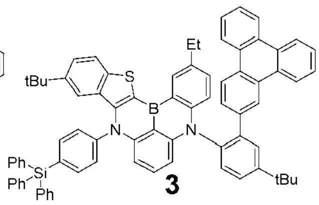
**3**

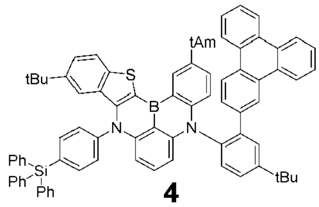
**4**

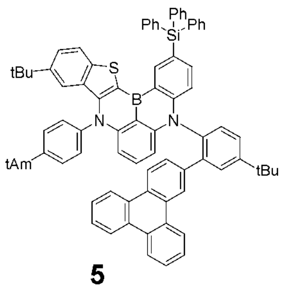
**5**

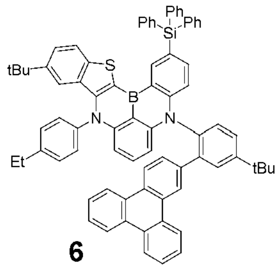
**6**

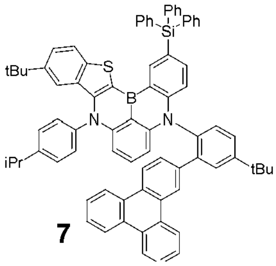
**7**

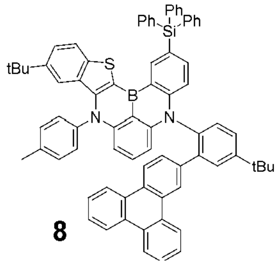
**8**

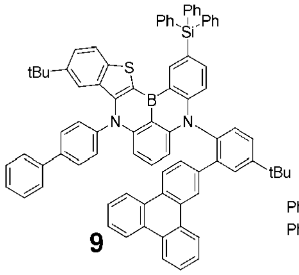
**9**

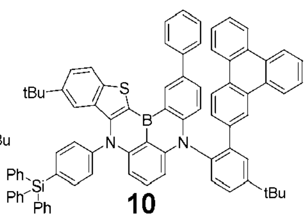
**10**

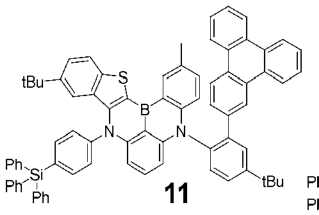
**11**

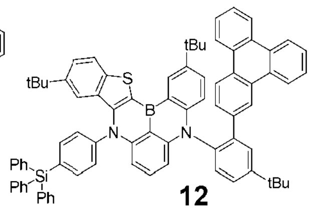
**12**

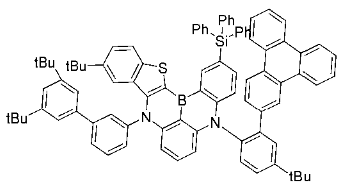
**13**

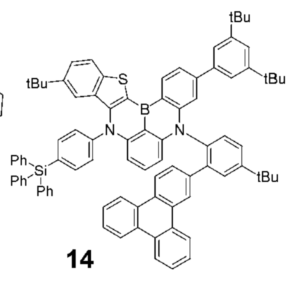
**14**

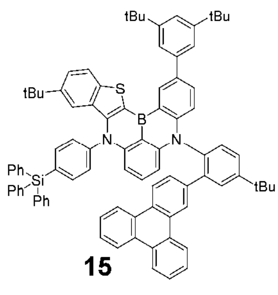
**15**

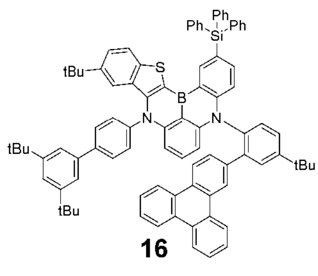
**16**

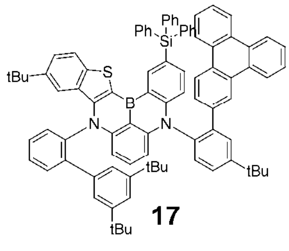
**17**

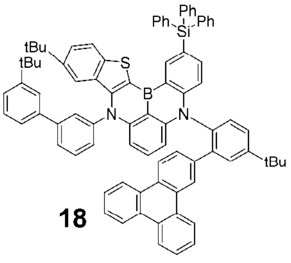
**18**

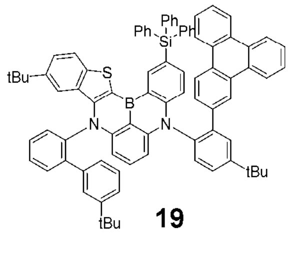
**19**

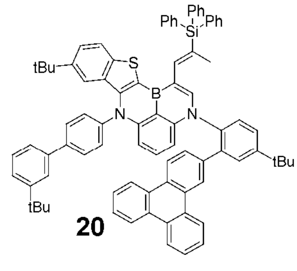
**20**

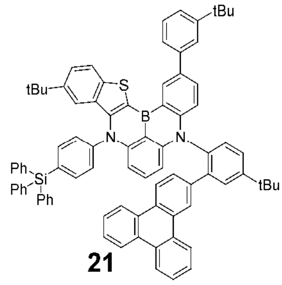
21

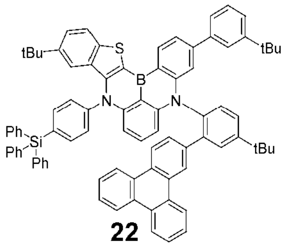
22

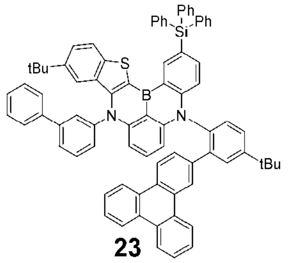
23

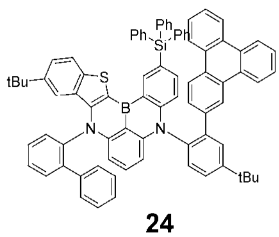
24

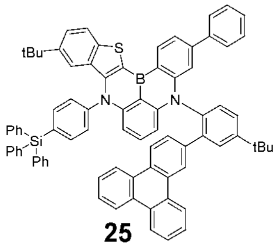
25

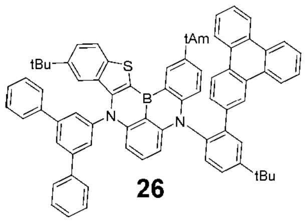
26

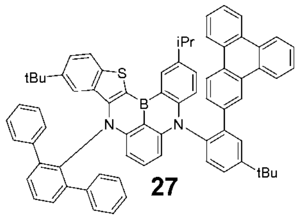
27

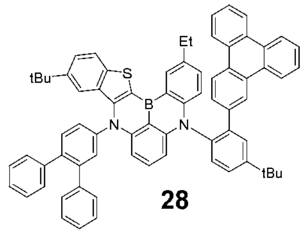
28

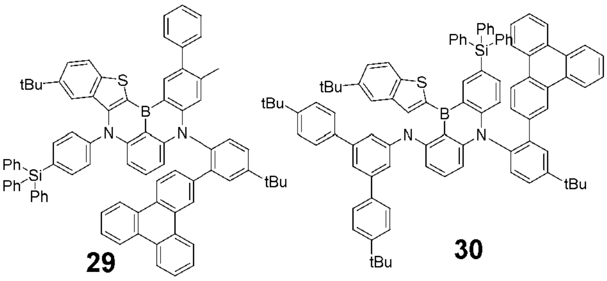
29

30

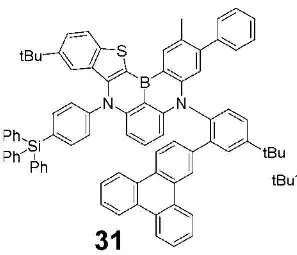
31

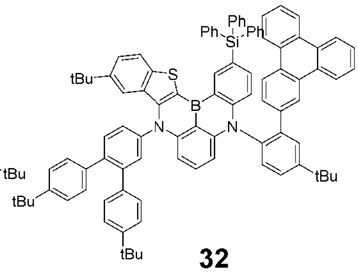
32

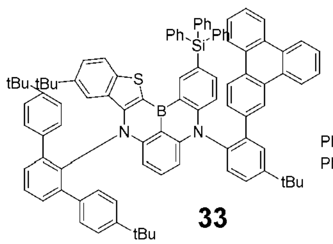
33

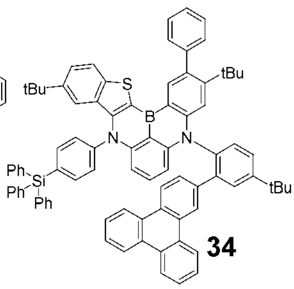
34

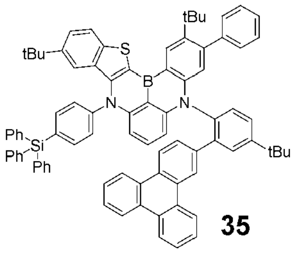
35

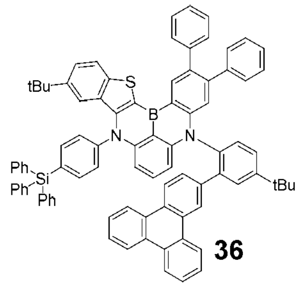
36

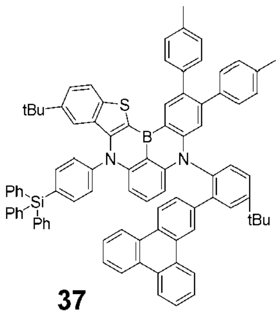
37

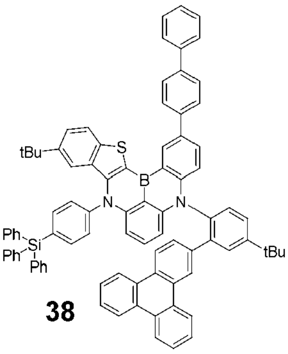
38

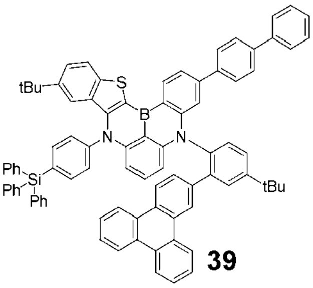
39

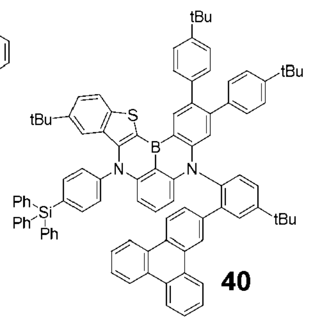
40

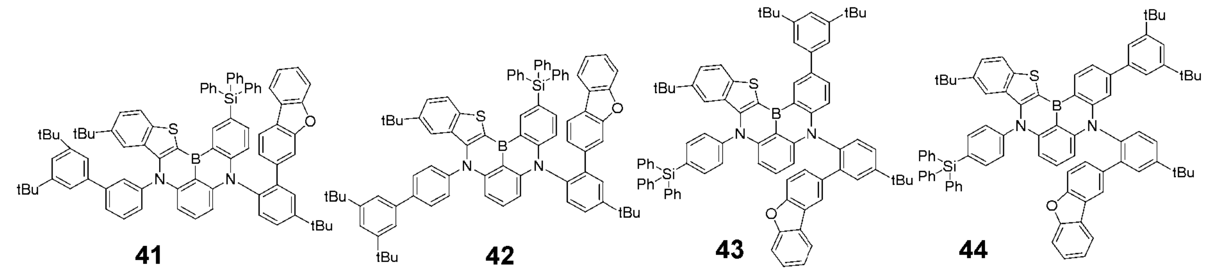

41 42 43 44

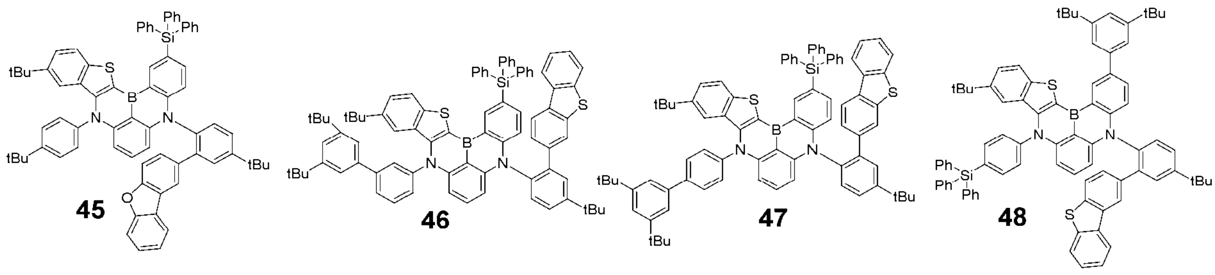

45 46 47 48

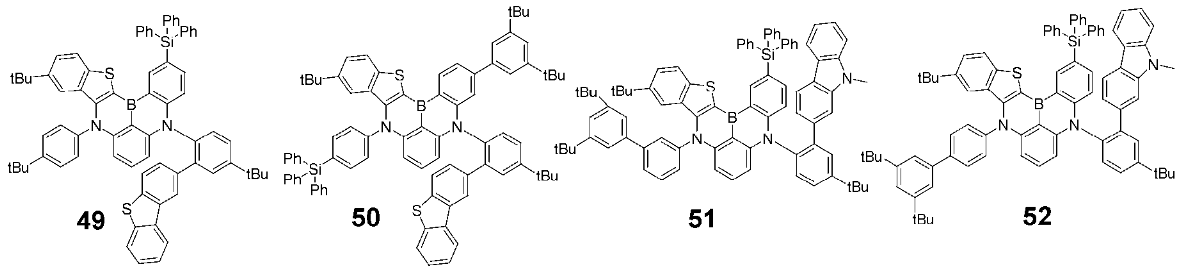

49 50 51 52

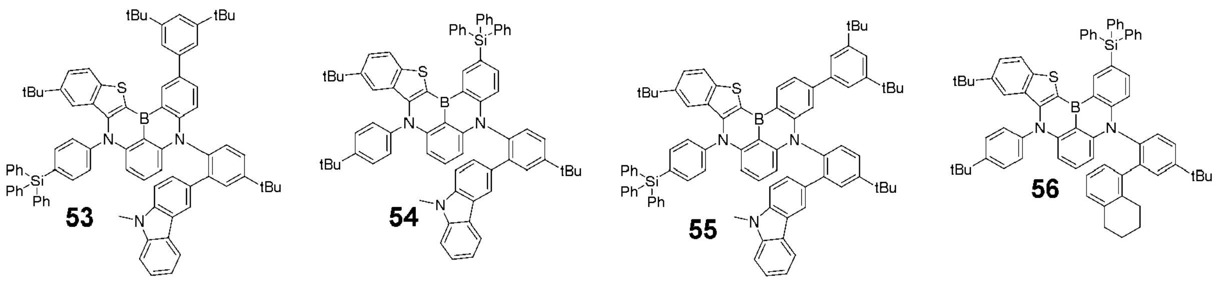

53 54 55 56

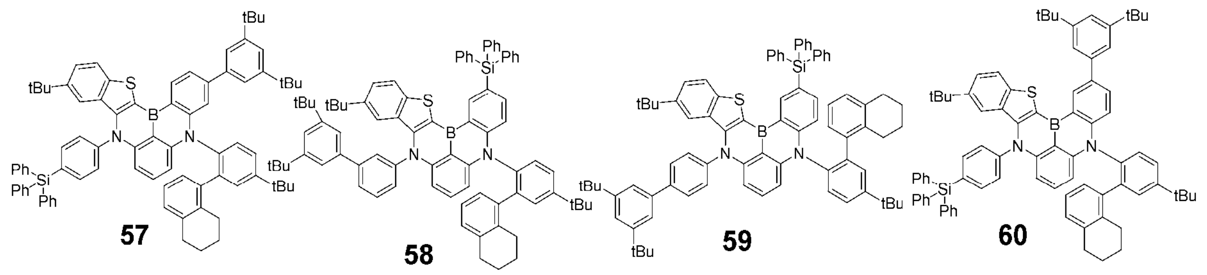

57 58 59 60

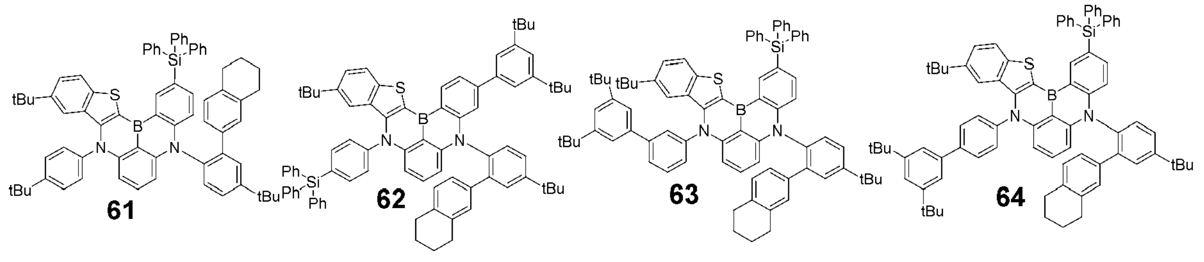

61 62 63 64

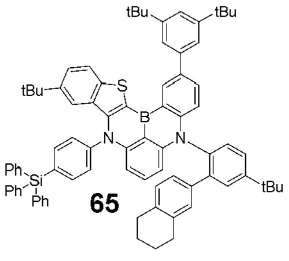
65

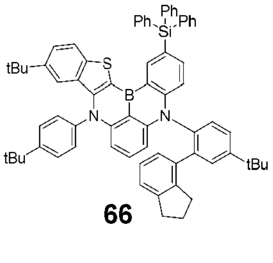
66

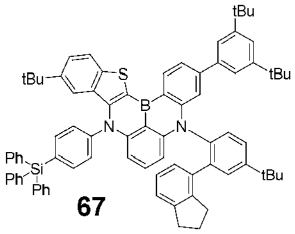
67

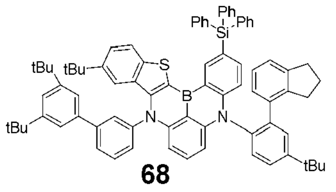
68

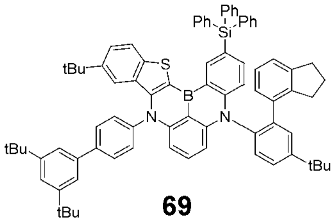
69

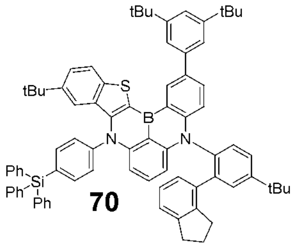
70

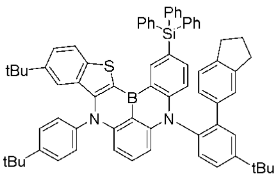
71

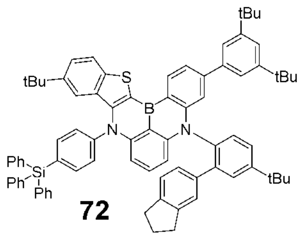
72

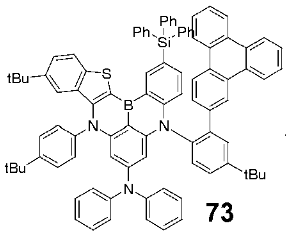
73

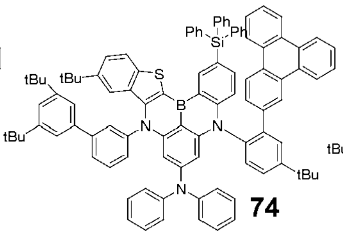
74

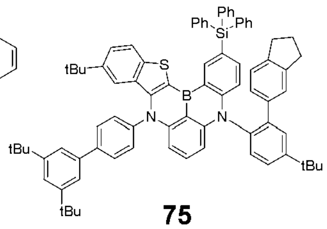
75

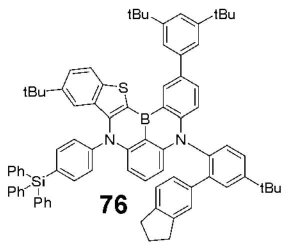
76

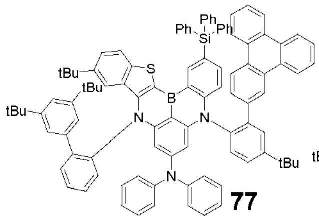
77

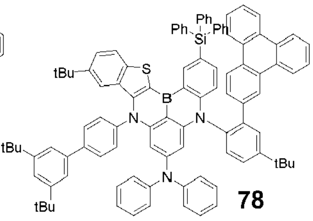
78

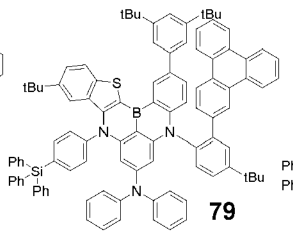
79

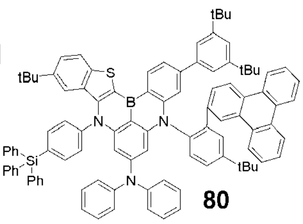
80

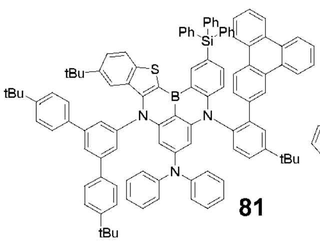
81

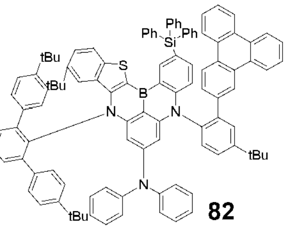
82

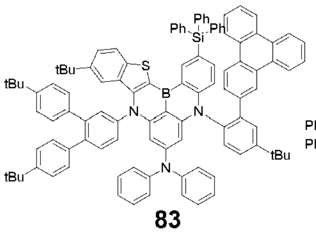
83

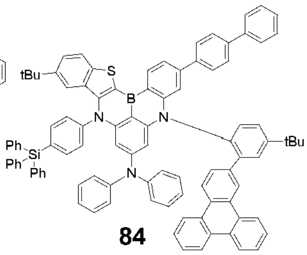
84

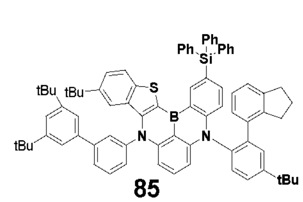
85

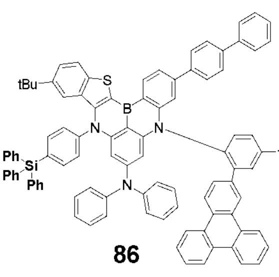
86

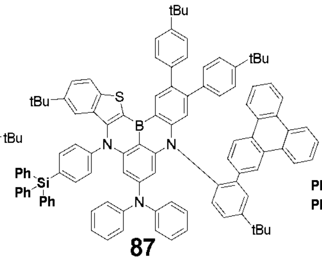
87

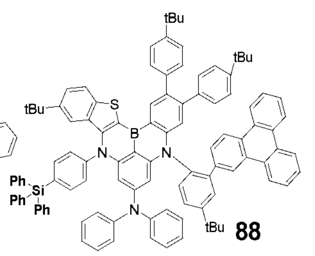
88

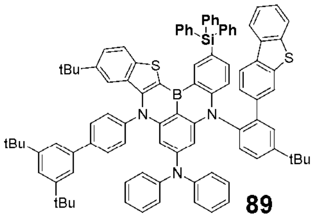
89

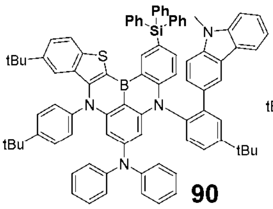
90

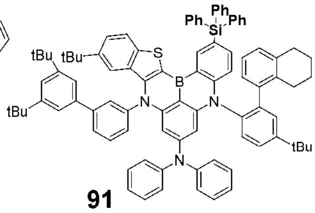
91

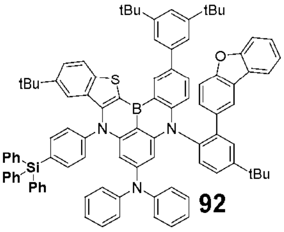
92

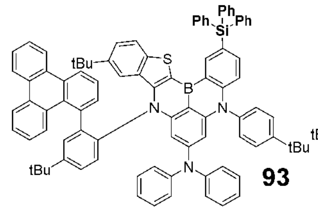
93

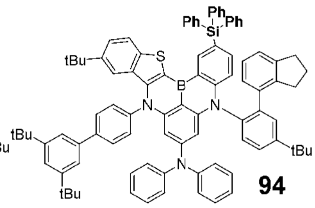
94

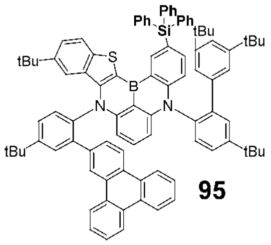
95

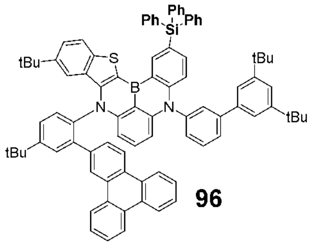
96

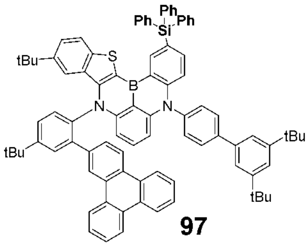
97

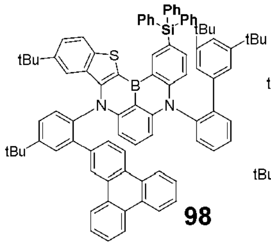
98

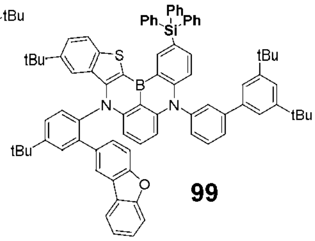
99

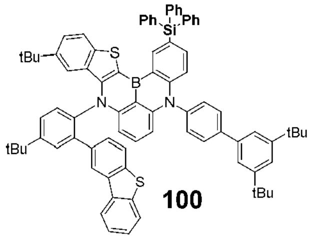
100

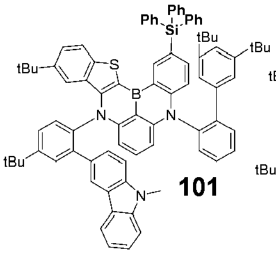
101

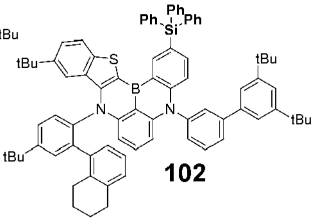
102

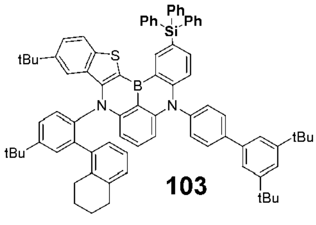
103

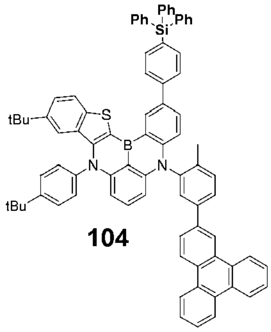
104

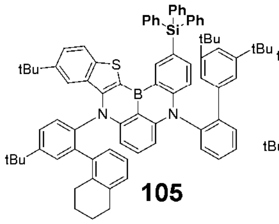
105

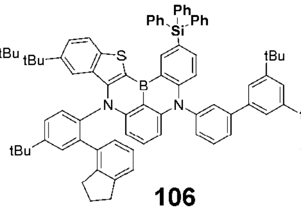
106

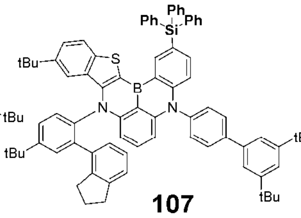
107

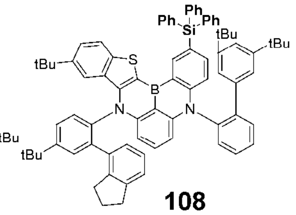
108

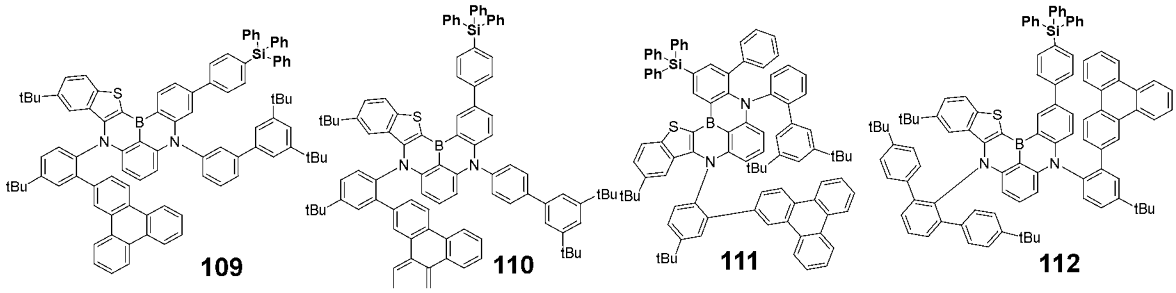

109 110 111 112

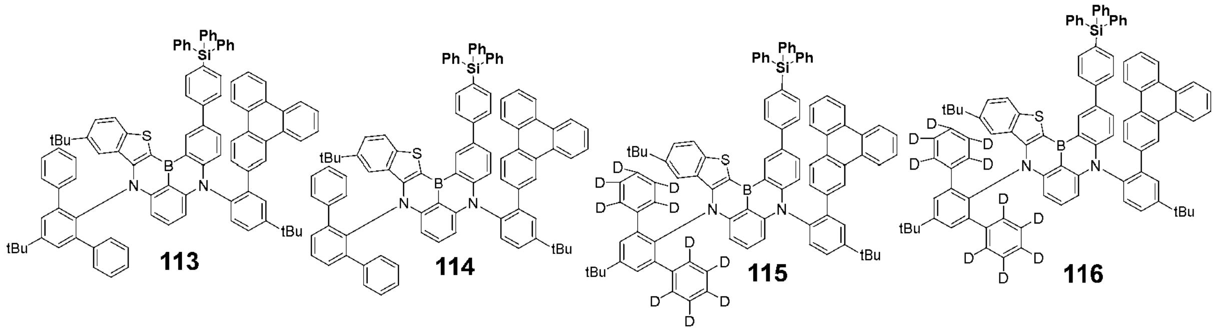

113 114 115 116

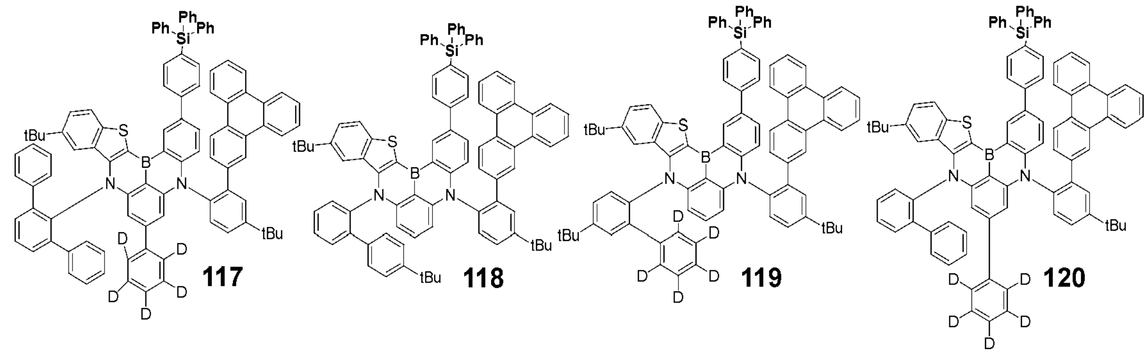

117 118 119 120

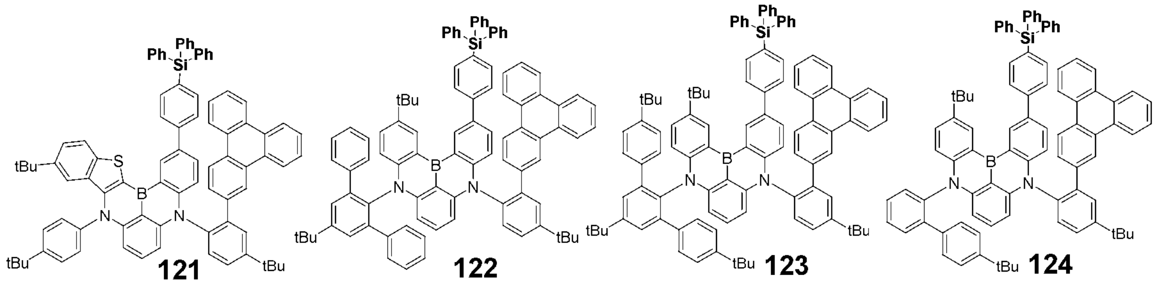

121 122 123 124

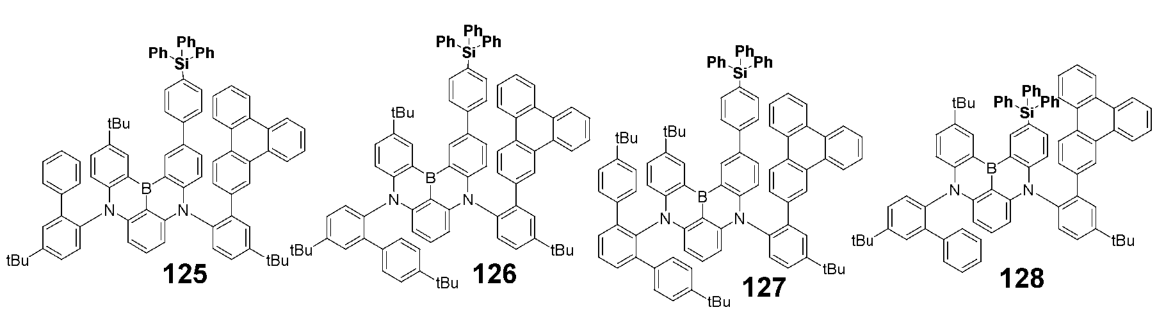

125 126 127 128

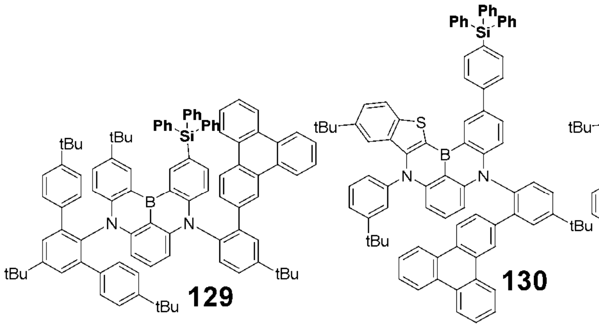

129 130 131

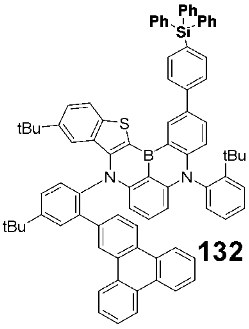

132

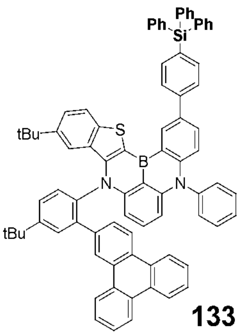

133

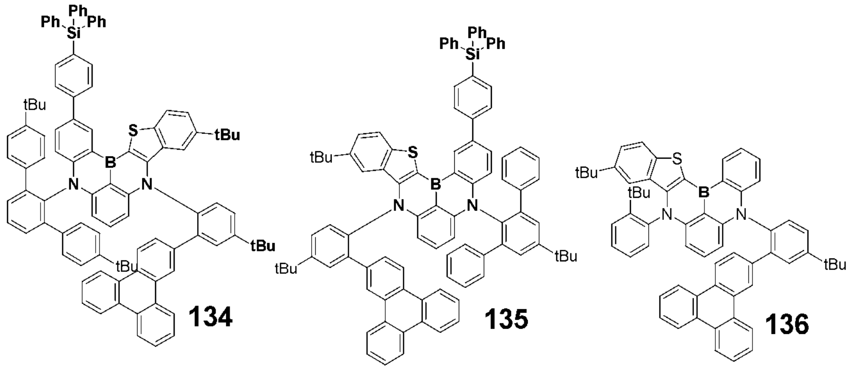

134 135 136

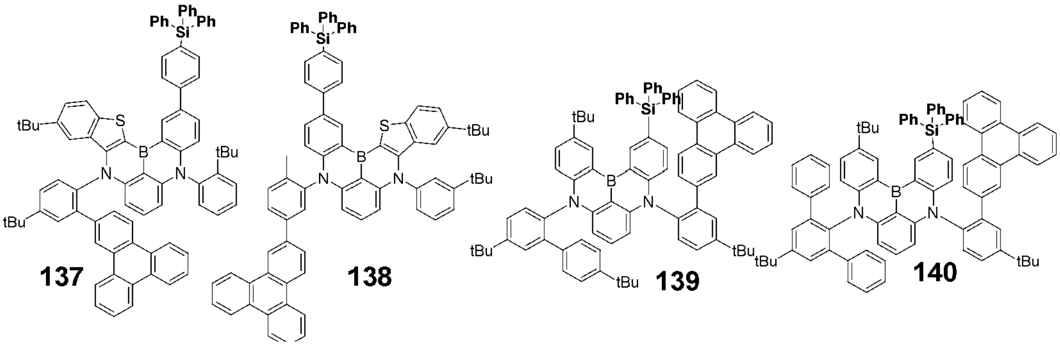

137 138 139 140

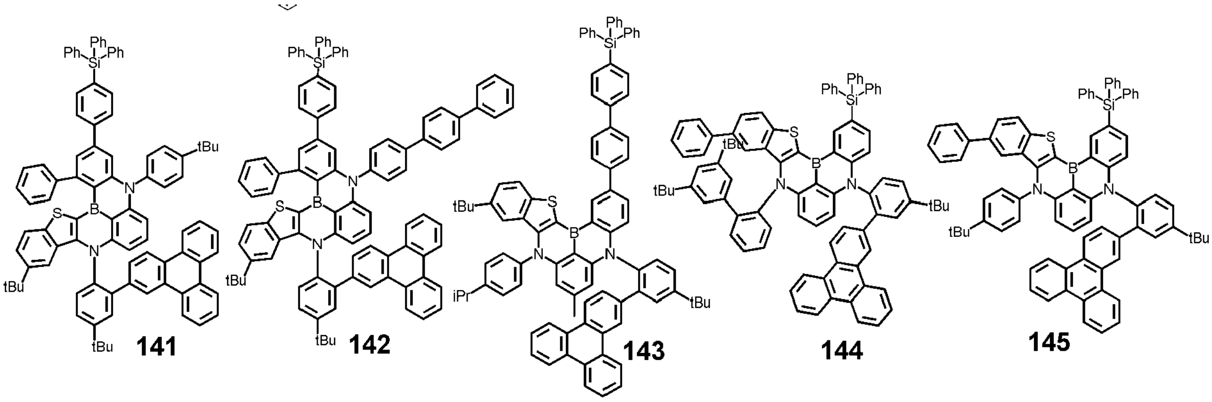

141 142 143 144 145

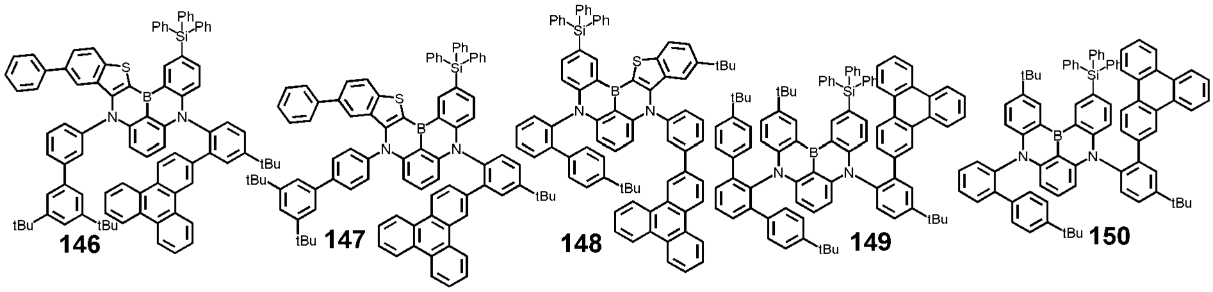

146 147 148 149 150

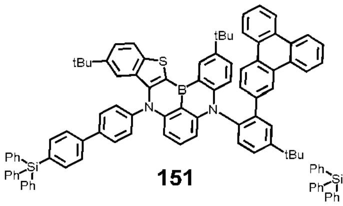

151

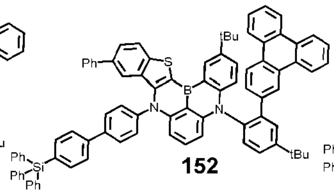

152

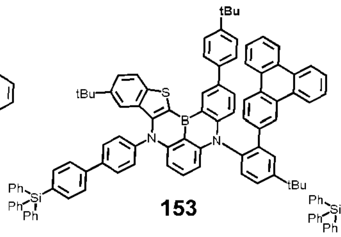

153

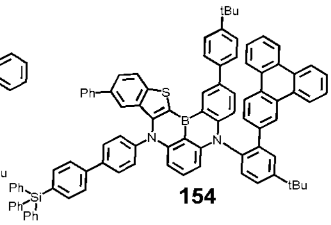

154

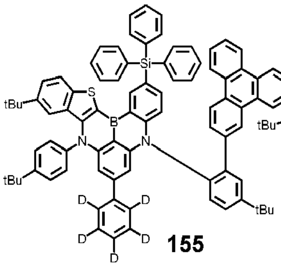

155

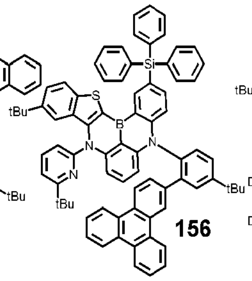

156

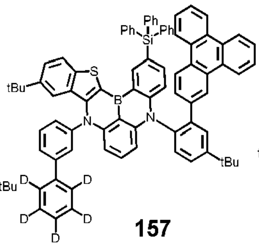

157

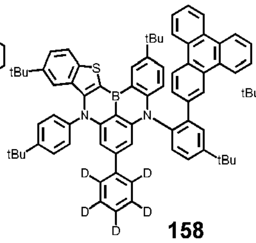

158

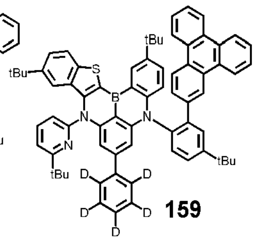

159

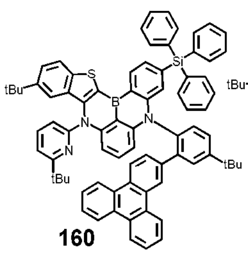

160

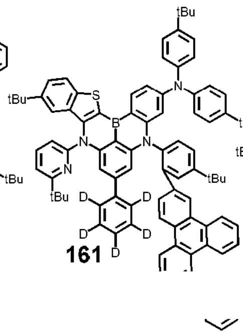

161

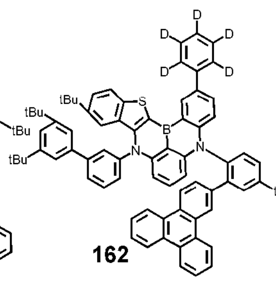

162

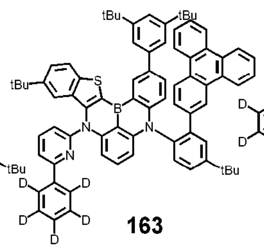

163

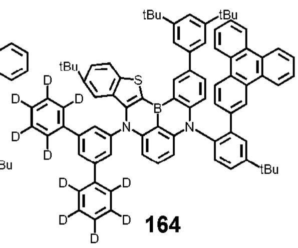

164

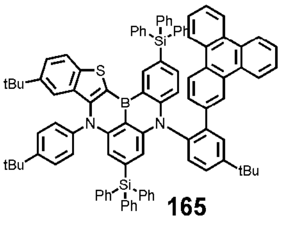

165

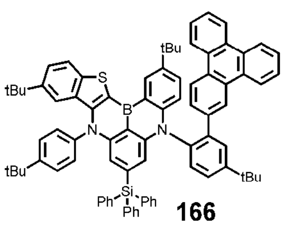

166

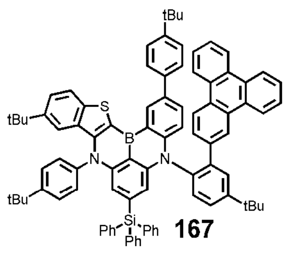

167

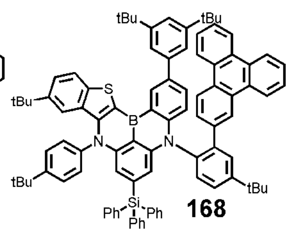

168

By introducing a biphenyl ring, an aromatic ring, and at least one of a silanyl group and a deuterated phenyl group into the organic compound, the organic compound provided in the embodiments has better solubility, which facilitates the purification of the organic compound in the preparation process, improves the purity of the organic compound, and improves the luminous efficiency and service life of the organic light-emitting device using the organic compound.

The present application further provides the preparation processes of some organic compounds as described in the above embodiments. In the following description, Examples 1-35 are provided to describe the preparation processes of these organic compounds in detail.

Example 1

Synthetic Route of Organic Compound M1 is as follows:

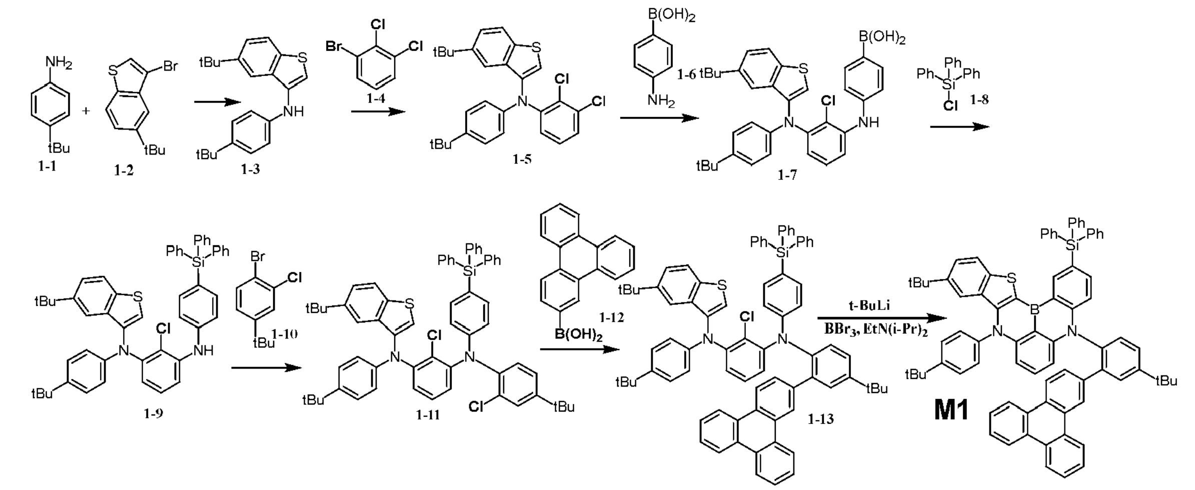


(1) Synthesis of Intermediate 1-3: compound 1-1 (10 mmol), compound 1-2 (10 mmol), bis(dibenzylideneacetone) palladium ($Pd(dba)_2$, 0.1 mmol), tri-tert-butylphosphine (TTBP, 0.2 mmol), and sodium tert-butoxide (30 mmol) were dissolved **in** toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 1-3 (8.21 mmol) with yield of 82.1%. Atmospheric pressure solid phase analysis probe mass spectrometry (ASAP-MS) result of intermediate 1-3: MS (ASAP) = 337.

(2) Synthesis of Intermediate 1-5: intermediate 1-3 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 1-5 (7.28 mmol) with yield of 72.8%. ASAP-MS result of intermediate 1-5: MS (ASAP) = 481.

(3) Synthesis of Intermediate 1-7: intermediate 1-5 (10 mmol), compound 1-6 (10 mmol), bis(di-tert-butyl(4-dimethylaminophenyl)phosphine)dichloropalladium(II) (Pd-132, 0.1 mmol), 2-dicyclohexylphosphino-2',6'-dimethoxybiphenyl (S-Phos, 0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 1-7 (6.51 mmol) with yield of 65.1%. ASAP-MS result of intermediate 1-7: MS (ASAP) = 582.

(4) Synthesis of Intermediate 1-9: intermediate 1-7 (10 mmol) and compound 1-8 (10 mmol) were dissolved in a mixed solvent of 1,4-dioxane and water (21:2/mL), tetrakis(triphenylphosphine)palladium ($Pd(PPh_3)_4$, 0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 1-9 (6.33 mmol) with yield of 63.3%. ASAP-MS result of intermediate 1-9: MS (ASAP) = 796.

(5) Synthesis of Intermediate 1-11: intermediate 1-9 (10 mmol), compound 1-10 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain

an organic phase. The organic phase was purified by column chromatography and recrystallized to obtain intermediate 1-11 (7.76 mmol) with yield of 77.6%. ASAP-MS result of intermediate 1-11: MS (ASAP) = 962.

(6) Synthesis of Intermediate 1-13: intermediate 1-11 (10 mmol) and compound 1-12 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 1-13 (5.68 mmol) with yield of 56.8%. ASAP-MS result of intermediate 1-13: MS (ASAP) = 1154.

(7) Synthesis of Organic Compound M1: intermediate 1-13 (10 mmol) and dry tert-butylbenzene (100 mL) were added to a three-necked flask (250 mL), cooled to -30 °C in $N_2$ atmosphere, a solution of tert-butyllithium (t-BuLi, 21 mmol) dissolved with n-hexane was added dropwise, the reaction solution was heated to 60 °C and reacted for 2 hours, then n-hexane was removed by rotary evaporation. The reaction solution was cooled to -30 °C again, boron tribromide ($BBr_3$, 21 mmol) was added, the reaction solution was heated to room temperature and stirred for 0.5 hour, and cooled to 0 °C. N, N-diisopropylethylamine ($EtN(i\text{-}Pr)_2$, 42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M1 with yield of 33.1%. ASAP-MS result of organic compound M1: MS (ASAP) = 1128.

Example 2

Synthetic Route of Organic Compound M12 is as follows:

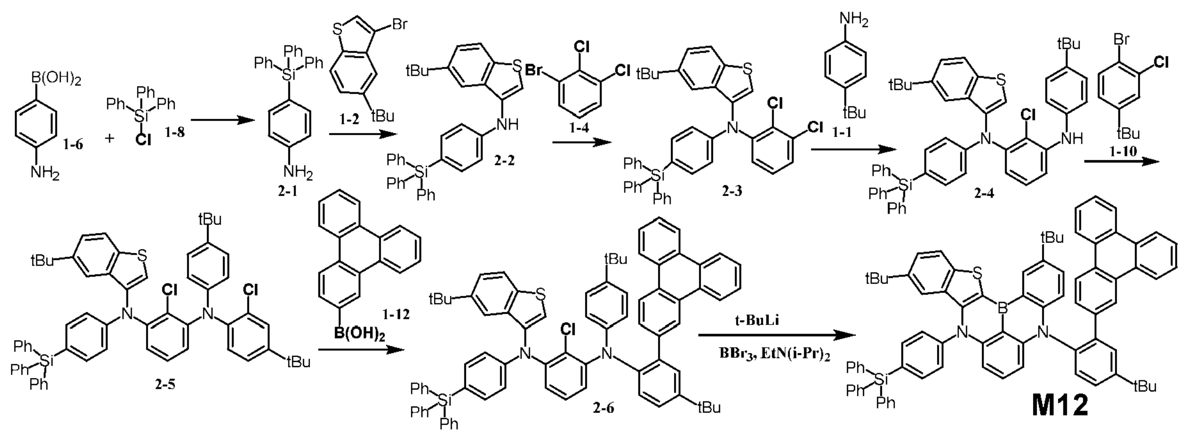


(1) Synthesis of Intermediate 2-1: compound 1-6 (10 mmol) and compound 1-8 (10 mmol) were dissolved in a mixed solvent of 1,4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 2-1 (8.33 mmol) with yield of 83.3%. ASAP-MS result of intermediate 2-1: MS (ASAP) = 351.

(2) Synthesis of Intermediate 2-2: intermediate 2-1 (10 mmol), compound 1-2 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 2-2 (7.39 mmol)

with yield of 73.9%. ASAP-MS result of intermediate 2-2: MS (ASAP) = 539.

(3) Synthesis of Intermediate 2-3: intermediate 2-2 (10 mmol), compound 1-4 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 2-3 (6.72 mmol) with yield of 67.2%. ASAP-MS result of intermediate 2-3: MS (ASAP) = 683.

(4) Synthesis of Intermediate 2-4: intermediate 2-3 (10 mmol), compound 1-1 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 2-4 (6.71 mmol) with yield of 67.1%. ASAP-MS result of intermediate 2-4: MS (ASAP) = 796.

(5) Synthesis of Intermediate 2-5: intermediate 2-4 (10 mmol), compound 1-10 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 2-5 (7.35 mmol) with yield of 73.5%. ASAP-MS result of intermediate 2-5: MS (ASAP) = 962.

(6) Synthesis of Intermediate 2-6: intermediate 2-5 (10 mmol) and compound 1-12 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 2-6 (5.12 mmol) with yield of 51.2%. ASAP-MS result of intermediate 2-6: MS (ASAP) = 1154.

(7) Synthesis of Organic Compound M12: intermediate 2-6 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M12 with yield of 43.7%. ASAP-MS result of organic compound M12: MS (ASAP) = 1128.

Example 3

Synthetic Route of Organic Compound M15 is as follows:

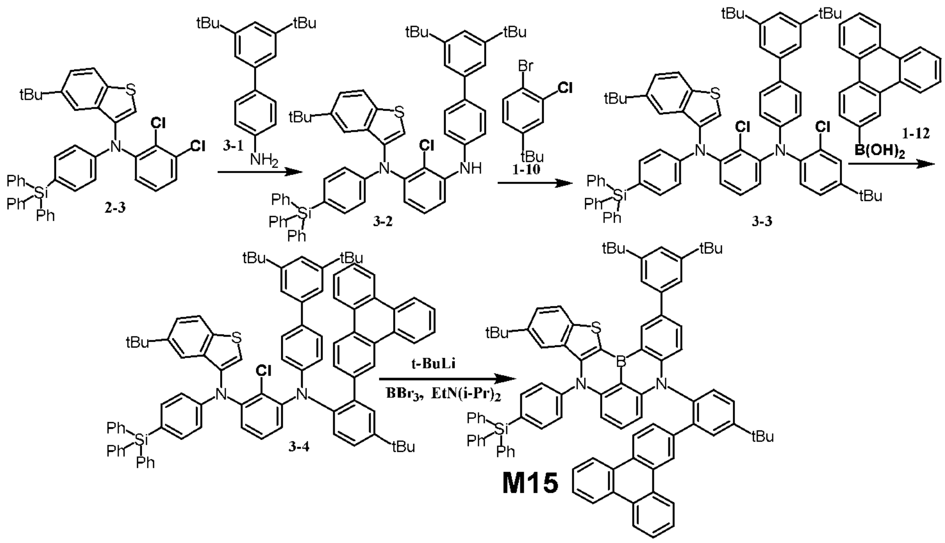


(1) Synthesis of Intermediate 3-2: intermediate 2-3 (10 mmol), compound 3-1 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 3-2 (7.89 mmol) with yield of 78.9%. ASAP-MS result of intermediate 3-2: MS (ASAP) = 928.

(2) Synthesis of Intermediate 3-3: intermediate 3-2 (10 mmol), compound 1-10 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 3-3 (7.71 mmol) with yield of 77.1%. ASAP-MS result of intermediate 3-3: MS (ASAP) = 1094.

(3) Synthesis of Intermediate 3-4: intermediate 3-3 (10 mmol) and compound 1-12 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 3-4 (5.41 mmol) with yield of 54.1%. ASAP-MS result of intermediate 3-4: MS (ASAP) = 1154.

(4) Synthesis of Organic Compound M15: intermediate 3-4 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M15 with yield of 41.3%. ASAP-MS result of organic compound M15: MS (ASAP) = 1260.

Example 4

Synthetic Route of Organic Compound M16 is as follows:

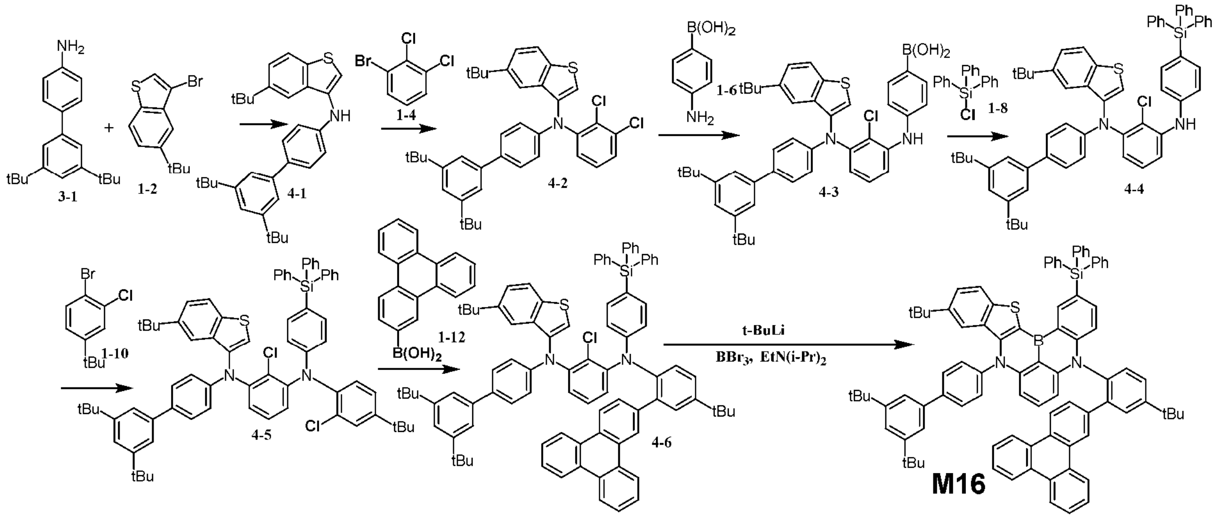


(1) Synthesis of Intermediate 4-1: compound 3-1 (10 mmol), compound 1-2 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 4-1 (8.73 mmol) with yield of 87.3%. ASAP-MS result of intermediate 4-1: MS (ASAP) = 469.

(2) Synthesis of Intermediate 4-2: intermediate 4-1 (10 mmol), compound 1-4 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 4-2 (7.86 mmol) with yield of 78.6%. ASAP-MS result of intermediate 4-2: MS (ASAP) = 613.

(3) Synthesis of Intermediate 4-3: intermediate 4-2 (10 mmol), compound 1-6 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 4-3 (6.82 mmol) with yield of 68.2%. ASAP-MS result of intermediate 4-3: MS (ASAP) = 714.

(4) Synthesis of Intermediate 4-4: intermediate 4-3 (10 mmol) and compound 1-8 (10 mmol) were dissolved in a mixed solvent of 1, 4-dioxane and water (21:2/mL), Pd(PPh$_3$)$_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 4-4 (5.63 mmol) with yield of 56.3%. ASAP-MS result of intermediate 4-4: MS (ASAP) = 928.

(5) Synthesis of Intermediate 4-5: intermediate 4-4 (10 mmol), compound 1-10 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 4-5 (7.76 mmol) with yield of 77.6%. ASAP-MS result of intermediate 4-5: MS (ASAP) = 1094.

(6) Synthesis of Intermediate 4-6: intermediate 4-5 (10 mmol) and compound 1-12 (10 mmol) were dissolved in a mixed solvent of 1, 4-dioxane and water (21:2/mL), Pd(PPh$_3$)$_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 4-6 (5.11 mmol) with yield of 51.1%. ASAP-MS result of intermediate 4-6: MS (ASAP) = 1286.

(7) Synthesis of Organic Compound M16: intermediate 4-6 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M16 with yield of 37.6%. ASAP-MS result of organic compound M16: MS (ASAP) = 1260.

Example 5

Synthetic Route of Organic Compound M60 is as follows:

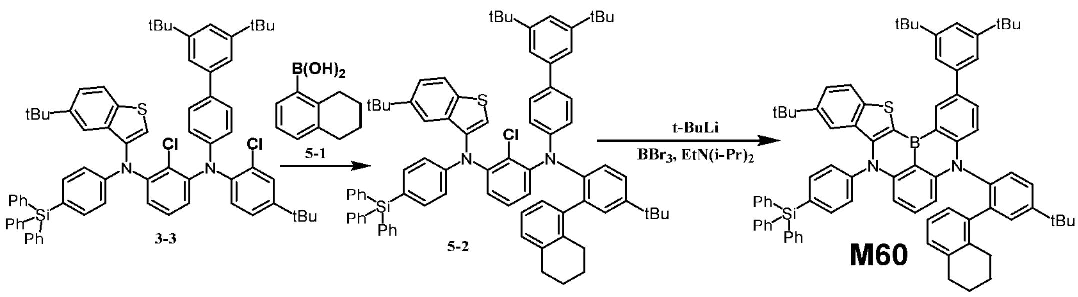

3-3
5-2
M60

(1) Synthesis of Intermediate 5-2: intermediate 3-3 (10 mmol) and intermediate 5-1 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 5-2 (5.28 mmol) with yield of 52.8%. ASAP-MS result of intermediate 5-2: MS (ASAP) = 1190.

(2) Synthesis of Organic Compound M60: intermediate 5-2 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M60 with yield of 32.7%. ASAP-MS result of organic compound M60: MS (ASAP) = 1164.

Example 6

Synthetic Route of Organic Compound M64 is as follows:

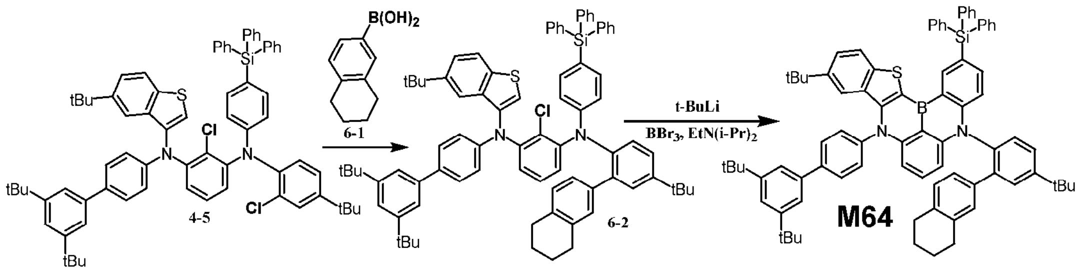

4-5
6-2
M64

(1) Synthesis of Intermediate 6-2: intermediate 4-5 (10 mmol) and intermediate 6-1 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 6-2 (5.93 mmol) with yield of 59.3%. ASAP-MS result of intermediate 6-2: MS (ASAP) = 1190.

(2) Synthesis of Organic Compound M64: intermediate 6-2 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M64 with yield of 32.9%. ASAP-MS result of organic compound M64: MS (ASAP) = 1164.

Example 7

Synthetic Route of Organic Compound M68 is as follows:

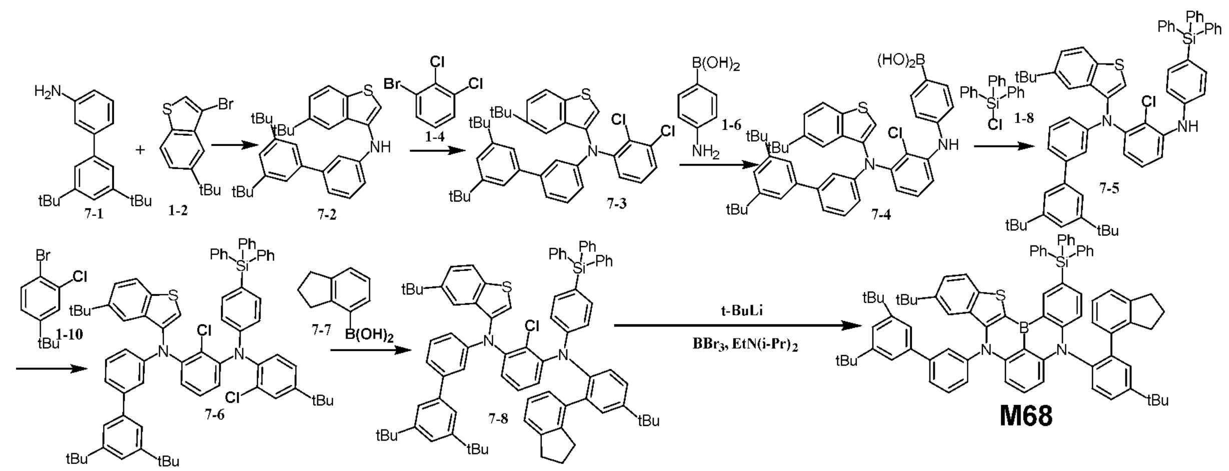


(1) Synthesis of Intermediate 7-2: compound 7-1 (10 mmol), compound 1-2 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 7-2 (8.33 mmol) with yield of 83.3%. ASAP-MS result of intermediate 7-2: MS (ASAP) = 469.

(2) Synthesis of Intermediate 7-3: intermediate 7-2 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 7-3 (7.21 mmol) with yield of 72.1%. ASAP-MS result of intermediate 7-3: MS (ASAP) = 613.

(3) Synthesis of Intermediate 7-4: intermediate 7-3 (10 mmol), compound 1-6 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 7-4 (6.52 mmol)

with yield of 65.2%. ASAP-MS result of intermediate 7-4: MS (ASAP) = 714.

(4) Synthesis of Intermediate 7-5: intermediate 7-4 (10 mmol) and compound 1-8 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 7-5 (5.13 mmol) with yield of 51.3%. ASAP-MS result of intermediate 7-5: MS (ASAP) = 928.

(5) Synthesis of Intermediate 7-6: intermediate 7-5 (10 mmol), compound 1-10 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 7-6 (7.13 mmol) with yield of 71.3%. ASAP-MS result of intermediate 7-6: MS (ASAP) = 1094.

(6) Synthesis of Intermediate 7-8: intermediate 7-6 (10 mmol) and compound 7-7 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 7-8 (5.56 mmol) with yield of 55.6%. ASAP-MS result of intermediate 7-8: MS (ASAP) = 1176.

(7) Synthesis of Organic Compound M68: intermediate 7-8 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M68 with yield of 32.3%. ASAP-MS result of organic compound M68: MS (ASAP) = 1150.

Example 8

Synthetic Route of Organic Compound M72 is as follows:

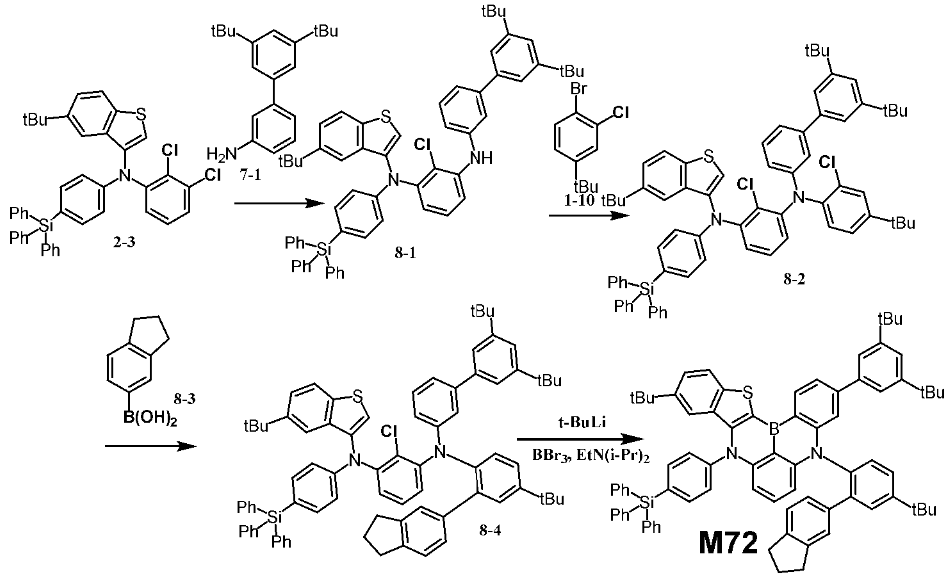


(1) Synthesis of Intermediate 8-1: intermediate 2-3 (10 mmol), compound 7-1 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 8-1 (7.21 mmol) with yield of 72.1%. ASAP-MS result of intermediate 8-1: MS (ASAP) = 928.

(2) Synthesis of Intermediate 8-2: intermediate 8-1 (10 mmol), compound 1-10 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 8-2 (7.21 mmol) with yield of 72.1%. ASAP-MS result of intermediate 8-2: MS (ASAP) = 1094.

(3) Synthesis of Intermediate 8-4: intermediate 8-2 (10 mmol) and compound 8-3 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 8-4 (5.22 mmol) with yield of 52.2%. ASAP-MS result of intermediate 8-4: MS (ASAP) = 1176.

(4) Synthesis of Organic Compound M72: intermediate 8-4 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M72 with yield of 25.3%. ASAP-MS result of organic compound M72: MS (ASAP) = 1150.

Example 9

Synthetic Route of Organic Compound M89 is as follows:

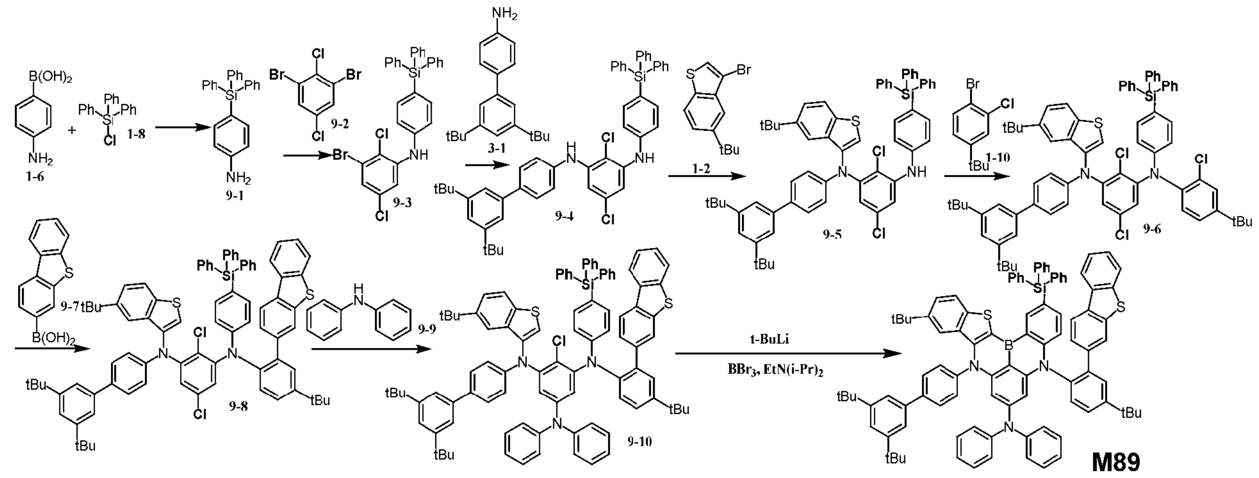


(1) Synthesis of Intermediate 9-1: compound 1-6 (10 mmol) and compound 1-8 (10 mmol) were dissolved in a mixed solvent of 1,4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 9-1 (8.93 mmol) with yield of 89.3%. ASAP-MS result of intermediate 9-1: MS (ASAP) = 351.

(2) Synthesis of Intermediate 9-3: intermediate 9-1 (10 mmol), compound 9-2 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 9-3 (8.53 mmol) with yield of 85.3%. ASAP-MS result of intermediate 9-3: MS (ASAP) = 573.

(3) Synthesis of Intermediate 9-4: intermediate 9-3 (10 mmol), compound 3-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 9-4 (6.27 mmol) with yield of 62.7%. ASAP-MS result of intermediate 9-4: MS (ASAP) = 774.

(4) Synthesis of Intermediate 9-5: intermediate 9-4 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 9-5 (6.71 mmol) with yield of 67.1%. ASAP-MS result of intermediate 9-5: MS (ASAP) = 962.

(5) Synthesis of Intermediate 9-6: intermediate 9-5 (10 mmol), compound 1-10 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 9-6 (5.96 mmol) with yield of 59.6%. ASAP-MS result of intermediate 9-6: MS (ASAP) = 1128.

(6) Synthesis of Intermediate 9-8: intermediate 9-6 (10 mmol) and compound 9-7 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified

by column chromatography and recrystallized to obtain intermediate 9-8 (7.93 mmol) with yield of 79.3%. ASAP-MS result of intermediate 9-8: MS (ASAP) = 1276.

(7) Synthesis of Intermediate 9-10: intermediate 9-8 (10 mmol), compound 9-9 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 9-10 (5.03 mmol) with yield of 50.3%. ASAP-MS result of intermediate 9-10: MS (ASAP) = 1409.

(8) Synthesis of Organic Compound M89: intermediate 9-10 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M89 with yield of 29.1%. ASAP-MS result of organic compound M89: MS (ASAP) = 1383.

Example 10

Synthetic Route of Organic Compound M90 is as follows:

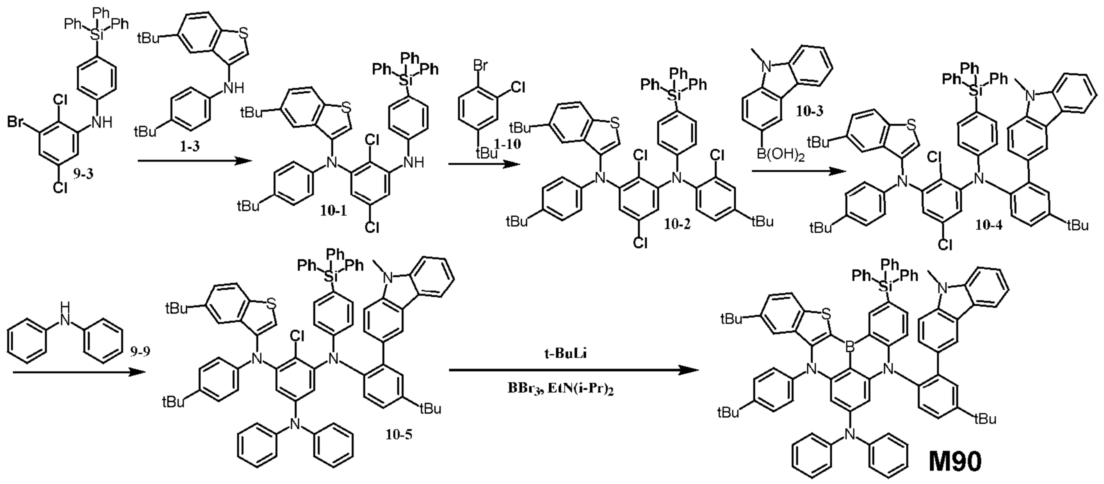


(1) Synthesis of Intermediate 10-1: intermediate 9-3 (10 mmol), intermediate 1-3 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 10-1 (7.89 mmol) with yield of 78.9%. ASAP-MS result of intermediate 10-1: MS (ASAP) = 830.

(2) Synthesis of Intermediate 10-2: intermediate 10-1 (10 mmol), compound 1-10 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 10-2 (7.13 mmol) with yield of 71.3%. ASAP-MS result of intermediate 10-2: MS (ASAP) = 996.

(3) Synthesis of Intermediate 10-4: intermediate 10-2 (10 mmol) and compound 10-3 (10 mmol) were dissolved in a

mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 10-4 (5.71 mmol) with yield of 57.1%. ASAP-MS result of intermediate 10-4: MS (ASAP) = 1141.

(4) Synthesis of Intermediate 10-5: intermediate 10-4 (10 mmol), compound 9-9 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 10-5 (5.63 mmol) with yield of 56.3%. ASAP-MS result of intermediate 10-5: MS (ASAP) = 1274.

(5) Synthesis of Organic Compound M90: intermediate 10-5 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M90 with yield of 36.1%. ASAP-MS result of organic compound M90: MS (ASAP) = 1248.

Example 11

Synthetic Route of Organic Compound M99 is as follows:

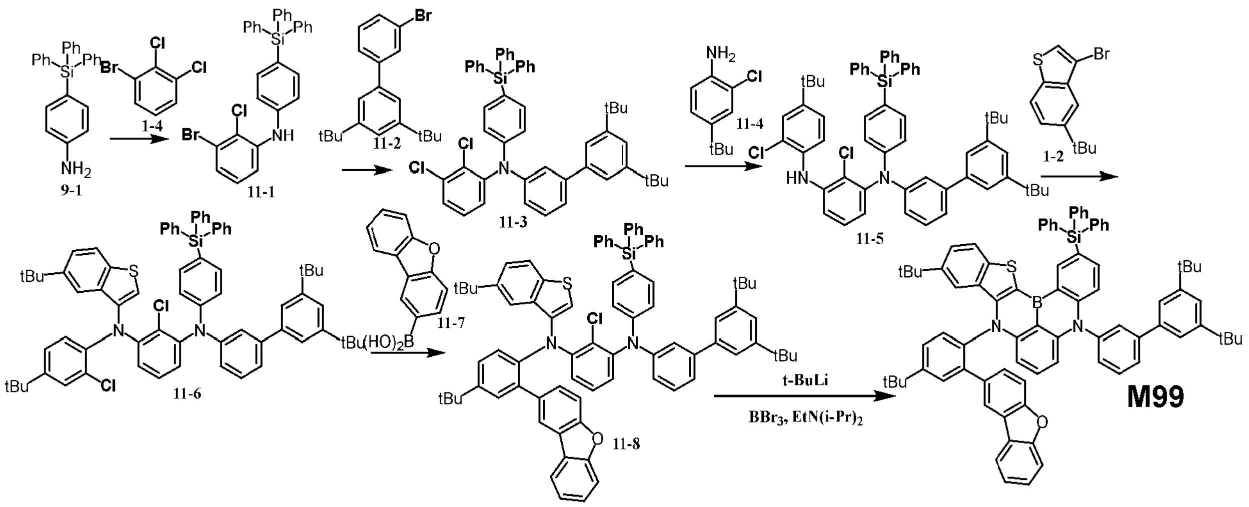


(1) Synthesis of Intermediate 11-1: intermediate 9-1 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 11-1 (8.43 mmol) with yield of 84.3%. ASAP-MS result of intermediate 11-1: MS (ASAP) = 539.

(2) Synthesis of Intermediate 11-3: intermediate 11-1 (10 mmol), compound 11-2 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain

an organic phase. The organic phase was purified by column chromatography to obtain intermediate 11-3 (6.87 mmol) with yield of 68.7%. ASAP-MS result of intermediate 11-3: MS (ASAP) = 759.

(3) Synthesis of Intermediate 11-5: intermediate 11-3 (10 mmol), compound 11-4 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 11-5 (7.89 mmol) with yield of 78.9%. ASAP-MS result of intermediate 11-5: MS (ASAP) = 906.

(4) Synthesis of Intermediate 11-6: intermediate 11-5 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 11-6 (7.91 mmol) with yield of 79.1%. ASAP-MS result of intermediate 11-6: MS (ASAP) = 1094.

(5) Synthesis of Intermediate 11-8: intermediate 11-6 (10 mmol) and compound 11-7 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 11-8 (7.93 mmol) with yield of 79.3%. ASAP-MS result of intermediate 11-8: MS (ASAP) = 1226.

(6) Synthesis of Organic Compound M99: intermediate 11-8 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M99 with yield of 43.2%. ASAP-MS result of organic compound M99: MS (ASAP) = 1200.

Example 12

Synthetic Route of Organic Compound M116 is as follows:

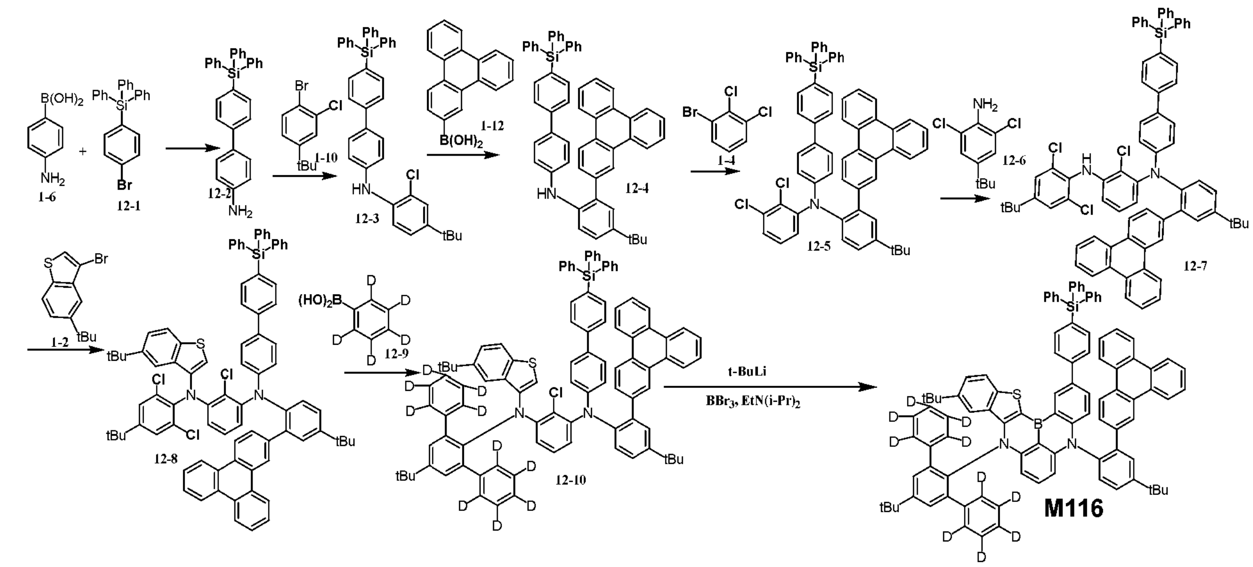


(1) Synthesis of Intermediate 12-2: compound 1-6 (10 mmol) and compound 12-1 (10 mmol) were dissolved in a mixed solvent of 1,4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 12-2 (8.73 mmol) with yield of 87.3%. ASAP-MS result of intermediate 12-2: MS (ASAP) = 427.

(2) Synthesis of Intermediate 12-3: intermediate 12-2 (10 mmol), compound 1-10 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 12-3 (8.84 mmol) with yield of 88.4%. ASAP-MS result of intermediate 12-3: MS (ASAP) = 593.

(3) Synthesis of Intermediate 12-4: intermediate 12-3 (10 mmol), compound 1-12 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 12-4 (6.87 mmol) with yield of 68.7%. ASAP-MS result of intermediate 12-4: MS (ASAP) = 785.

(4) Synthesis of Intermediate 12-5: intermediate 12-4 (10 mmol), compound 1-4 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 12-5 (7.31 mmol) with yield of 73.1%. ASAP-MS result of intermediate 12-5: MS (ASAP) = 929.

(5) Synthesis of Intermediate 12-7: intermediate 12-5 (10 mmol), compound 12-6 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 12-7 (6.16 mmol) with yield of 61.6%. ASAP-MS result of intermediate 12-7: MS (ASAP) = 1110.

(6) Synthesis of Intermediate 12-8: intermediate 12-7 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was

removed by rotary evaporation. Then the reaction solution was extracted, washed with water, and separated to obtain an organic phase. The organic phase was purified by column chromatography and recrystallized to obtain intermediate 12-8 (7.33 mmol) with yield of 73.3%. ASAP-MS result of intermediate 12-8: MS (ASAP) = 1298.

(7) Synthesis of Intermediate 12-10: intermediate 12-8 (10 mmol) and compound 12-9 (20 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 12-10 (5.73 mmol) with yield of 57.3%. ASAP-MS result of intermediate 12-10: MS (ASAP) = 1392.

(8) Synthesis of Organic Compound M116: intermediate 12-10 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M116 with yield of 38.3%. ASAP-MS result of organic compound M116: MS (ASAP) = 1366.

Example 13

Synthetic Route of Organic Compound M120 is as follows:

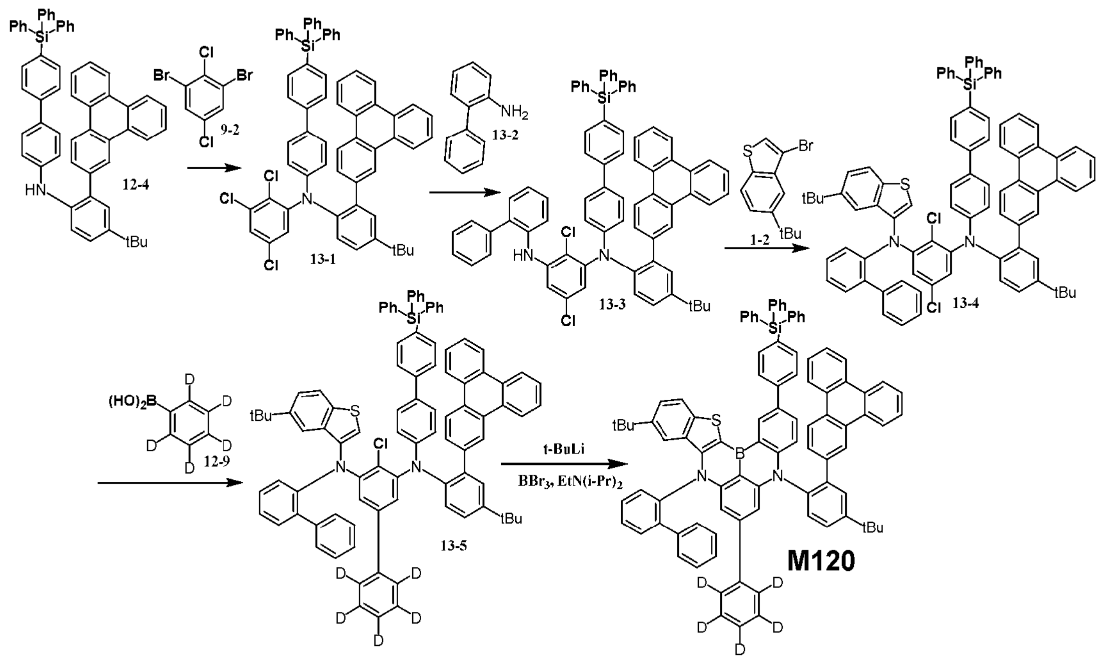


(1) Synthesis of Intermediate 13-1: intermediate 12-4 (10 mmol), compound 9-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 13-1 (7.88 mmol) with yield of 78.8%. ASAP-MS result of intermediate 13-1: MS (ASAP) = 963.

(2) Synthesis of Intermediate 13-3: intermediate 13-1 (10 mmol), compound 13-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 13-3 (6.96 mmol) with yield of 69.6%. ASAP-MS result of intermediate 13-3: MS (ASAP) = 1096.

(3) Synthesis of Intermediate 13-4: intermediate 13-3 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 13-4 (7.71 mmol) with yield of 77.1%. ASAP-MS result of intermediate 13-4: MS (ASAP) = 1284.

(4) Synthesis of Intermediate 13-5: intermediate 13-4 (10 mmol) and compound 12-9 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 13-5 (5.81 mmol) with yield of 58.1%. ASAP-MS result of intermediate 13-5: MS (ASAP) = 1331.

(5) Synthesis of Organic Compound M120: intermediate 13-5 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M120 with yield of 33.4%. ASAP-MS result of organic compound M120: MS (ASAP) = 1305.

Example 14

Synthetic Route of Organic Compound M145 is as follows:

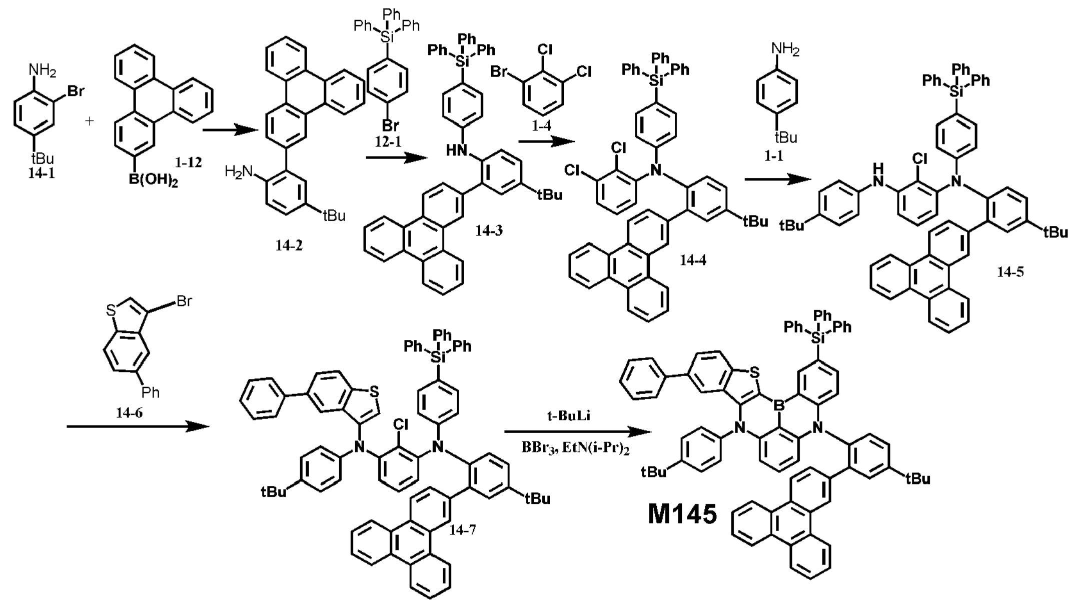

(1) Synthesis of Intermediate 14-2: compound 14-1 (10 mmol) and compound 12-1 (10 mmol) were dissolved in a mixed solvent of 1,4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 14-2 (8.12 mmol) with yield of 81.2%. ASAP-MS result of intermediate 14-2: MS (ASAP) = 375.

(2) Synthesis of Intermediate 14-3: intermediate 14-2 (10 mmol), compound 12-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 14-3 (8.54 mmol) with yield of 85.4%. ASAP-MS result of intermediate 14-3: MS (ASAP) = 709.

(3) Synthesis of Intermediate 14-4: intermediate 14-3 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 14-4 (6.57 mmol) with yield of 65.7%. ASAP-MS result of intermediate 14-4: MS (ASAP) = 853.

(4) Synthesis of Intermediate 14-5: intermediate 14-4 (10 mmol), compound 1-1 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 14-5 (7.81 mmol) with yield of 78.1%. ASAP-MS result of intermediate 14-5: MS (ASAP) = 966.

(5) Synthesis of Intermediate 14-7: intermediate 14-5 (10 mmol), compound 14-6 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 14-7 (5.86 mmol) with yield of 58.6%. ASAP-MS result of intermediate 14-7: MS (ASAP) = 1174.

(6) Synthesis of Organic Compound M145: intermediate 14-7 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M145 with yield of 36.1%. ASAP-MS result of organic compound M145: MS (ASAP) = 1148.

Example 15

Synthetic Route of Organic Compound M148 is as follows:

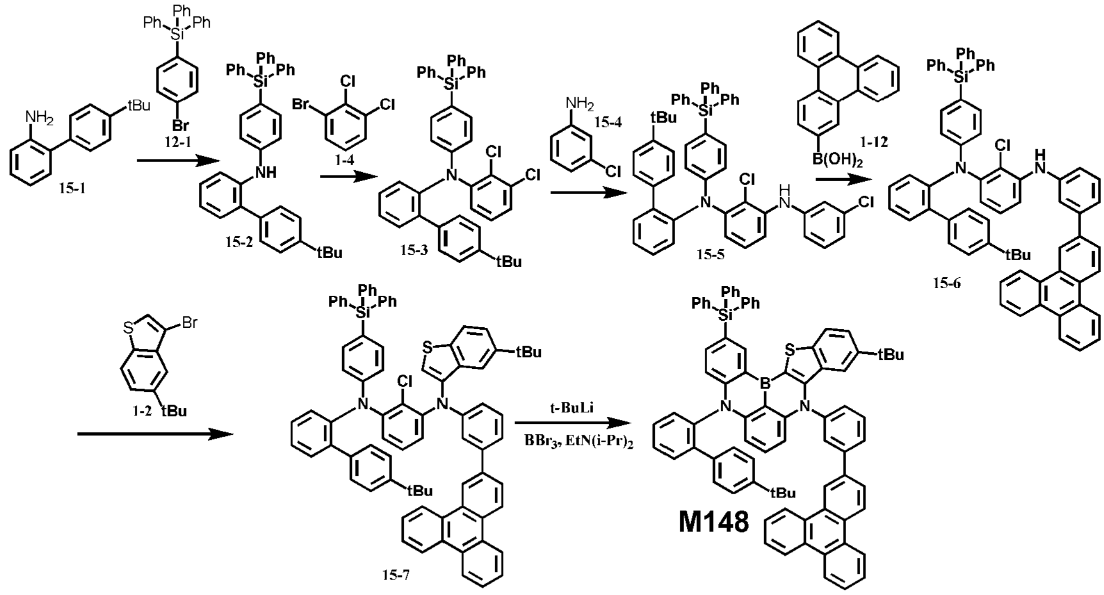


(1) Synthesis of Intermediate 15-2: compound 15-1 (10 mmol) and compound 12-1 (10 mmol) were dissolved in a mixed solvent of 1,4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 15-2 (8.42 mmol) with yield of 84.2%. ASAP-MS result of intermediate 15-2: MS (ASAP) = 559.

(2) Synthesis of Intermediate 15-3: intermediate 15-2 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 15-3 (8.94 mmol) with yield of 89.4%. ASAP-MS result of intermediate 15-3: MS (ASAP) = 703.

(3) Synthesis of Intermediate 15-5: intermediate 15-3 (10 mmol), compound 15-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 15-5 (6.77 mmol) with yield of 67.7%. ASAP-MS result of intermediate 15-5: MS (ASAP) = 794.

(4) Synthesis of Intermediate 15-6: intermediate 15-5 (10 mmol), compound 1-12 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 15-6 (7.53 mmol) with yield of 75.3%. ASAP-MS result of intermediate 15-6: MS (ASAP) = 986.

(5) Synthesis of Intermediate 15-7: intermediate 15-6 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 15-7 (5.49 mmol) with yield of 54.9%. ASAP-MS result of intermediate 15-7: MS (ASAP) = 1174.

(6) Synthesis of Organic Compound M148: intermediate 15-7 (10 mmol) and dry tert-butylbenzene (100 mL) were added to a three-necked flask (250 mL), cooled to -30 °C in $N_2$ atmosphere, a solution of t-BuLi (21 mmol) dissolved

with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M148 with yield of 39.3%. ASAP-MS result of organic compound M148: MS (ASAP) = 1148.

Example 16

Synthetic Route of Organic Compound M149 is as follows:

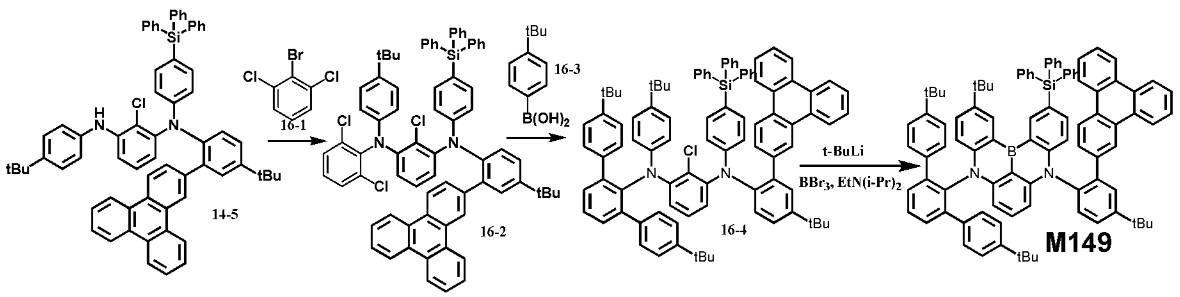


(1) Synthesis of Intermediate 16-2: intermediate 14-5 (10 mmol), compound 16-1 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 16-2 (7.59 mmol) with yield of 75.9%. ASAP-MS result of intermediate 16-2: MS (ASAP) = 1110.

(2) Synthesis of Intermediate 16-4: intermediate 16-2 (10 mmol) and compound 16-3 (20 mmol) were dissolved in a mixed solvent of 1,4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 16-4 (8.83 mmol) with yield of 88.3%. ASAP-MS result of intermediate 16-4: MS (ASAP) = 1306.

(3) Synthesis of Organic Compound M149: intermediate 16-4 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M149 with yield of 43.2%. ASAP-MS result of organic compound M149: MS (ASAP) = 1280.

Example 17

Synthetic Route of Organic Compound M150 is as follows:

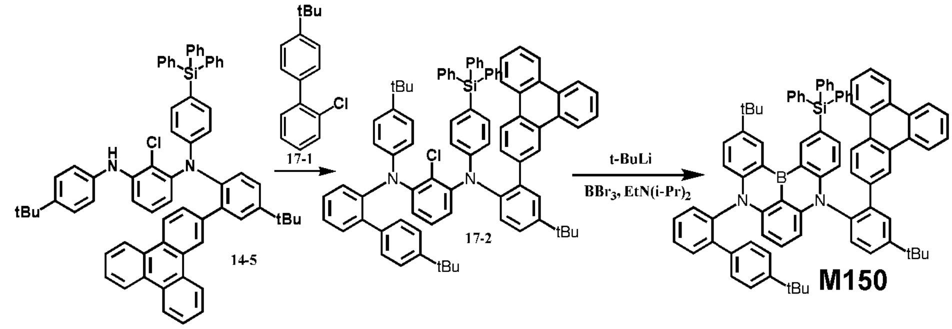


(1) Synthesis of Intermediate 17-2: intermediate 14-5 (10 mmol), compound 17-1 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 17-2 (7.93 mmol) with yield of 79.3%. ASAP-MS result of intermediate 17-2: MS (ASAP) = 1174.

(2) Synthesis of Organic Compound M150: intermediate 17-2 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M150 with yield of 36.3%. ASAP-MS result of organic compound M150: MS (ASAP) = 1148.

Example 18

Synthetic Route of Organic Compound M151 is as follows:

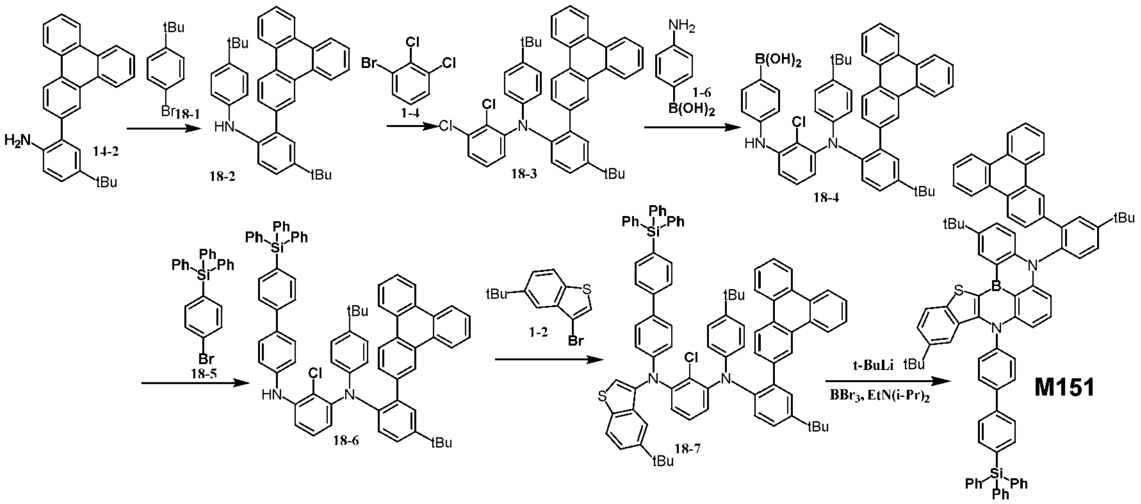


(1) Synthesis of Intermediate 18-2: intermediate 14-2 (10 mmol), compound 18-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 18-2 (7.68 mmol) with yield of 76.8%. ASAP-MS result of intermediate 18-2: MS (ASAP) = 507.

(2) Synthesis of Intermediate 18-3: intermediate 18-2 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 18-3 (6.97 mmol) with yield of 69.7%. ASAP-MS result of intermediate 18-3: MS (ASAP) = 651.

(3) Synthesis of Intermediate 18-4: intermediate 18-3 (10 mmol), compound 1-6 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 18-4 (7.42 mmol) with yield of 74.2%. ASAP-MS result of intermediate 18-4: MS (ASAP) = 752.

(4) Synthesis of Intermediate 18-6: intermediate 18-4 (10 mmol), compound 18-5 (10 mmol), tris(dibenzylideneacetone)dipalladium ($Pd_2(dba)_3$, 0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 18-6 (5.97 mmol) with yield of 59.7%. ASAP-MS result of intermediate 18-6: MS (ASAP) = 1042.

(5) Synthesis of Intermediate 18-7: intermediate 18-6 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 18-7 (7.27 mmol) with yield of 72.7%. ASAP-MS result of intermediate 18-7: MS (ASAP) = 1230.

(6) Synthesis of Organic Compound M151: intermediate 18-7 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M151 with yield of 33.8%. ASAP-MS result of organic compound M151: MS (ASAP) = 1204.

Example 19

Synthetic Route of Organic Compound M152 is as follows:

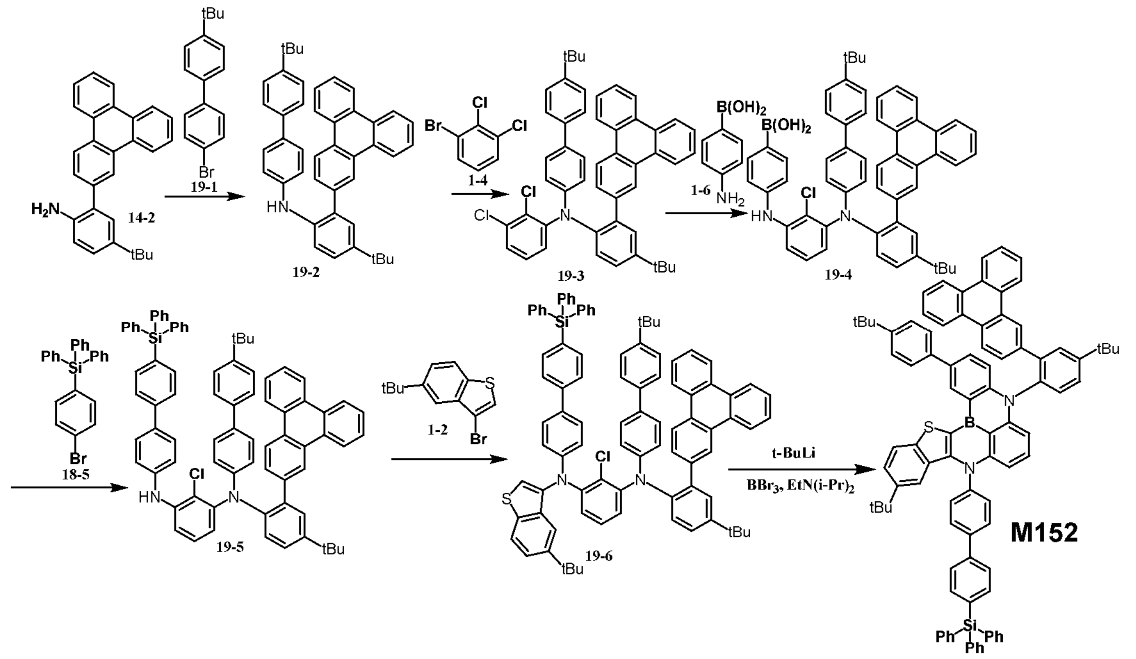


(1) Synthesis of Intermediate 19-2: intermediate 14-2 (10 mmol), compound 19-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 19-2 (6.45 mmol) with yield of 64.5%. ASAP-MS result of intermediate 19-2: MS (ASAP) = 583.

(2) Synthesis of Intermediate 19-3: intermediate 19-2 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 19-3 (6.91 mmol) with yield of 69.1%. ASAP-MS result of intermediate 19-3: MS (ASAP) = 727.

(3) Synthesis of Intermediate 19-4: intermediate 19-3 (10 mmol), compound 1-6 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 19-4 (5.54 mmol) with yield of 55.4%. ASAP-MS result of intermediate 19-4: MS (ASAP) = 828.

(4) Synthesis of Intermediate 19-5: intermediate 19-4 (10 mmol), compound 18-5 (10 mmol), $Pd_2(dba)_3$ (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 19-5 (5.49 mmol) with yield of 54.9%. ASAP-MS result of intermediate 19-5: MS (ASAP) = 1118.

(5) Synthesis of Intermediate 19-6: intermediate 19-5 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 19-6 (7.55 mmol) with yield of 75.5%. ASAP-MS result of intermediate 19-6: MS (ASAP) = 1306.

(6) Synthesis of Organic Compound M152: intermediate 19-6 (10 mmol) and dry tert-butylbenzene (100 mL) were

added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M152 with yield of 29.6%. ASAP-MS result of organic compound M152: MS (ASAP) = 1280.

Example 20

Synthetic Route of Organic Compound M153 is as follows:

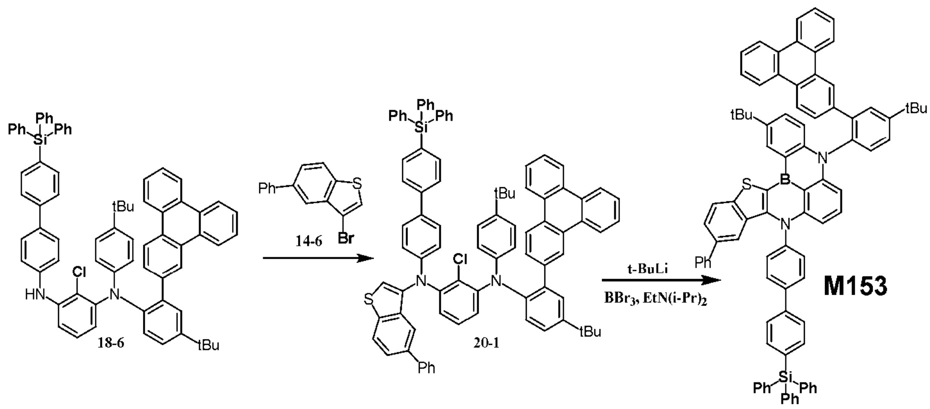


(1) Synthesis of Intermediate 20-1: intermediate 18-6 (10 mmol), intermediate 14-6 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 20-1 (7.76 mmol) with yield of 77.6%. ASAP-MS result of intermediate 20-1: MS (ASAP) = 1250.

(2) Synthesis of Organic Compound M153: intermediate 20-1 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M153 with yield of 36.3%. ASAP-MS result of organic compound M153: MS (ASAP) = 1224.

Example 21

Synthetic Route of Organic Compound M154 is as follows:

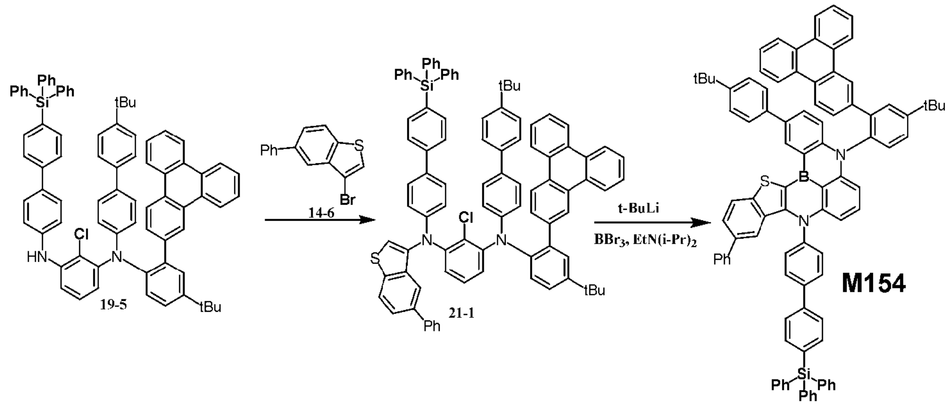


19-5 21-1 M154

(1) Synthesis of Intermediate 21-1: intermediate 19-5 (10 mmol), intermediate 14-6 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 21-1 (6.53 mmol) with yield of 65.3%. ASAP-MS result of intermediate 21-1: MS (ASAP) = 1326.

(2) Synthesis of Organic Compound M154: intermediate 21-1 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. EtN(i-Pr)$_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M154 with yield of 31.2%. ASAP-MS result of organic compound M154: MS (ASAP) = 1300.

Example 22

Synthetic Route of Organic Compound M155 is as follows:

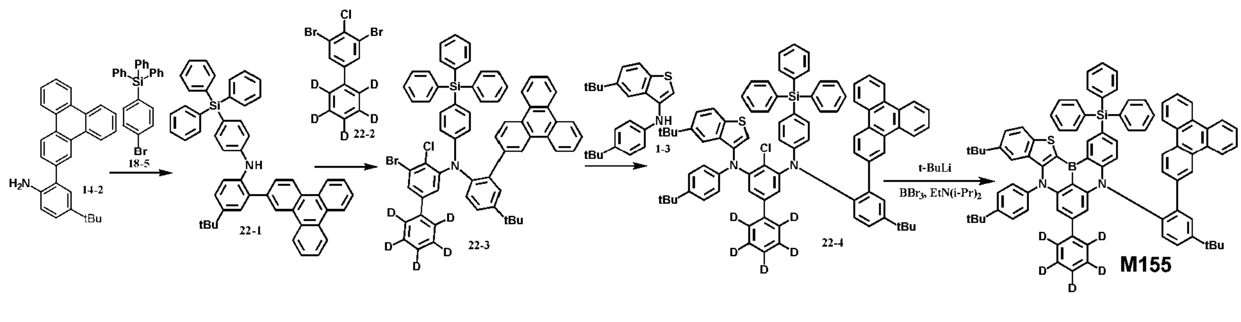


14-2 22-1 22-2 22-3 22-4 M155

(1) Synthesis of Intermediate 22-1: intermediate 14-2 (10 mmol), compound 18-5 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 22-1 (5.67 mmol) with yield of 56.7%. ASAP-MS result of intermediate 22-1: MS (ASAP) = 709.

(2) Synthesis of Intermediate 22-3: intermediate 22-1 (10 mmol), compound 22-2 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain

an organic phase. The organic phase was purified by column chromatography to obtain intermediate 22-3 (6.18 mmol) with yield of 61.8%. ASAP-MS result of intermediate 22-3: MS (ASAP) = 978.

(3) Synthesis of Intermediate 22-4: intermediate 22-3 (10 mmol), intermediate 1-3 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 22-4 (7.27 mmol) with yield of 72.7%. ASAP-MS result of intermediate 22-4: MS (ASAP) = 1235.

(4) Synthesis of Organic Compound M155: intermediate 22-4 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. EtN(i-Pr)$_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M155 with yield of 28.9%. ASAP-MS result of organic compound M155: MS (ASAP) = 1209.

Example 23

Synthetic Route of Organic Compound M156 is as follows:

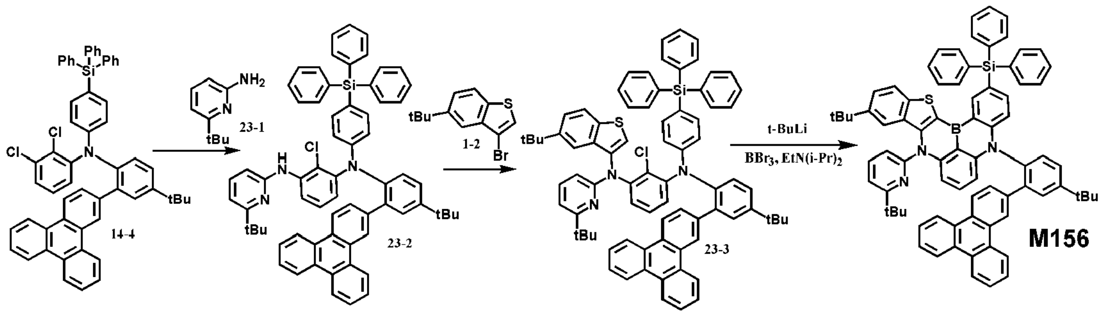


(1) Synthesis of Intermediate 23-2: intermediate 14-4 (10 mmol), compound 23-1 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 23-2 (7.86 mmol) with yield of 78.6%. ASAP-MS result of intermediate 23-2: MS (ASAP) = 967.

(2) Synthesis of Intermediate 23-3: intermediate 23-2 (10 mmol), compound 1-2 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 23-3 (5.23 mmol) with yield of 52.3%. ASAP-MS result of intermediate 23-3: MS (ASAP) = 1155.

(3) Synthesis of Organic Compound M156: intermediate 23-3 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. EtN(i-Pr)$_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M156 with yield of 43.6%. ASAP-MS result of organic compound M156: MS (ASAP) = 1129.

Example 24

Synthetic Route of Organic Compound M157 is as follows:

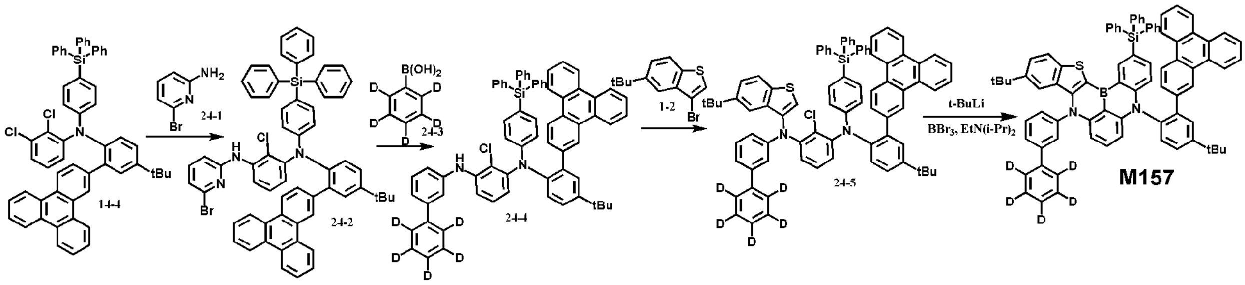


(1) Synthesis of Intermediate 24-2: intermediate 14-4 (10 mmol), compound 24-1 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 24-2 (7.37 mmol) with yield of 73.7%. ASAP-MS result of intermediate 24-2: MS (ASAP) = 989.

(2) Synthesis of Intermediate 24-4: intermediate 24-2 (10 mmol) and compound 24-3 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 24-4 (8.61 mmol) with yield of 86.1%. ASAP-MS result of intermediate 24-4: MS (ASAP) = 991.

(3) Synthesis of Intermediate 24-5: intermediate 24-4 (10 mmol), compound 1-2 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 24-5 (5.63 mmol) with yield of 56.3%. ASAP-MS result of intermediate 24-5: MS (ASAP) = 1179.

(4) Synthesis of Organic Compound M157: intermediate 24-5 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M157 with yield of 41.1%. ASAP-MS result of organic compound M157: MS (ASAP) = 1153.

Example 25

Synthetic Route of Organic Compound M158 is as follows:

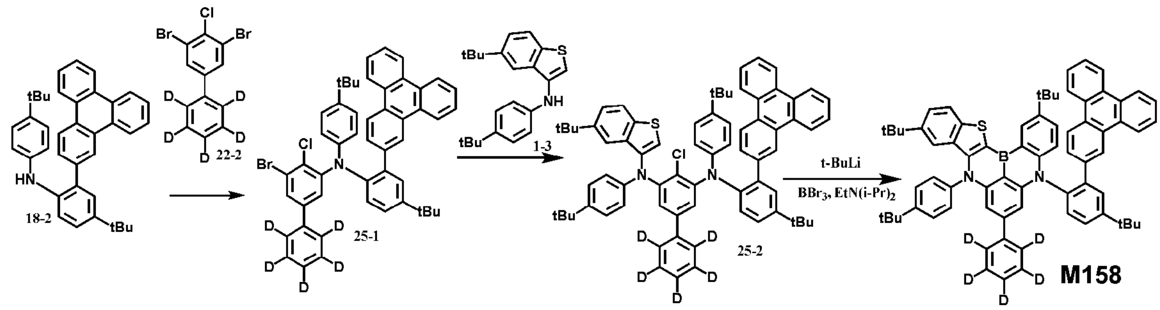


(1) Synthesis of Intermediate 25-1: intermediate 18-2 (10 mmol), compound 22-2 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 25-1 (6.33 mmol) with yield of 63.3%. ASAP-MS result of intermediate 25-1: MS (ASAP) = 776.

(2) Synthesis of Intermediate 25-2: intermediate 25-1 (10 mmol), intermediate 1-3 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 25-2 (8.36 mmol) with yield of 83.6%. ASAP-MS result of intermediate 25-2: MS (ASAP) = 1033.

(3) Synthesis of Organic Compound M158: intermediate 25-2 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M158 with yield of 36.9%. ASAP-MS result of organic compound M158: MS (ASAP) = 1007.

Example 26

Synthetic Route of Organic Compound M159 is as follows:

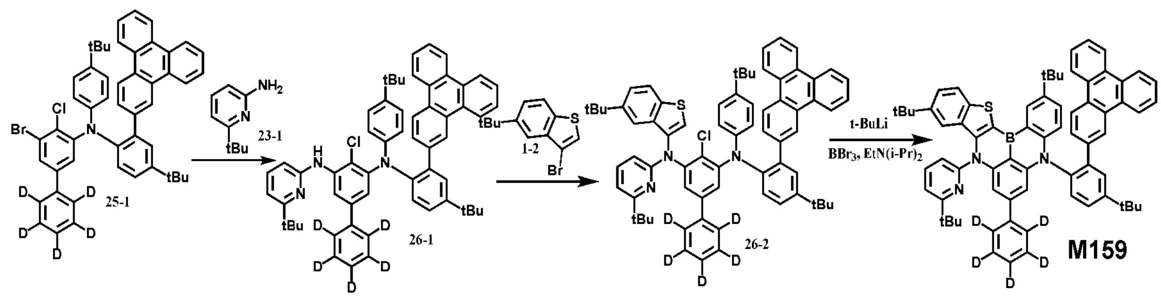


(1) Synthesis of Intermediate 26-1: intermediate 25-1 (10 mmol), compound 23-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 26-1 (6.89 mmol) with yield of 68.9%. ASAP-MS result of intermediate 26-1: MS (ASAP) = 846.

(2) Synthesis of Intermediate 26-2: intermediate 26-1 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 26-2 (8.11 mmol) with yield of 81.1%. ASAP-MS result of intermediate 26-2: MS (ASAP) = 1034.

(3) Synthesis of Organic Compound M159: intermediate 26-2 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. EtN(i-Pr)$_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M159 with yield of 37.3%. ASAP-MS result of organic compound M159: MS (ASAP) = 1008.

Example 27

Synthetic Route of Organic Compound M160 is as follows:

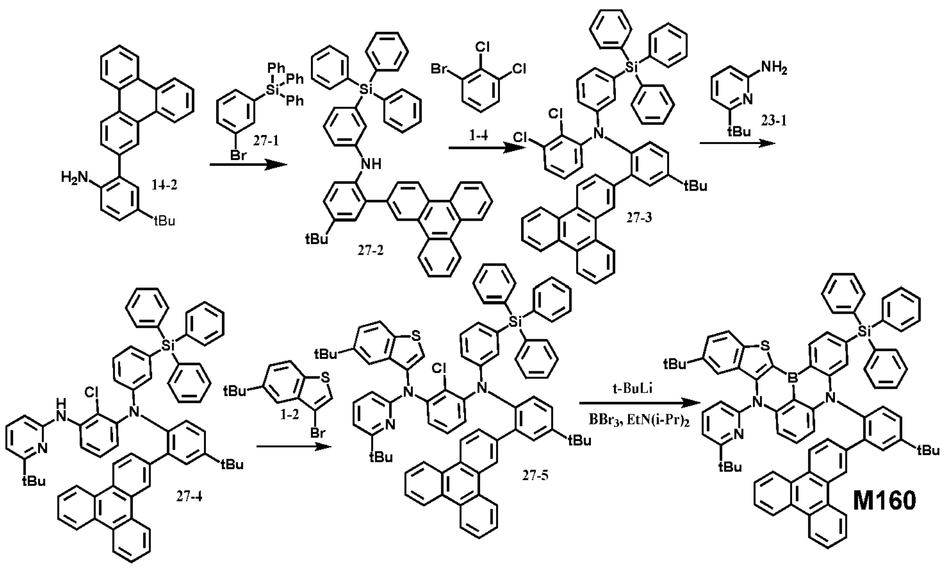


(1) Synthesis of Intermediate 27-2: intermediate 14-2 (10 mmol), compound 27-1 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 27-2 (5.80 mmol) with yield of 58.9%. ASAP-MS result of intermediate 27-2: MS (ASAP) = 709.

(2) Synthesis of Intermediate 27-3: intermediate 27-2 (10 mmol), compound 1-4 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 27-3 (8.63 mmol) with yield of 86.3%. ASAP-MS result of intermediate 27-3: MS (ASAP) = 853.

(3) Synthesis of Intermediate 27-4: intermediate 27-3 (10 mmol), compound 23-1 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain

an organic phase. The organic phase was purified by column chromatography to obtain intermediate 27-4 (6.84 mmol) with yield of 68.4%. ASAP-MS result of intermediate 27-4: MS (ASAP) = 967.

(4) Synthesis of Intermediate 27-5: intermediate 27-4 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 27-5 (7.69 mmol) with yield of 76.9%. ASAP-MS result of intermediate 27-5: MS (ASAP) = 1155.

(5) Synthesis of Organic Compound M160: intermediate 27-5 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. EtN(i-Pr)$_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M160 with yield of 37.0%. ASAP-MS result of organic compound M160: MS (ASAP) = 1129.

Example 28

Synthetic Route of Organic Compound M161 is as follows:

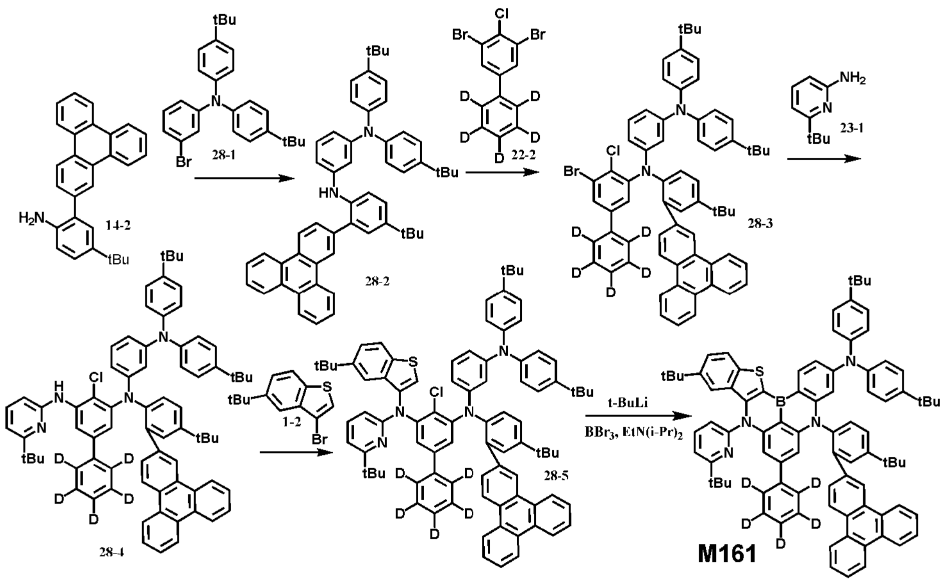


(1) Synthesis of Intermediate 28-2: intermediate 14-2 (10 mmol), compound 28-1 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 28-2 (6.90 mmol) with yield of 69.0%. ASAP-MS result of intermediate 28-2: MS (ASAP) = 730.

(2) Synthesis of Intermediate 28-3: intermediate 28-2 (10 mmol), compound 22-2 (10 mmol), Pd(dba)$_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 28-3 (8.12 mmol) with yield of 81.2%. ASAP-MS result of intermediate 28-3: MS (ASAP) = 999.

(3) Synthesis of Intermediate 28-4: intermediate 28-3 (10 mmol), compound 23-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 28-4 (7.53 mmol) with yield of 75.3%. ASAP-MS result of intermediate 28-4: MS (ASAP) = 1069.

(4) Synthesis of Intermediate 28-5: intermediate 28-4 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 28-5 (7.20 mmol) with yield of 72.0%. ASAP-MS result of intermediate 28-5: MS (ASAP) = 1257.

(5) Synthesis of Organic Compound M161: intermediate 28-5 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i-Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M161 with yield of 32.8%. ASAP-MS result of organic compound M161: MS (ASAP) = 1231.

Example 29

Synthetic Route of Organic Compound M162 is as follows:

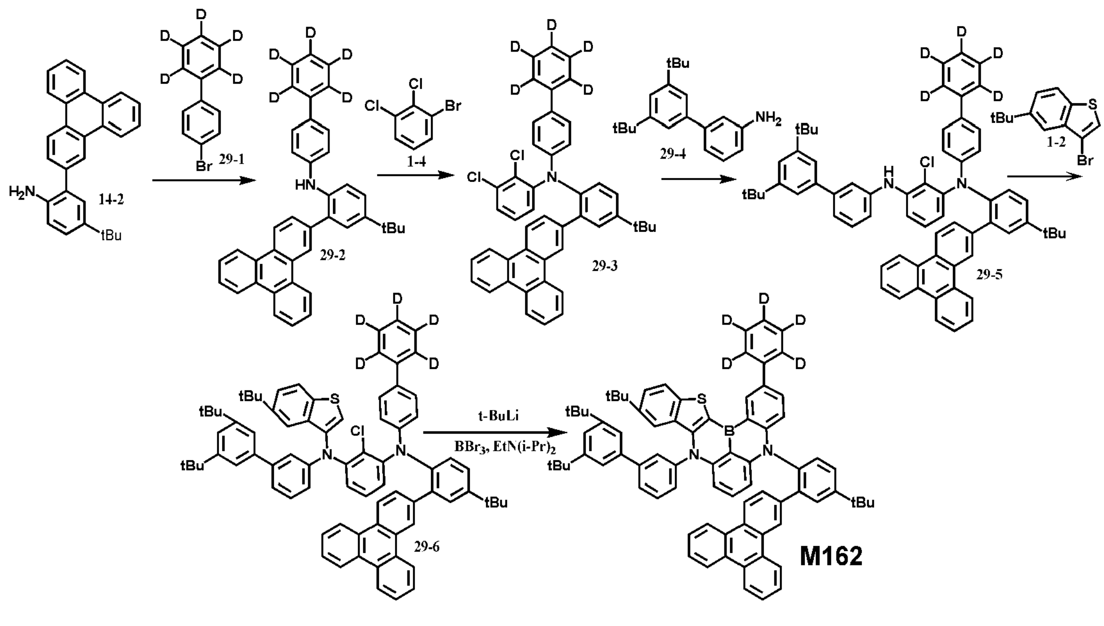


(1) Synthesis of Intermediate 29-2: intermediate 14-2 (10 mmol), compound 29-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 29-2 (7.92 mmol) with yield of 79.2%. ASAP-MS result of intermediate 29-2: MS (ASAP) = 532.

(2) Synthesis of Intermediate 29-3: intermediate 29-2 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 29-3 (8.56 mmol) with yield of 85.6%. ASAP-MS result of intermediate 29-3: MS (ASAP) = 676.

(3) Synthesis of Intermediate 29-5: intermediate 29-3 (10 mmol), compound 29-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 29-5 (7.21 mmol) with yield of 72.1%. ASAP-MS result of intermediate 29-5: MS (ASAP) = 921.

(4) Synthesis of Intermediate 29-6: intermediate 29-5 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 29-6 (7.38 mmol) with yield of 73.8%. ASAP-MS result of intermediate 29-6: MS (ASAP) = 1109.

(5) Synthesis of Organic Compound M162: intermediate 29-6 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M162 with yield of 36.4%. ASAP-MS result of organic compound M162: MS (ASAP) = 1083.

Example 30

Synthetic Route of Organic Compound M163 is as follows:

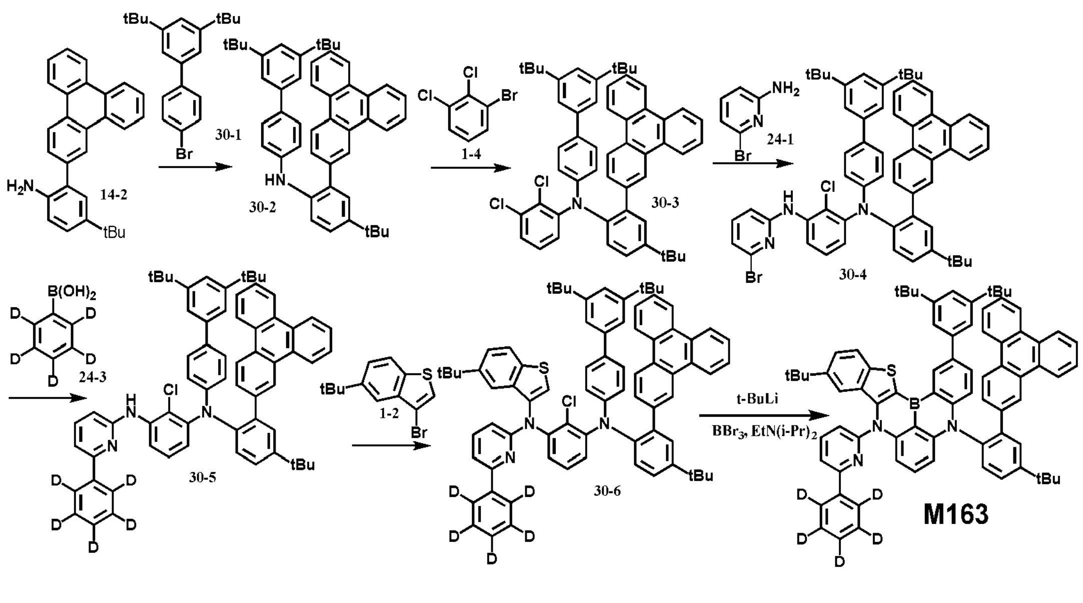


(1) Synthesis of Intermediate 30-2: intermediate 14-2 (10 mmol), compound 30-1 (10 mmol), $Pd(dba)_2$ (0.1 mmol), TTBP (0.2 mmol), and sodium tert-butoxide (30 mmol) were dissolved in toluene, and heated to 100 °C and stirred for 6

hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 30-2 (7.35 mmol) with yield of 73.5%. ASAP-MS result of intermediate 30-2: MS (ASAP) = 639.

(2) Synthesis of Intermediate 30-3: intermediate 30-2 (10 mmol), compound 1-4 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 30-3 (8.22 mmol) with yield of 82.2%. ASAP-MS result of intermediate 30-3: MS (ASAP) = 783.

(3) Synthesis of Intermediate 30-4: intermediate 30-3 (10 mmol), compound 24-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 30-4 (7.38 mmol) with yield of 73.8%. ASAP-MS result of intermediate 30-4: MS (ASAP) = 919.

(4) Synthesis of Intermediate 30-5: intermediate 30-4 (10 mmol) and compound 24-3 (10 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 30-5 (8.09 mmol) with yield of 80.9%. ASAP-MS result of intermediate 30-5: MS (ASAP) = 922.

(5) Synthesis of Intermediate 30-6: intermediate 30-5 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 30-6 (7.85 mmol) with yield of 78.5%. ASAP-MS result of intermediate 30-6: MS (ASAP) = 1110.

(6) Synthesis of Organic Compound M163: intermediate 30-6 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M163 with yield of 36.9%. ASAP-MS result of organic compound M163: MS (ASAP) = 1084.

Example 31

Synthetic Route of Organic Compound M164 is as follows:

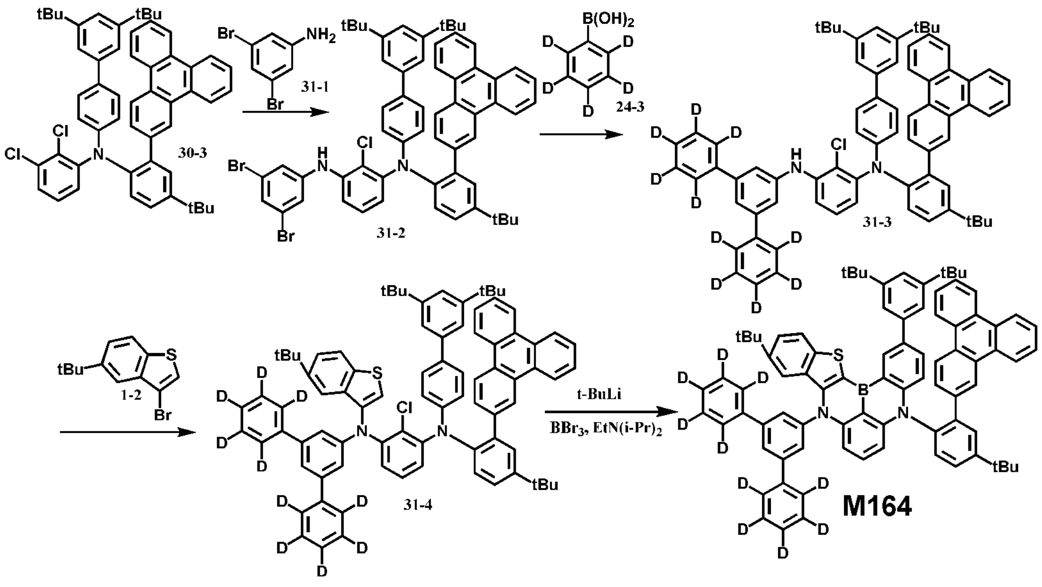


(1) Synthesis of Intermediate 31-2: intermediate 30-3 (10 mmol), compound 31-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 31-2 (7.96 mmol) with yield of 79.6%. ASAP-MS result of intermediate 31-2: MS (ASAP) = 996.

(2) Synthesis of Intermediate 31-3: intermediate 31-3 (10 mmol) and compound 24-3 (20 mmol) were dissolved in a mixed solvent of 1, 4-dioxane and water (21:2/mL), $Pd(PPh_3)_4$ (0.1 mmol) and potassium carbonate (30 mmol) were added, and the reaction solution was heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 31-3 (8.57 mmol) with yield of 85.7%. ASAP-MS result of intermediate 31-3: MS (ASAP) = 1002.

(3) Synthesis of Intermediate 31-4: intermediate 31-3 (10 mmol), compound 1-2 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 31-4 (7.25 mmol) with yield of 72.5%. ASAP-MS result of intermediate 31-4: MS (ASAP) = 1190.

(4) Synthesis of Organic Compound M164: intermediate 31-4 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M164 with yield of 44.6%. ASAP-MS result of organic compound M164: MS (ASAP) = 1164.

Example 32

Synthetic Route of Organic Compound M165 is as follows:

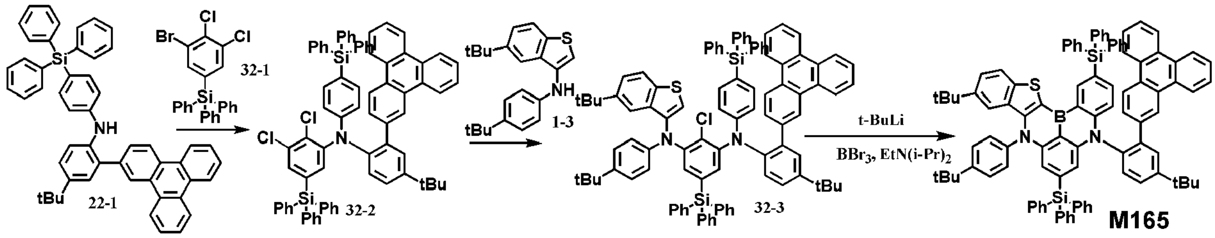


22-1 32-1 32-2 1-3 32-3 M165

(1) Synthesis of Intermediate 32-2: intermediate 22-1 (10 mmol), compound 32-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 32-2 (6.59 mmol) with yield of 65.9%. ASAP-MS result of intermediate 32-2: MS (ASAP) = 1111.

(2) Synthesis of Intermediate 32-3: intermediate 32-2 (10 mmol), intermediate 1-3 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 32-3 (7.93 mmol) with yield of 79.3%. ASAP-MS result of intermediate 32-3: MS (ASAP) = 1412.

(3) Synthesis of Organic Compound M165: intermediate 32-3 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i-Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M165 with yield of 37.7%. HNMR of organic compound M165 is shown in FIG. 1. ASAP-MS result of organic compound M165: MS (ASAP) = 1386.

Example 33

Synthetic Route of Organic Compound M166 is as follows:

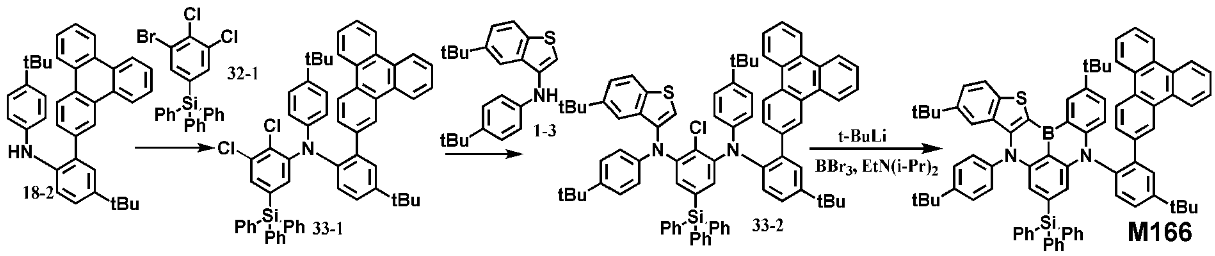


18-2 32-1 33-1 1-3 33-2 M166

(1) Synthesis of Intermediate 33-1: intermediate 18-2 (10 mmol), compound 32-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 33-1 (6.59 mmol) with yield of 65.9%. ASAP-MS result of intermediate 33-1: MS (ASAP) = 909.

(2) Synthesis of Intermediate 33-2: intermediate 33-1 (10 mmol), intermediate 1-3 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 33-2 (7.54 mmol) with yield of 75.4%. ASAP-MS result of intermediate 33-2: MS (ASAP) = 1210.

(3) Synthesis of Organic Compound M166: intermediate 33-2 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M166 with yield of 32.8%. HNMR of organic compound M166 is shown in FIG. 2. ASAP-MS result of organic compound M166: MS (ASAP) = 1184.

Example 34

Synthetic Route of Organic Compound M167 is as follows:

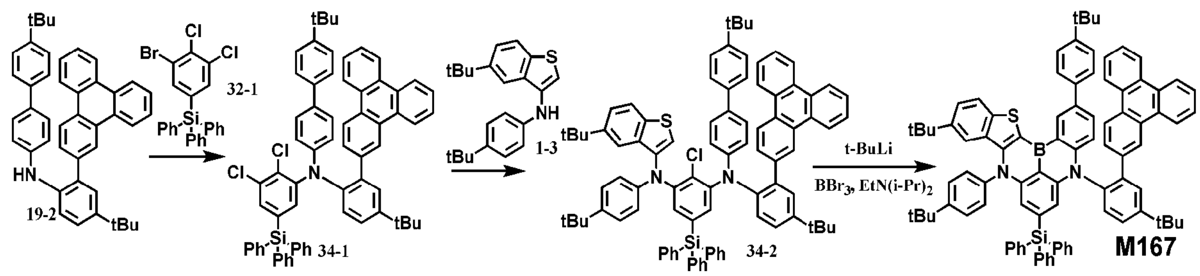


(1) Synthesis of Intermediate 34-1: intermediate 19-2 (10 mmol), compound 32-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 34-1 (8.41 mmol) with yield of 84.1%. ASAP-MS result of intermediate 34-1: MS (ASAP) = 985.

(2) Synthesis of Intermediate 34-2: intermediate 34-1 (10 mmol), intermediate 1-3 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 34-2 (8.03 mmol) with yield of 80.3%. ASAP-MS result of intermediate 34-2: MS (ASAP) = 1286.

(3) Synthesis of Organic Compound M167: intermediate 34-2 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. $EtN(i\text{-}Pr)_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M167 with yield of 38.3%. HNMR of organic compound M167 is shown in FIG. 3. ASAP-MS result of organic compound

M167: MS (ASAP) = 1260.

Example 35

Synthetic Route of Organic Compound M168 is as follows:

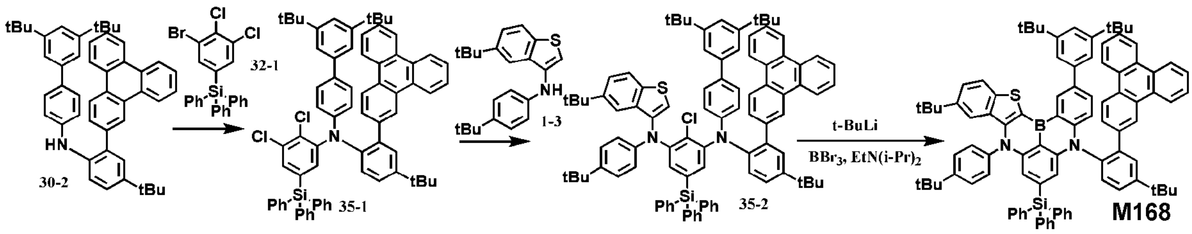


(1) Synthesis of Intermediate 35-1: intermediate 30-2 (10 mmol), compound 32-1 (10 mmol), $Pd(dba)_2$ (0.1 mmol), TTBP (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography to obtain intermediate 35-1 (8.17 mmol) with yield of 81.7%. ASAP-MS result of intermediate 35-1: MS (ASAP) = 1041.

(2) Synthesis of Intermediate 35-2: intermediate 35-1 (10 mmol), intermediate 1-3 (10 mmol), Pd-132 (0.1 mmol), S-Phos (0.2 mmol), and sodium tert-butoxide (30 mmol) were dissolved in toluene, and heated to 100 °C and stirred for 6 hours in a $N_2$ environment. After the reaction was completed, the reaction solution was cooled and the solvent was removed by rotary evaporation. Then the reaction solution was extracted, washed with water, and separated to obtain an organic phase. The organic phase was purified by column chromatography and recrystallized to obtain intermediate 35-2 (7.29 mmol) with yield of 72.9%. ASAP-MS result of intermediate 35-2: MS (ASAP) = 1342.

(3) Synthesis of Organic Compound M168: intermediate 35-2 (10 mmol) and dry tert-butylbenzene (100 mL) were added to a three-necked flask (250 mL), cooled to -30 °C in $N_2$ atmosphere, a solution of t-BuLi (21 mmol) dissolved with n-hexane was added dropwise, the reaction solution was heated to 60 °C and reacted for 2 hours, then n-hexane was removed by rotary evaporation. The reaction solution was cooled to -30 °C again, $BBr_3$ (21 mmol) was added, the reaction solution was heated to room temperature and stirred for 0.5 hour, and cooled to 0 °C. EtN(i-Pr)$_2$ (42 mmol) was added, heated to room temperature and stirred, then heated to 120 °C and stirred for 3 hours. The reaction solution was cooled to room temperature, and sodium carbonate aqueous solution and ethyl acetate were added to quench the reaction. Aqueous phase was extracted with ethyl acetate and organic phases were merged. The solvent was removed by rotary evaporation to obtain a crude product, which was purified by column chromatography and recrystallized using toluene and ethyl acetate, obtaining a light yellow solid powder that was organic compound M168 with yield of 39.2%. ASAP-MS result of organic compound M168: MS (ASAP) = 1316.

The above organic compounds provided in examples 1-35 contain boron and biphenyl, by introducing at least one of dibenzofuran, dibenzothiophene, carbazole, benzo five-membered ring, triphenylene, and naphthalene into the organic compound containing boron and biphenyl, the overall molecular conjugation of the organic compound is increased, and therefore the luminous efficiency and service life of the organic light-emitting device using the organic compound can be improved. Moreover, the introduction of at least one of tetrahydronaphthalene and indene into the organic compound containing boron and biphenyl can improve the solubility of molecules in processes such as inkjet printing, facilitating the purification of the organic compound in the preparation process, improving the purity of the organic compound, and further improving the luminous efficiency and service life of the organic light-emitting device using the organic compound.

Some embodiments of the present application further provide a mixture, which includes at least one organic compound as described above and at least one organic functional material. In some embodiments, when the mixture is used in an organic light-emitting device, the organic functional material is selected from at least one of a hole injection material, a hole transport material, an electron transport material, an electron injection material, an electron blocking material, a hole blocking material, a light-emitting material, and an organic dye.

Some embodiments of the present application further provide a composition, the composition includes one or more of the organic compounds as described above and at least one organic solvent, or, the composition includes the mixture as described above and at least one organic solvent.

In some embodiments, the composition is a solution or a suspension, and the composition includes a dispersion agent and a dispersion aid. The dispersion agent is composed of one or more of the organic compounds as described above and at least one organic solvent, or the dispersion agent is the mixture as described above. The dispersion aid is used for dispersing the dispersion agent.

In some embodiments, the organic compound in the composition ranges from 0.3% to 30% by mass on a total mass of the composition, for example, 0.5% to 20%, 0.5% to 15%, 0.5% to 10%, or 1% to 5%.

When the composition is used in the printing process, it can be ink, and the viscosity and surface tension of the ink are important parameters. The appropriate surface tension of the ink is suitable for a specific substrate and a specific printing method. In some embodiments, the ink has a surface tension from 19 dyne/cm to 50 dyne/cm at an operation temperature or a temperature of 25 °C, for example, 22 dyne/cm to 35 dyne/cm or 25 dyne/cm to 33 dyne/cm, which is conducive to the use of the composition in the inkjet printing process. In some embodiments, the ink has a viscosity from 1 cps to 100 cps at an operation temperature or a temperature of 25 °C, for example, 1 cps to 50 cps, 1.5 cps to 20 cps, or 4.0 cps to 20 cps, which is conducive to the use of the composition in the inkjet printing process.

In some embodiments, the Hansen solubility parameters of the dispersion acid are as follows: $\delta d$ (dispersion force) ranges from 17.0 $MPa^{1/2}$ to 23.2 $MPa^{1/2}$, for example, 18.5 $MPa^{1/2}$ to 21.0 $MPa^{1/2}$; $\delta p$ (polarity force) ranges from 0.2 $MPa^{1/2}$ to 12.5 $MPa^{1/2}$, for example, 2.0 $MPa^{1/2}$ to 6.0 $MPa^{1/2}$; and $\delta h$ (hydrogen bonding force) ranges from 0.9 $MPa^{1/2}$ to 14.2 $MPa^{1/2}$, for example, 2.0 $MPa^{1/2}$ to 6.0 $MPa^{1/2}$.

In some embodiments, the boiling point of the dispersion acid is greater than or equal to 150 °C, which is beneficial to preventing nozzles of inkjet printing heads from clogging, and the higher the boiling point, the more beneficial it is for preventing clogging. For example, the boiling point of the dispersion acid is greater than or equal to 180 °C, greater than or equal to 200 °C, greater than or equal to 250 °C, or greater than or equal to 300 °C.

In some embodiments, the dispersion aid includes at least one organic solvent, and the organic solvent can evaporate from a solvent system to form a film containing functional materials.

In some embodiments, the organic solvent is selected from an aromatic-based solvent or a heteroaromatic-based solvent. Examples of the organic solvent include, but not limited to, 1,4-diisopropylbenzene, pentylbenzene, tetrahydronaphthalene, cyclohexylbenzene, chloronaphthalene, 1,4-dimethylnaphthalene, 3-isopropylbiphenyl, p-methylisopropylbenzene, dipentylbenzene, tripentylbenzene, pentyltoluene, 1,2-diethylbenzene, m-diethylbenzene, 1,4-diethylbenzene, 1,2,3,4-tetramethylbenzene, 1,2,3,5-tetramethylbenzene, 1,2,4,5-tetramethylbenzene, butylbenzene, dodecylbenzene, dihexylbenzene, dibutylbenzene, 1,4-diisopropylbenzene, cyclohexylbenzene, benzylbutylbenzene, dimethylnaphthalene, 3-isopropylbiphenyl, p-isopropyltoluene, 1-methylnaphthalene, 1,2,4-trichlorobenzene, 4,4'-difluorodiphenylmethane, methyl eugenol, methyl isoeugenol, diphenylmethane, 2-phenylpyridine, 3-phenylpyridine, N-methyldiphenylamine, 4-isopropylbiphenyl, diphenyldichloromethane, 4-(3-phenylpropyl)pyridine, benzyl benzoate, 1,1-bis(3,4-dimethylphenyl)ethane, 2-isopropylnaphthalene, quinoline, isoquinoline, methyl 2-furanoate, and ethyl 2-furanoate.

In some embodiments, the organic solvent is an aromatic ketone-based solvent. Examples of the organic solvent include, but not limited to, 1-tetralone, beta-tetralone, 2-phenylepoxy-1-tetralone, 6-methoxy-1-tetralone, acetophenone, propiophenone, benzophenone, and derivatives thereof, for example, 4-methylacetophenone, 3-methylacetophenone, 2-methylacetophenone, 4-methylphenylacetone, 3-methylphenylacetone, and 2-methylphenylacetone.

In some embodiments, the organic solvent is an aromatic ether-based solvent. Examples of the organic solvent include, but not limited to, 3-phenoxytoluene, butoxybenzene, 1-(dimethoxymethyl)anisole, tetrahydro-2-phenoxy-2H-pyran, methyl isoeugenol, 1,4-benzodioxan, 1,3-dipropylbenzene, 2,5-dimethoxytoluene, 4-ethylphenetole, 1,3-dipropoxybenzene, 1,2,4-trimethoxybenzene, 1,3-dimethoxybenzene, glycidyl phenyl ether, dibenzyl ether, 4-tert-butylanisole, trans-anethole, 1,2-dimethoxybenzene, 1-methoxynapthalene, diphenyl ether, 2-phenoxymethyl ether, 2-phenoxytetrahydrofuran, and 2-ethoxynaphthalene.

In some embodiments, the organic solvent is an aliphatic ketone-based solvent. Examples of the aliphatic ketone-based solvent include, but not limited to, 2-nonanone, 3-nonanone, 5-nonanone, 2-decanone, 2,5-hexanedione, 2,6,8-trimethyl-4-nonanone, fenchone, phorone, isophorone, and 6-undecanone. In some embodiments, the organic solvent is an aliphatic ether-based solvent. Examples of the aliphatic ether-based solvent include, but not limited to, pentyl ether, hexyl ether, dioctyl ether, ethylene glycol dibutyl ether, diethylene glycol diethyl ether, diethylene glycol butyl methyl ether, diethylene glycol dibutyl ether, triethylene glycol dimethyl ether, triethylene glycol ethyl methyl ether, triethylene glycol butyl methyl ether, tripropylene glycol dimethyl ether, and tetraethylene glycol dimethyl ether.

In some embodiments, the organic solvent is an ester-based solvent. Examples of the organic solvent include, but not limited to, alkyl octanoate, alkyl sebacate, alkyl stearate, alkyl benzoate, alkyl phenylacetate, alkyl cinnamate, alkyl oxalate, alkyl maleate, alkyl lactone, alkyl oleate, and the like. In some embodiments, the organic solvent is selected from at least one of octyl octanoate, diethyl sebacate, diallyl phthalate, and isononyl isononanoate.

In some embodiments, the organic solvent is selected from at least one of methanol, ethanol, 2-methoxyethanol, dichloromethane, chloroform, chlorobenzene, o-dichlorobenzene, tetrahydrofuran, anisole, morpholine, toluene, o-xylene, m-xylene, p-xylene, 1,4-dioxane, acetone, 2-butanone, 1,2-dichloroethane, 3-phenoxytoluene, 1,1,1-trichloroethane, 1,1,2,2-tetrachloroethane, ethyl acetate, butyl acetate, N,N-dimethylformamide, N,N-dimethylacetamide, dimethyl sulfoxide, 1,2,3,4-tetrahydronaphthalene, decahydronaphthalene, and indene.

In some embodiments, the composition further includes, other than the dispersion agent and the dispersion acid, one or more components such as a surfactant, a lubricant, a wetting agent, a hydrophobic agent, an adhesive, or the like, for adjusting viscosity, so as to adjust the viscosity of the composition and improve film forming performance and adhesiveness.

As illustrated in FIG. 4, some embodiments of the present application further provide an organic light-emitting device 100, which includes a first electrode 101, a second electrode 102, and an organic functional layer 103 disposed between the first electrode 101 and the second electrode 102. A material of the organic functional layer 103 includes one or more of the organic compounds as described above; alternatively, the material of the organic functional layer 103 includes the mixture as described above; and alternatively, the material of the organic functional layer 103 includes the composition as described above.

In some embodiments, the first electrode 101 is an anode and the second electrode 102 is a cathode.

In some embodiments, the organic light-emitting device 100 is an organic light-emitting diode, an organic photovoltaic battery, an organic light-emitting battery, an organic field-effect transistor, an organic light-emitting field-effect transistor, an organic laser, an organic spintronic device, an organic sensor, an organic plasmonic emission diode, or the like. In some embodiments, the organic light-emitting device 100 is an organic light-emitting diode, an organic light-emitting battery, or an organic light-emitting field-effect transistor.

In some embodiments, the organic light-emitting device 100 is used in various electronic devices, such as a display panel, an illumination device, a light source, and the like.

In some embodiments, the organic functional layer 103 is a single layer, for example, a mixture layer, and the mixture layer includes a first compound and a second compound. The first compound is selected from one or more of the organic compounds mentioned above, and the second compound is selected from one or more of a hole injection material, a hole transport material, an electron transport material, a hole blocking material, a light-emitting guest material, a light-emitting host material, and an organic dye. Detailed descriptions of various organic functional materials included in the organic functional layer 103 are described in documents WO 2010135519 A1, US 20090134784 A1, and WO 2011110277 A1, the present applications of which are incorporated herein by reference in their entirety.

The light-emitting guest material is selected from one or more of a singlet state of an emitter (such as a fluorescence emitter), a triplet state of an emitter (such as a phosphorescence emitter), and a TADF material.

When the second compound is selected from one or more of the hole injection material, the hole transport material, the electron transport material, the hole blocking material, the light-emitting host material, and the organic dye. A mass ratio of the first compound to the second compound ranges from 1:99 to 30:70, for example, 1:99 to 10:90.

When the second compound is a light-emitting guest material, the mass ratio of the first compound to the second compound ranges from 99:1 to 70:30, for example, 99:1 to 90:10.

In some embodiments, the organic functional layer 103 includes multiple layer, and the organic functional layer 103 includes at least a light-emitting layer. For example, as illustrated in FIG. 4, the organic functional layer 103 includes a hole injection layer 104, a hole transport layer 105, an electron blocking layer 106, a light-emitting layer 107, an electron transport layer 108, and an electron injection layer 109. In some embodiments, the organic functional layer 103 further includes a hole blocking layer disposed between the light-emitting layer 107 and the electron transport layer 108.

In some embodiments, the organic light-emitting device 100 is a blue organic light-emitting device, a green organic light-emitting device, or a red organic light-emitting device. The light-emitting layer 107 includes a host material and a guest material, the guest material is one or more of the organic compounds mentioned above, and the host material includes a fused aromatic derivative or a heteroaromatic compound.

In some embodiments, the organic light-emitting device 100 has an emission wavelength ranging from 300 nm to 1000 nm, for example, 350 nm to 900 nm, or 400 nm to 800 nm. In some embodiments, the organic light-emitting device 100 has an emission wavelength in the wavelength range of blue light.

In some embodiments, the host material includes at least one of a derivative of anthracene, a derivative of pyrene, a derivative of naphthalene, a derivative of pentacene, a compound containing phenanthrene, a compound containing fluoranthene, a derivative of carbazole, a derivative of dibenzofuran, a compound containing a ladder type of furan, and a derivative of pyrimidine. In some embodiments, the host material is a blue light-emitting host material used in a blue organic light-emitting device, and the host material is an organic compound containing anthracene.

In some embodiments, a mass ratio of the host material to the guest material ranges from 99:1 to 70:30, for example, 90:10, 85:15, 80:20, 75:25, or the like. In some embodiments, the mass ratio of the host material to the guest material ranges from 99:1 to 90:10, for example, 97:3, 96:4, 95:5, 93:7, 92:8, or the like. When the guest material is dispersed in the host material, and the mass ratio of the host material to the guest material ranges from 99:1 to 70:30, it is conducive to inhibiting crystallization of the light-emitting layer 107 and suppressing concentration quenching of the guest material caused by high concentration, thereby improving the luminous efficiency of the organic light-emitting device 100.

In some embodiments, the anode is an electrode used for injecting holes, and the holes in the anode can be

injected into the organic functional layer 103. For example, the holes in the anode are injected into the hole injection layer, the hole transport layer, or the light-emitting layer. A material of the anode includes at least one of a conductive metal, a conductive metal oxide, and a conductive polymer. An absolute value of a difference between work function of the anode and highest occupied molecular orbital (HOMO) energy level or valence band energy level of a p-type semiconductor material of the hole injection layer, the hole transport layer, or the electron blocking layer is less than 0.5 eV, for example, less than 0.3 eV or less than 0.2 eV. Examples of the material of the anode include, but not limited to, aluminum (Al), copper (Cu), aurum (Au), argentum (Ag), magnesium (Mg), ferrum (Fe), cobalt (Co), nickel (Ni), manganese (Mn), palladium (Pd), platinum (Pt), indium tin oxide (ITO), aluminum doped with zinc oxide (AZO), and the like. Other suitable materials of the anode are known in the art, and can be easily selected for use by ordinary skilled in the art. The material of the anode can be deposited using any suitable technology, such as a physical vapor deposition method including RF magnetron sputtering, vacuum thermal evaporation, electron beam (e-beam), or the like. In some embodiments, the anode is a patterned structure, such as a patterned ITO conductive substrate that can be commercially available and used to prepare the organic light-emitting device 100 as described above.

In some embodiments, the cathode is an electrode used for injecting electrons, and the electrons in the cathode can be easily injected into the organic functional layer 103. For example, the electrons in the cathode are easily injected into the electron injection layer, the electron transport layer, or the light-emitting layer. A material of the cathode may include at least one of a conductive metal and a conductive metal oxide. An absolute value of a difference between work function of the cathode and lower unoccupied molecular orbital (LUMO) energy level or valence band energy level of a n-type semiconductor material of the electron injection layer, the electron transport layer, or the hole blocking layer is less than 0.5 eV, for example, less than 0.3 eV, or less than 0.2 eV. All materials that can be used in the cathode of an organic electronic device can be used as the material of the cathode in the organic light-emitting device of the present application. Examples of the material of the cathode include, but not limited to, Al, Au, Ag, calcium (Ca), barium (Ba), Mg, LiF/Al, Mg-Ag alloy, $BaF_2$/Al, Cu, Fe, Co, Ni, Mn, Pd, Pt, ITO, and the like. The material of the cathode can be deposited using any suitable technology, such as a suitable physical vapor deposition method including RF magnetron sputtering, vacuum thermal evaporation, electron beam (e-beam), or the like.

In some embodiments, the hole injection layer 104 is used for promoting the injection of holes from the anode into the light-emitting layer 107. The hole injection layer 104 includes a hole injection material for receiving holes injected from a positive electrode at low voltages. HOMO energy level of the hole injection material is between work function of the material of the anode and HOMO energy level of a functional material of film layers at a side of the hole injection layer away from the anode (such as the hole transport material of the hole transport layer). Examples of the hole injection material include, but not limited to, metalloporphyrin, oligothiophene, an organic material based on arylamine, an organic material based on hexacyano hexaazabenzophenanthrene, an organic material based on quinacridone, an organic material based on perylene, anthraquinone, a conductive polymer based on polyaniline, and a conductive polymer based on polythiophene.

In some embodiments, the hole transport layer 105 is used for transmitting holes to the light-emitting layer 107. The hole transport layer 105 includes a hole transport material for receiving holes transmitted from the anode or the hole injection layer and transmitting the holes to the light-emitting layer. The hole transport material is a material having high hole mobility known in the art. Examples of the hole transport material include, but not limited to, an organic material based on aromatic amine, a conductive polymer, a block copolymer with both conjugated and non-conjugated portions.

In some embodiments, the electron transport layer 108 is used for transmitting electrons. The electron transport layer 108 includes an electron transport material for receiving electrons injected from a negative electrode and transmitting the electrons to the light-emitting layer 107. Examples of the electron injection material include, but not limited to, an Al-based complex of 8-hydroxyquinoline, a complex containing $Alq_3$, an organic radical compound, a hydroxyflavone metal complex, 8-hydroxyquinoline lithium (LiQ), and a compound based on benzimidazole.

In some embodiments, the electron injection layer 109 is used for injecting electrons. The electron injection layer 109 includes an electron injection material having ability to transmit electrons, so as to achieve an effect of injecting electrons from a negative electrode and an excellent effect of injecting electrons into the light-emitting layer 107 or the light-emitting material, and prevent excitons generated by the light-emitting layer 107 from transferring to the hole injection layer. Moreover, the electron injection material has ability to form a thin film. Examples of the electron injection material include, but not limited to, LiQ, fluorenone, anthraquinone dimethyl, diphenoquinone, thian dioxide, azole, diazole, triazole, imidazole, perylene tetracarboxylic acid, fluorenyl methane, anthrone and derivatives thereof, a metal complex, and a 5-membered ring derivative containing nitrogen.

In some embodiments, the hole blocking layer is used to block holes from reaching the negative electrode, and is generally formed under the same condition as the hole injection layer 104. The hole blocking layer includes a hole blocking material. Examples of the hole blocking material include, but not limited to, a derivative of diazole, a derivative of triazole, a derivative of phenanthroline, bromocresol purple sodium salt (BCP), and an aluminum complex.

In some embodiments, the organic light-emitting device 100 further includes a substrate 110. The first electrode 101, the hole injection layer 104, the hole transport layer 105, the electron blocking layer 106, the light-emitting layer 107, the electron transport layer 108, the electron injection layer 109, and the second electrode 102 are sequentially stacked on

the substrate 110.

The substrate 100 is a transparent substrate or an opaque substrate. When the substrate 110 is a transparent substrate, a transparent light-emitting device can be prepared. Moreover, the substrate 110 is a rigid substrate or a flexible substrate with elasticity. A material of the substrate 110 includes, but not limited to, plastics, a polymer, a metal, a semiconductor wafer, glass, or the like. In some embodiments, the substrate 110 includes at least one smooth surface for forming the anode. For example, the substrate 110 is a substrate without surface defects. In some embodiments, the material of the substrate 110 include, but not limited to, a polymer film or plastics, such as polyethylene terephthalate (PET) or polyethylene naphthyl-2,6-dicarboxylate (PEN). A glass transition temperature Tg of the material of the substrate 110 is greater than or equal to 150 °C, for example, greater than or equal to 200 °C, greater than or equal to 250 °C, or greater than or equal to 300 °C.

In some embodiments, the organic light-emitting device 100 is a solution type organic light-emitting device, that is, at least one of the organic functional layers is prepared by a printing process (such as inkjet printing).

In some embodiments, the mixture layer or the light-emitting layer is prepared from the composition by a printing process or a coating process. The printing process or the coating process includes, but not limited to, inkjet printing, nozzle printing, letterpress printing, silk-screen printing, dip coating, spin-coating, scraper coating, roller printing, twist roller printing, lithographic printing, flexographic printing, rotary printing, spray coating, brush coating, transfer printing, or slit extrusion coating. In some embodiments, the printing process or the coating process is selected from intaglio printing, nozzle printing, or inkjet printing.

Based on the above, the organic compounds provided in examples 1-35 contain boron and biphenyl, by introducing at least one of dibenzofuran, dibenzothiophene, carbazole, benzo five-membered ring, triphenylene, and naphthalene into the organic compound containing boron and biphenyl, the overall molecular conjugation of the organic compound is increased, and the luminous efficiency and service life of the organic light-emitting device using the organic compound can be improved. Moreover, the introduction of at least one of tetrahydronaphthalene and indene into the organic compound containing boron and biphenyl can improve the solubility of molecules in processes such as inkjet printing, facilitating the purification of the organic compound in the preparation process, improving the purity of the organic compound, and further improving the luminous efficiency and service life of the organic light-emitting device using the organic compound.

HOMO energy level, LUMO energy level, first excited triplet state (T1) energy level, and first excited singlet state (S1) energy level of each of organic compounds provided in examples 1-35 and comparative compound 1 (hereafter referred to as "organic compound Refl") provided in comparative example 1 (hereafter referred to as "example Refl") were tested, obtaining the properties of these organic compounds.

The structure of the organic compound Refl is as follows:

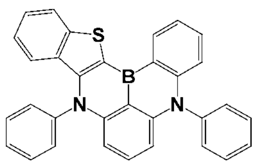

Ref1 .

The HOMO energy level, the LUMO energy level, the T1 energy level, and S1 energy level of each of the organic compounds provided in examples 1-35 and comparative compound 1 provided in comparative Example 1 were tested through quantum calculations. Specifically, Gaussian 09W (Gaussian Inc.) was used by time-dependent density functional theory (TD-DFT), specific simulation methods can refer to application WO201141110, which is incorporated herein by reference in its entirety. First, a semi-empirical method "Ground State/Semi-empirical/Default Spin/AM1" (Charge0/-Spin Singlet) was used to optimize molecular geometry, and then energy structures of organic molecules were calculated by the TD-DFT method to obtain "TD-SCF/DFT/Default Spin/B3PW91" and the base group "6-31G (d)" (Charge0/Spin Singlet). HOMO and LUMO energy levels were calculated according to the following calibration equations, and S1 and T1 energy levels were used directly.

$$\text{HOMO (eV)} - (\text{HOMO (G)} \times 27.212)\ -0.9899)/1.1206;$$

$$\text{LUMO (eV)} - (\text{LUMO (G)} \times 27.212)\ -2.0041)/1.385.$$

In the above equations, HOMO, LUMO, T1, and S1 energy levels were the calculation results of Gaussian 09W, in Hartree, and the results were shown in the following Table 1.

Table 1

| Example | Compound | HOMO (eV) | LUMO (eV) | T1 (eV) | S1 (eV) |
|---|---|---|---|---|---|
| 1 | M1 | -5.01 | -2.33 | 2.35 | 3.03 |
| 2 | M12 | -5.03 | -2.21 | 2.38 | 2.96 |
| 3 | M15 | -5.01 | -2.27 | 2.38 | 2.98 |
| 4 | M16 | -4.95 | -2.35 | 2.39 | 3.01 |
| 5 | M60 | -4.91 | -2.31 | 2.43 | 3.04 |
| 6 | M64 | -4.86 | -2.28 | 2.41 | 2.98 |
| 7 | M68 | -4.93 | -2.21 | 2.36 | 2.93 |
| 8 | M72 | -5.01 | -2.23 | 2.39 | 2.97 |
| 9 | M89 | -4.98 | -2.34 | 2.43 | 2.97 |
| 10 | M90 | -4.88 | -2.31 | 2.42 | 3.03 |
| 11 | M99 | -5.01 | -2.36 | 2.41 | 3.01 |
| 12 | M116 | -4.95 | -2.28 | 2.39 | 3.08 |
| 13 | M120 | -4.97 | -2.29 | 2.41 | 2.98 |
| 14 | M145 | -5.03 | -2.31 | 2.42 | 3.03 |
| 15 | M148 | -5.01 | -2.28 | 2.43 | 3.07 |
| 16 | M149 | -5.03 | -2.29 | 2.45 | 2.98 |
| 17 | M150 | -5.05 | -2.37 | 2.42 | 3.05 |
| 18 | M151 | -5.01 | -2.26 | 2.39 | 3.01 |
| 19 | M152 | -5.03 | -2.29 | 2.38 | 3.01 |
| 20 | M153 | -5.03 | -2.27 | 2.39 | 3.03 |
| 21 | M154 | -5.02 | -2.29 | 2.39 | 3.01 |
| 22 | M155 | -5.03 | -2.38 | 2.38 | 3.03 |
| 23 | M156 | -5.08 | -2.26 | 2.35 | 3.01 |
| 24 | M157 | -5.06 | -2.27 | 2.38 | 2.95 |
| 25 | M158 | -5.04 | -2.34 | 2.36 | 3.01 |
| 26 | M159 | -5.06 | -2.27 | 2.38 | 3.09 |
| 27 | M160 | -5.07 | -2.28 | 2.41 | 2.92 |
| 28 | M161 | -5.09 | -2.31 | 2.41 | 3.01 |
| 29 | M162 | -5.11 | -2.31 | 2.35 | 2.96 |
| 30 | M163 | -5.13 | -2.35 | 2.43 | 3.04 |
| 31 | M164 | -5.05 | -2.30 | 2.42 | 3.01 |
| 32 | M165 | -5.01 | -2.41 | 2.36 | 3.03 |
| 33 | M166 | -5.03 | -2.44 | 2.37 | 3.05 |
| 34 | M167 | -5.06 | -2.39 | 2.41 | 3.07 |
| 35 | M168 | -5.03 | -2.38 | 2.41 | 3.06 |
| Refl | Refl | -5.10 | -2.35 | 2.33 | 2.91 |

As can be seen from Table 1, the T1 energy levels and the S1 energy levels of the organic compounds provided in examples 1-35 of the present application are higher than the T1 energy level and the S1 energy level of the organic compound Refl provided in example Refl, indicating that blue light emitted by blue organic light-emitting devices using the

organic compounds provided in examples 1-35 can tend to dark blue, which is beneficial for the blue organic light-emitting devices using the organic compounds provided in examples 1-35 as guest materials of light-emitting layers to obtain better color coordinates.

Referring to FIG. 5, some embodiments of the present application provide a method for preparing an organic light-emitting device 200 as illustrated in FIG. 5, as shown in the following embodiment 1.

Embodiment 1

In the organic light-emitting device 200 provided in embodiment 1, ITO (indium tin oxide) was used as a material of an anode 202, poly(3,4-ethylenedioxythiophene) (PEDOT, Clevios ™ AI4083) was used as a material of a hole injection layer 203, poly(N-vinylcarbazole) (PVK, average molecular mass of 25000 to 50000) was used as a material of a hole transport layer 204, BH-1 to BH-3 were respectively used as a host material of a light-emitting layer 205 of the organic light-emitting device, the organic compounds in examples 1-35 and the organic compound Refl in example Refl were respectively used as a guest material of the light-emitting layer 205 of the organic light-emitting device, ET and Liq (8-hydroxyquinoline lithium) were used as materials of an electron transport layer 206, and Al was used as a material of a cathode 207. The method for preparing the organic light-emitting device includes the following steps.

Step a, cleaning an ITO conductive glass: cleaning the ITO conductive glass with one or more of chloroform, acetone, and isopropyl alcohol, and then treating by a UV ozone process. The conductive glass includes a substrate 201 and the anode 202 disposed on the substrate 201.

Step b, forming the hole injection layer 203: applying PEDOT on the anode 202 by a spin-coating method, and treating on a hot plate at 180 °C for 10 minutes to obtain the hole injection layer 203 with a thickness of 40 nm.

Step c, forming the hole transport layer 204: applying a PVK solution with a concentration of 5 mg/mL using toluene as solvent by a spin-coating method, and treating on a hot plate at 180 °C for 60 minutes to obtain the hole transport layer 204 with a thickness of 20 nm.

Step d: forming the light-emitting layer 205: in a nitrogen glove box, applying the light-emitting material on the hole transport layer 204 by a spin-coating method, and then treating on a hot plate at 140 °C for 10 minutes obtain the light-emitting layer 205 with a thickness of 40 nm. The host material of the light-emitting layer 205 of the organic light-emitting device 200 was BH-1, BH-2, or BH-3, and the guest material of the light-emitting layer 205 of the organic light-emitting device 200 was selected from the organic compounds provided in examples 1-35. The solvent for dissolving the light-emitting material was methyl benzoate. A mass ratio of the host material to the guest material was 95:5. The concentration of the light-emitting material in the solution including methyl benzoate is 15 mg/mL.

Step e, forming the electron transport layer 206: applying ET and Liq on the light-emitting layer 205 in different evaporation units of vacuum chamber, and co-depositing at a mass ratio of 50 to 50 in high vacuum ($1\times10^{-6}$ millibar), to obtain the electron transport layer 206 with a thickness of 20 nm.

Step f, forming the cathode 207: depositing Al on the electron transport layer 206 to obtain the cathode 207 with a thickness of 100 nm.

Step g, encapsulating the device prepared above in a nitrogen glove box using UV cured resin.

Organic light-emitting devices 1-39 (hereafter referred to as devices 1-39) provided in the following examples 36-74 and comparative devices 1-3 (hereafter referred to as devices Ref1-Ref3) provided in the following comparative examples 2-4 (hereafter referred to as examples Ref2-Ref4) were prepared by using the above-mentioned method. Guest materials used in the organic light-emitting devices 1-35 were the organic compounds provided in the above examples 1-35, respectively, and host materials used in the organic light-emitting devices 1-35 were BH-1. Guest materials used in the organic light-emitting devices 36 and 38 were the organic compound M16 provided in the above example 4, and host materials used in the organic light-emitting devices 36 and 38 were BH-2 and BH-3, respectively. Guest materials used in the organic light-emitting devices 37 and 39 were the organic compound M64 provided in the above example 6, and host materials used in the organic light-emitting devices 37 and 39 were BH-2 and BH-3, respectively. Guest materials used in the devices Ref1-Ref3 were the organic compound Refl provided in the above example Refl, and host materials used in the devices Refl-Ref3 were BH-1, BH-2, and BH-3, respectively.

The structures of BH-1, BH-2, BH-3, ET, and Liq are as follows:

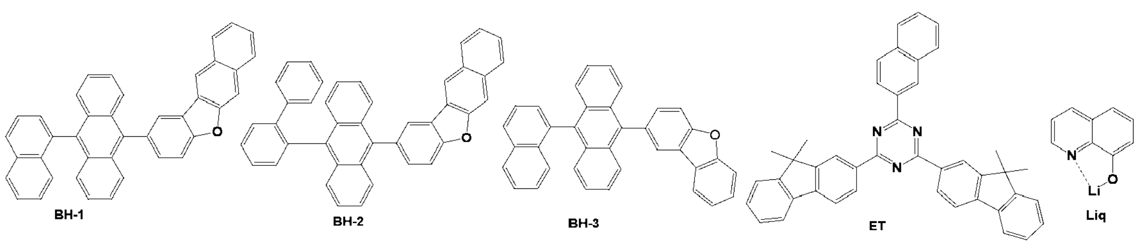

BH-1 BH-2 BH-3 ET Liq

In the present application, current voltage (J-V) characteristics of the devices 1-39 provided in examples 36-74 and the devices Ref1-Ref3 provided in examples Ref2-Ref4 were obtained. Moreover, the CIE color coordinate (x, y), the driving voltage at luminance of 1 knits (voltage @ 1 knits [V]), a luminous efficiency obtained at the current density of 10 $mA/cm^2$ (CE @ 1 knits [cd/A]), and a time taken for the brightness to decrease from the initial brightness of 1 knits to 90% of the initial brightness (LT90 @ 1 knits [h]) of each of the devices 1-39 and Refl-Ref3 were obtained, as shown in the following Table 2.

Table 2

| Example | Device | Guest material | Host material | CIE (x, y) | Voltage @1knits (V) | CE@ 1knits (cd/A) | LT90@ 1knits (h) |
|---|---|---|---|---|---|---|---|
| 36 | 1 | M1 | BH-1 | 0.141,0.081 | 5.5 | 6.4 | 176 |
| 37 | 2 3 | M12 | BH-1 | 0.143,0.083 | 5.5 | 6.4 | 171 |
| 38 | | M15 | BH-1 | 0.141,0.083 | 5.5 | 6.3 | 174 |
| 39 | 4 | M16 | BH-1 | 0.141,0.083 | 5.5 | 6.1 | 171 |
| 40 | 5 | M60 | BH-1 | 0.143,0.081 | 5.5 | 5.9 | 161 |
| 41 | | M64 | BH-1 | 0.142,0.085 | 5.5 | 5.8 | 159 |
| 42 | 6 7 | M68 | BH-1 | 0.142,0.087 | 5.5 | 5.7 | 156 |
| 43 | 8 | M72 | BH-1 | 0.143,0.087 | 5.5 | 5.7 | 158 |
| 44 | 9 | M89 | BH-1 | 0.141,0.087 | 5.5 | 5.6 | 159 |
| 45 | 10 | M90 | BH-1 | 0.142,0.081 | 5.7 | 5.8 | 161 |
| 46 | 11 | M99 | BH-1 | 0.141,0.081 | 5.5 | 5.9 | 159 |
| 47 | 12 | M116 | BH-1 | 0.143,0.083 | 5.5 | 5.9 | 158 |
| 48 | 13 | M120 | BH-1 | 0.141,0.084 | 5.5 | 5.8 | 156 |
| 49 | 14 | M145 | BH-1 | 0.143,0.084 | 5.7 | 5.7 | 153 |
| 50 | 15 | M148 | BH-1 | 0.141,0.083 | 5.5 | 5.7 | 153 |
| 51 | 16 | M149 | BH-1 | 0.143,0.081 | 5.5 | 5.9 | 152 |
| 52 | 17 | M150 | BH-1 | 0.142,0.081 | 5.6 | 5.8 | 149 |
| 53 | 18 | M151 | BH-1 | 0.142,0.081 | 5.5 | 6.2 | 171 |
| 54 | 19 | M152 | BH-1 | 0.142,0.083 | 5.5 | 6.4 | 176 |
| 55 | 20 | M153 | BH-1 | 0.142,0.081 | 5.5 | 6.5 | 171 |
| 56 | 21 | M154 | BH-1 | 0.142,0.083 | 5.5 | 6.3 | 174 |
| 57 | 22 | M155 | BH-1 | 0.142,0.083 | 5.5 | 6.1 | 171 |
| 58 | 23 | M156 | BH-1 | 0.142,0.083 | 5.5 | 6.3 | 174 |
| 59 | 24 | M157 | BH-1 | 0.142,0.083 | 5.5 | 6.3 | 171 |
| 60 | 25 | M158 | BH-1 | 0.142,0.083 | 5.5 | 6.4 | 171 |
| 61 | 26 | M159 | BH-1 | 0.142,0.083 | 5.5 | 6.3 | 171 |
| 62 | 27 | M160 | BH-1 | 0.142,0.083 | 5.5 | 6.4 | 172 |
| 63 | 28 | M161 | BH-1 | 0.142,0.083 | 5.5 | 6.3 | 172 |
| 64 | 29 | M162 | BH-1 | 0.142,0.083 | 5.5 | 6.4 | 175 |
| 65 | 30 | M163 | BH-1 | 0.142,0.081 | 5.5 | 6.3 | 173 |
| 66 | 31 | M164 | BH-1 | 0.142,0.083 | 5.5 | 6.4 | 171 |
| 67 | 32 | M165 | BH-1 | 0.142,0.081 | 5.5 | 6.2 | 171 |
| 68 | 33 | M166 | BH-1 | 0.142,0.081 | 5.5 | 6.2 | 171 |
| 69 | 34 | M167 | BH-1 | 0.142,0.081 | 5.5 | 6.4 | 173 |

(continued)

| Example | Device | Guest material | Host material | CIE (x, y) | Voltage @1knits (V) | CE@ 1knits (cd/A) | LT90@ 1knits (h) |
|---|---|---|---|---|---|---|---|
| 70 | 35 | M168 | BH-1 | 0.142,0.081 | 5.5 | 6.5 | 173 |
| 71 | 36 | M16 | BH-2 | 0.143,0.119 | 5.5 | 5.6 | 145 |
| 72 | 37 | M64 | BH-2 | 0.141,0.121 | 5.5 | 5.7 | 133 |
| 73 | 38 | M16 | BH-3 | 0.141,0.121 | 5.6 | 5.6 | 137 |
| 74 | 39 | M64 | BH-3 | 0.141,0.123 | 5.6 | 5.7 | 133 |
| Ref2 | Refl | Refl | BH-1 | 0.152,0.135 | 6.0 | 2.9 | 97 |
| Ref3 | Ref2 | Refl | BH-2 | 0.154,0138 | 5.8 | 2.5 | 85 |
| Ref4 | Ref3 | Refl | BH-3 | 0.157,0167 | 6.0 | 2.6 | 87 |

As can be seen from Table 2, compared to the devices Ref1-Ref3 provided in examples Ref2-Ref4, the devices 1-39 provided in examples 36-74 that used the organic compounds provided in examples 1-35 as the guest materials of the light-emitting layers, have better color coordinates. Moreover, the luminous efficiency of the devices 1-39 provided in examples 36-74 are all in the range of 5.7 cd/A to 6.6 cd/A, which are higher than the luminous efficiency of the devices Ref1-Ref3 provided in examples Ref2-Ref4. Furthermore, compared to the time taken for the brightness to decrease from the initial brightness of 1 knits to 90% of the initial brightness of the devices Refl-Ref3, the time taken for the brightness to decrease from the initial brightness of 1 knits to 90% of the initial brightness of the devices 1-39 are all in the range of 133 hours to 176 hours, and the increase range is 50% to 100%, indicating that the service life of the devices 1-39 provided in examples 36-74 is improved.

Moreover, compared to the organic compound Refl provided in example Refl, the organic compounds provided in the above examples 1-35 have better overall molecular solubility by introducing biphenyl, an aromatic ring, and at least one of a silanyl group and a deuterated phenyl group), facilitating the purification of the organic compounds in the preparation process, improving the purity of the organic compounds, and improving the luminous efficiency and service life of the devices 1-39 using the organic compounds provided in the above examples 1-35.

Furthermore, the luminous efficiency of the devices 1-4 and 151-168 is in the range of 6.1 cd/A to 6.5 cd/A, and the service life of the devices 1-4 and 151-168 is about 170 hours. This is because the guest materials used in the devices 1-4 and 151-168 contain the triphenylene group, which makes the overall molecular conjugation larger. In addition, the improvement of the luminous efficiency and service life of the organic compounds containing aromatic amine including the combination of benzothiophene and triphenylene group is better than the improvement of the luminous efficiency and service life of the organic compounds containing aromatic amine including of the combination of benzothiophene and dibenzothiophene/furan. Moreover, the number of solubilizing groups in these guest materials is larger, which improves the solubility of the guest materials, and further improves the luminous efficiency and service life of the organic light-emitting devices using these guest materials.

By providing the organic compound containing boron and nitrogen, and introducing biphenyl, aromatic amine containing benzothiophene, and a silanyl group that makes the overall conjugation of the organic compound greater into the organic compound containing boron and nitrogen, properties of the organic compound used as the light-emitting material can be improved, luminous efficiency of the organic light-emitting device using the organic compound can be improved, and service life of the organic light-emitting device can be prolonged.

Some embodiments of the present application further provide a display panel including the organic light-emitting device as described in any one of the above-mentioned embodiments.

The display panel further includes an array substrate disposed on a side of the organic light-emitting device, and an encapsulation layer disposed on a side of the organic light-emitting device away from the array substrate and covering the organic light-emitting device. The display panel further includes a polarizer layer disposed on a side of the encapsulation layer away from the organic light-emitting device and a cover layer disposed on a side of the polarizer layer away from the organic light-emitting device. In some embodiments, the polarizer layer is replaced by a color filter layer, and the color filter layer includes a plurality of color resistors and a black matrix disposed between every adjacent two color resistors.

In the display panel provided in the embodiments of the present application, by using the organic light-emitting device including the organic compound containing boron and nitrogen and the silanyl group, the silanyl group makes the overall conjugation of the organic compound greater, and therefore the conjugation effect of the organic compound can be enhanced. Therefore, when the organic compound is used as the light-emitting material of the organic light-emitting device, the properties of the light-emitting material can be improved, the luminous efficiency of the display panel can be

improved, and the service life of the display panel can be prolonged.

In the above-described embodiments, the description of each embodiment has its own emphasis, and for parts not described in detail in one embodiment, please refer to relevant description of other embodiments.

The above provides a detailed description to the organic compound, the mixture, the composition, the organic light-emitting device, and the display panel provided in the embodiments of the present application. Specific embodiments are applied in this context to explain the principles and implementation methods of the present application. The explanation of the above-mentioned embodiments is only used to help understand the technical solutions and core ideas of the present application. For ordinary skilled in the art, there may be changes in the specific implementation methods and application scopes based on the ideas of the present application. Therefore, the contents of the present application should not be understood as limitations on the present application.

## Claims

1. An organic compound, **characterized in that** the organic compound has a structure represented by the following formula (1) or (2):

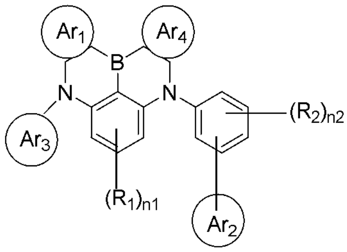
(1),
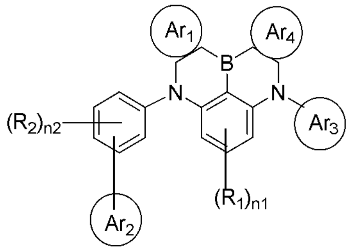
(2);

wherein $Ar_1$ and $Ar_2$ are independently selected from a substituted or unsubstituted aryl group having 6-60 carbon atoms, or a substituted or unsubstituted heteroaryl group having 5-60 carbon atoms;
$Ar_3$ and $Ar_4$ are independently selected from an aryl group having 6-60 carbon atoms;
$R_1$ and $R_2$ are independently selected from -H, -D, a $C_{1-20}$ linear alkyl group, a linear silanyl group having 1-20 carbon atoms, a branched silanyl group having 1-20 carbon atoms, a linear alkoxyl group having 1-20 carbon atoms, a linear thioalkoxyl group having 1-20 carbon atoms, a $C_{3-20}$ branched alkyl group, a $C_{3-20}$ cyclic alkyl group, a branched alkoxyl group having 3-20 carbon atoms, a cyclic alkoxyl group having 3-20 carbon atoms, a branched thioalkoxyl group having 3-20 carbon atoms, a cyclic thioalkoxyl group having 3-20 carbon atoms, a ketone group having 1-20 carbon atoms, an alkoxycarbonyl group having 2-20 carbon atoms, an aryloxycarbonyl group having 7-20 carbon atoms, an alkenyl group having 2-20 carbon atoms, a cyanoyl group, a carbamoyl group, a haloformyl group, a formyl group, an isocyanoyl group, an isocyanate group, a thiocyanate group, an isothiocyanate group, a hydroxyl group, a nitro group, $-CF_3$, -Cl, -Br, -F, a substituted or unsubstituted aromatic group having 6-30 ring atoms, a substituted or unsubstituted heteroaromatic group having 5-30 ring atoms, a substituted or unsubstituted aryloxy group having 6-30 ring atoms, or a substituted or unsubstituted heteroaryloxy group having 5-30 ring atoms;
at least one of $Ar_1$, $Ar_2$, $Ar_3$, $Ar_4$, $R_1$, and $R_2$ contains a linear silanyl group having 1-20 carbon atoms, a branched silanyl group having 1-20 carbon atoms, or a deuterated phenyl group;
n1 is independently selected from 0, 1, 2, or 3; and
n2 is independently selected from 0, 1, 2, 3, or 4.

2. The organic compound of claim 1, **characterized in that** $Ar_1$ is a group represented by any one of the following formulae (X-1) to (X-4):

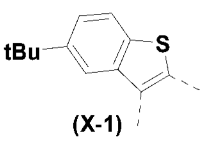
(X-1)
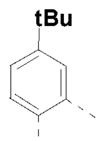
(X-2)
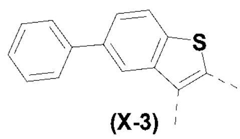
(X-3)
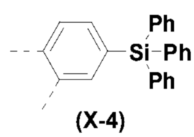
(X-4)
;

$Ar_2$ is a group represented by any one of the following formulae (A-1) to (A-4):

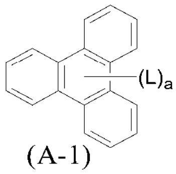
(A-1)
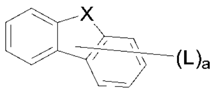
(A-2)
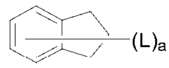
(A-3)
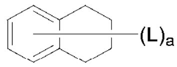
(A-4)
;

and

$Ar_3$ and $Ar_4$ are independently a group represented by any one of the following formulae (B-1) to (B-5):

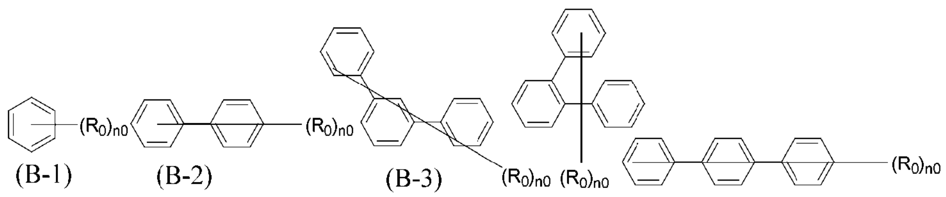
(B-1) (B-2) (B-3) (B-4) (B-5)
;

wherein a linking site of $Ar_2$ is a carbon atom of a of $Ar_2$, a linking site of $Ar_3$ is a carbon atom of a ring of $Ar_3$, and a fused site of $Ar_4$ is two adjacent carbon atoms of a ring of $Ar_4$;

X is selected from O, S, N-$CH_3$, N-Ph, or $C(CH_3)_2$;

$R_0$ and L independently have the same definitions as those for $R_1$ and $R_2$;

n0 is any integer from 0 to 14;

a is any integer from 0 to 12; and

--- in the formulae (X-1) to (X-4) refers to a bond to connect with the formula (1) or (2).

3. The organic compound of claim 2, **characterized in that** $Ar_1$ is the group represented by the formula (X-2), and $Ar_4$ is the group represented by any one of the formulae (B-2) to (B-5).

4. The organic compound of claim 2, **characterized in that** $Ar_2$ is the group represented by any one of the following formulae:

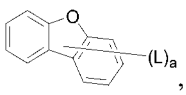
,
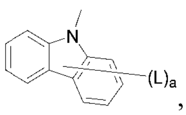
, and
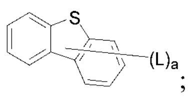
;

wherein L and a in the formulae independently have the same definitions as those for L and a in the formulae (A-1) to (A-4).

5. The organic compound of claim 2, **characterized in that** n1 is greater than or equal to 2, and adjacent two $R_1$ groups and ring atoms connected thereto form a ring or do not form a ring together;

n2 is greater than or equal to 2, and adjacent two $R_2$ groups and ring atoms connected thereto form a ring or do not form a ring together; and

a is greater than or equal to 2, and adjacent two L groups and atoms connected thereto form or do not form a ring with each other.

6. The organic compound of claim 1, **characterized in that** the organic compound has the structure represented by any one of the following formulae (2-1) to (2-31):

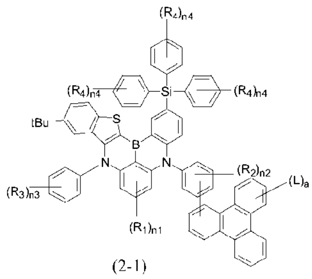
(2-1)

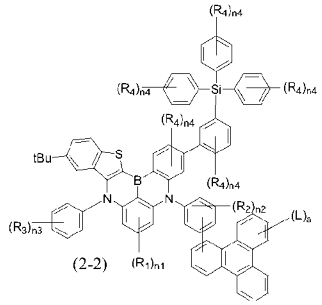
(2-2)

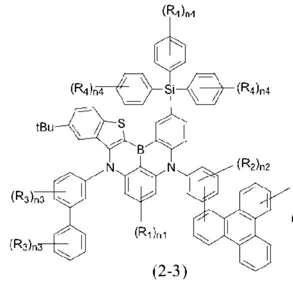
(2-3)

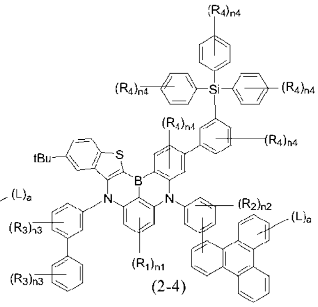
(2-4)

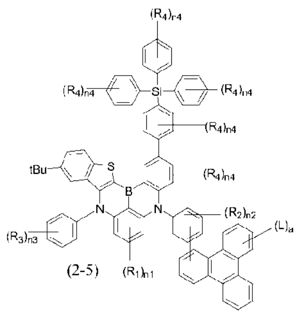
(2-5)

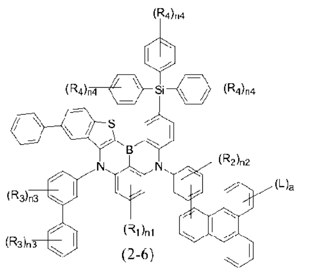
(2-6)

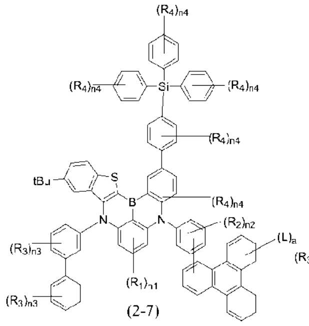
(2-7)

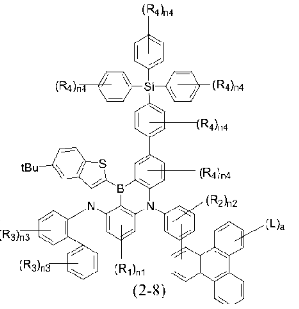
(2-8)

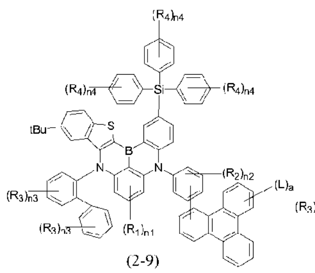
(2-9)

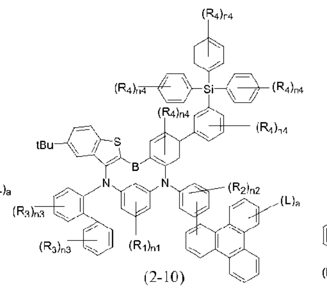
(2-10)

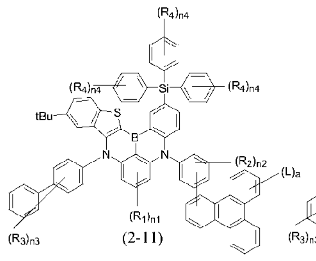
(2-11)

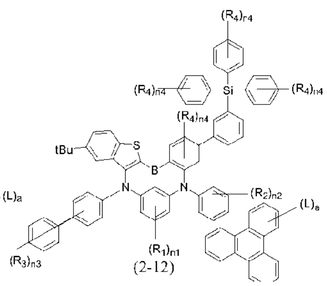
(2-12)

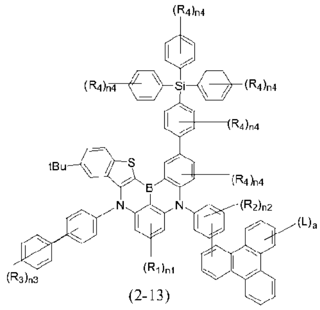
(2-13)

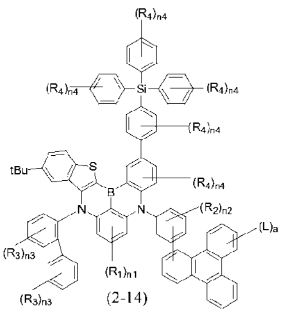
(2-14)

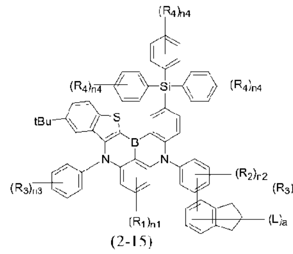
(2-15)

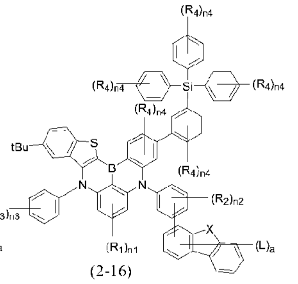
(2-16)

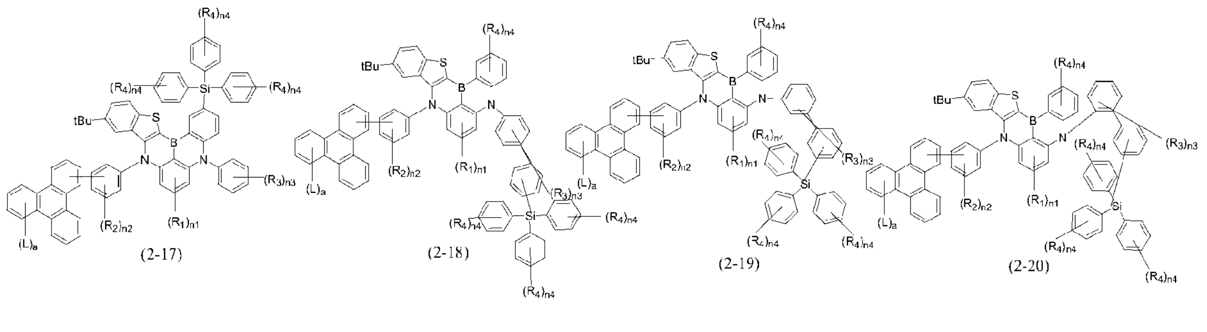
(2-17) (2-18) (2-19) (2-20)

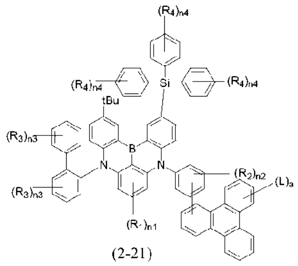

(2-21)

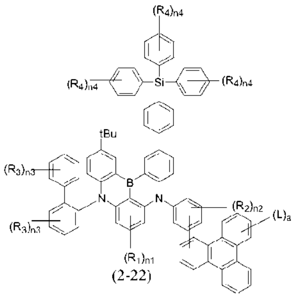

(2-22)

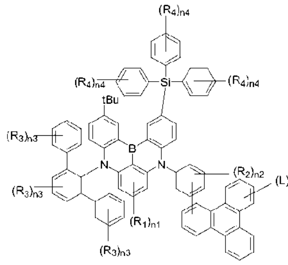

(2-23)

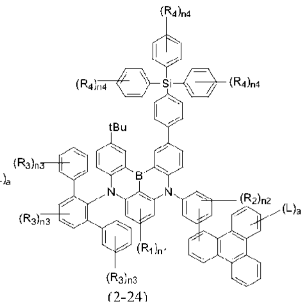

(2-24)

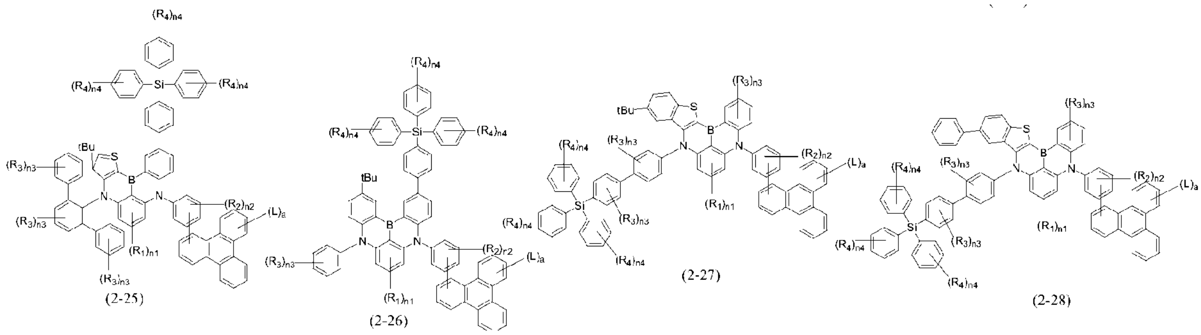

(2-25) (2-26) (2-27) (2-28)

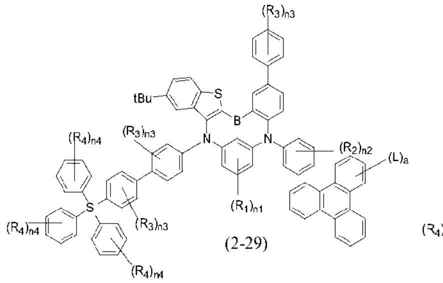

(2-29)

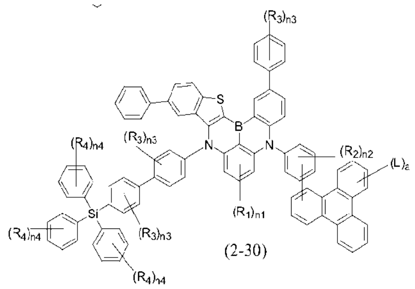

(2-30)

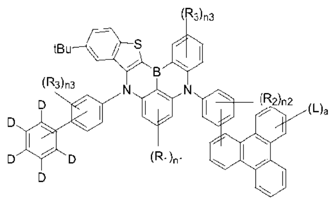

(2-31)

;

wherein $R_1$, $R_2$, $R_3$, $R_4$, and L in the formulae (2-1) to (2-31) independently have the same definitions as those for $R_1$ and $R_2$ in the formula (1) and formula (2);
a is any integer from 0 to 12;
n0 is any integer from 0 to 14;
n1 and n2 in the formulae (2-1) to (2-31) independently have the same definitions as those for n1 and n2 in the formula (1) and formula (2);
n3 is greater than or equal to 0 and less than or equal to 5, wherein adjacent two $R_3$ groups and ring atoms connected thereto form a ring or do not form a ring together in response to n3 being greater than or equal to 2; and
n4 is greater than or equal to 0 and less than or equal to 5, wherein adjacent two $R_4$ groups and ring atoms connected thereto form a ring or do not form a ring together in response to n4 being greater than or equal to 2.

**7.** The organic compound of claim 6, **characterized in that** $R_1$, $R_2$, $R_3$, $R_4$, and L are independently selected from -H, -D, a $C_{1-10}$ linear alkyl group, a $C_{3-10}$ branched alkyl group, or a $C_{3-10}$ cyclic alkyl group.

**8.** The organic compound of claim 6, **characterized in that** $R_1$, $R_2$, $R_3$, $R_4$, and L are independently selected from -H, -D, a $C_{1-4}$ linear alkyl group or a $C_{3-5}$ branched alkyl group.

**9.** The organic compound of claim 1, **characterized in that** the organic compound is a blue light-emitting material.

**10.** The organic compound of claim 1, **characterized in that** the organic compound is selected from any one of a group consisting of the following compounds 1 to 168:

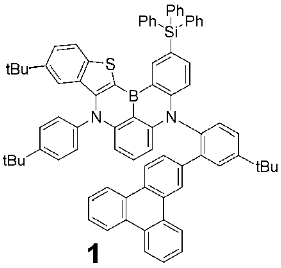
1

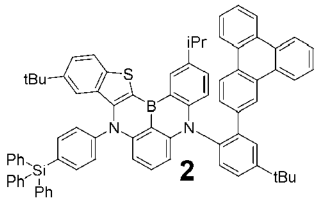
2

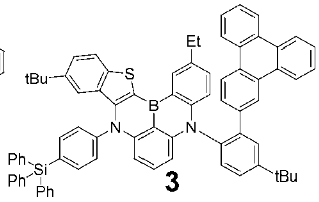
3

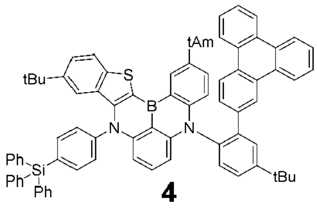
4

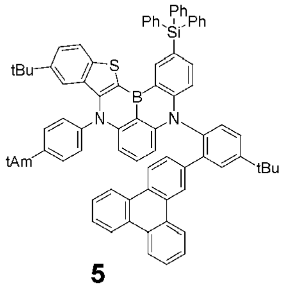
5

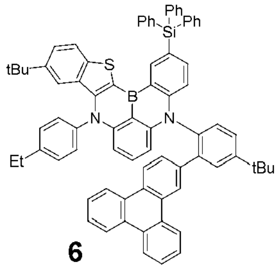
6

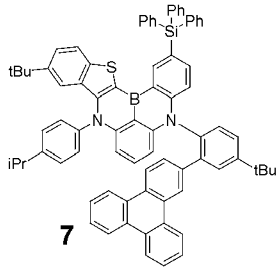
7

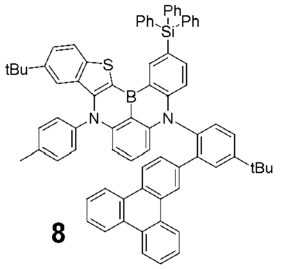
8

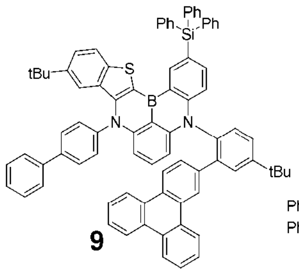
9

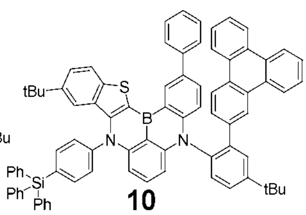
10

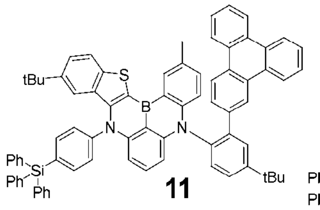
11

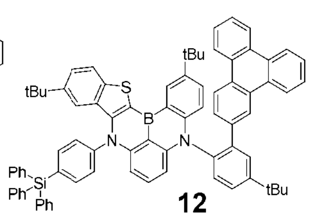
12

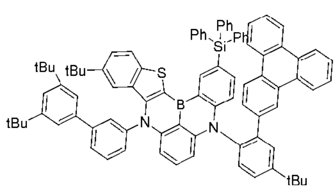
13

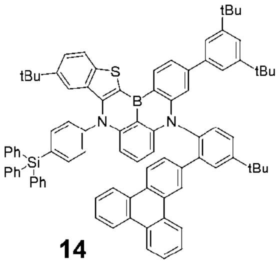
14

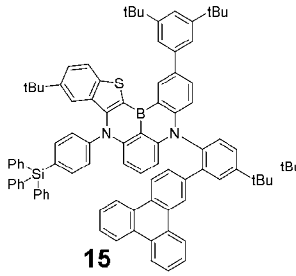
15

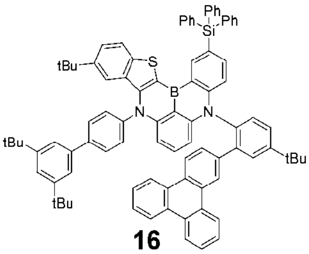
16

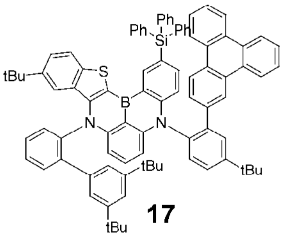
17

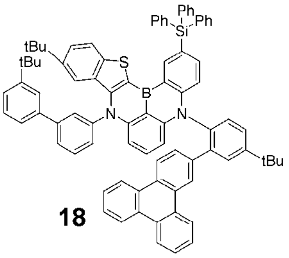
18

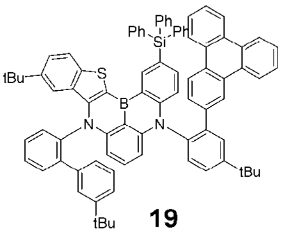
19

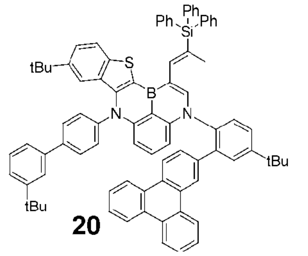
20

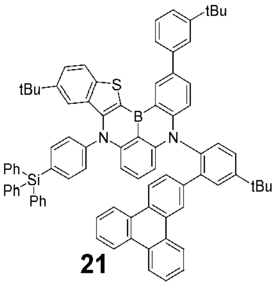
21

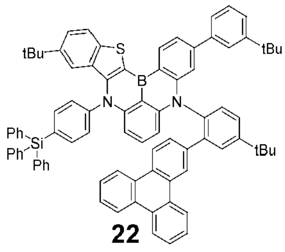
22

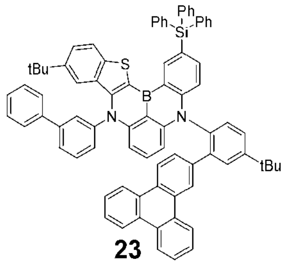
23

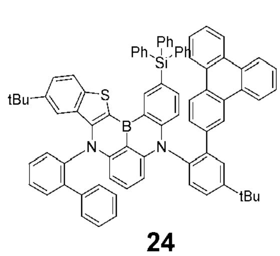
24

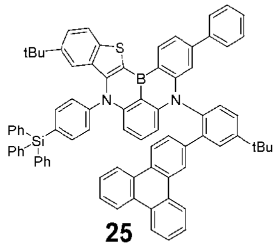
25

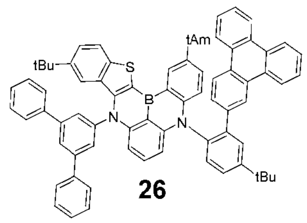
26

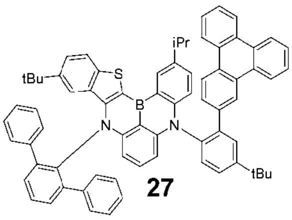
27

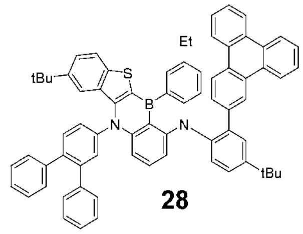
28

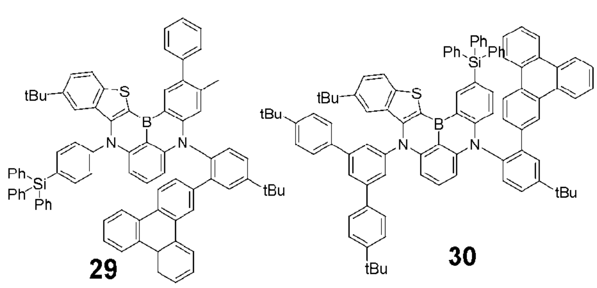
29

30

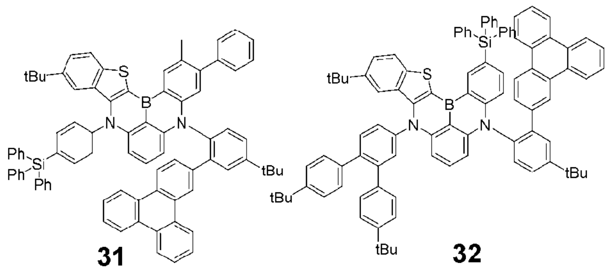
31

32

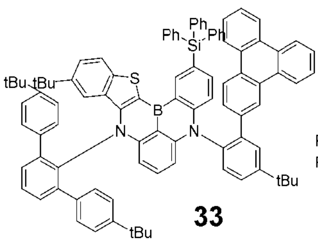
33

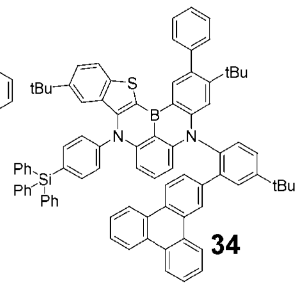
34

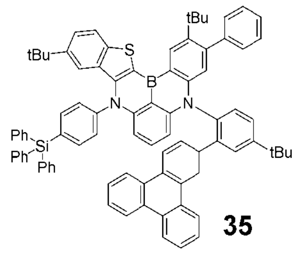
35

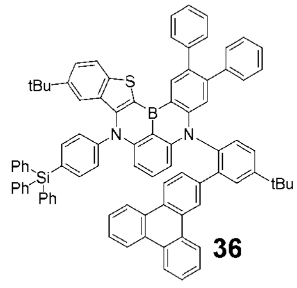
36

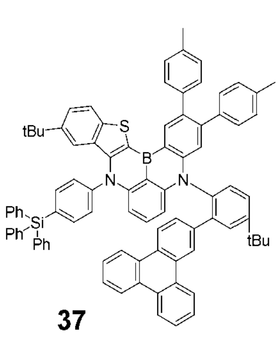
37

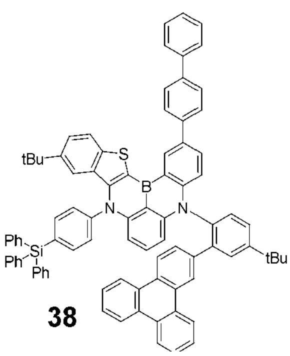
38

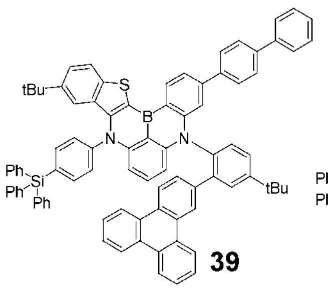
39

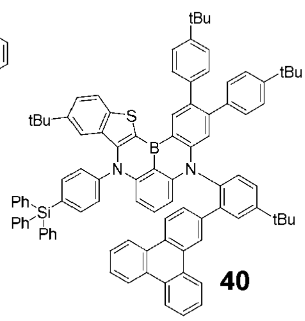
40

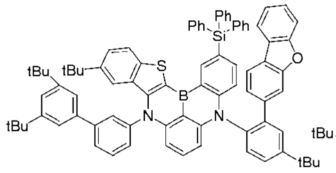
41

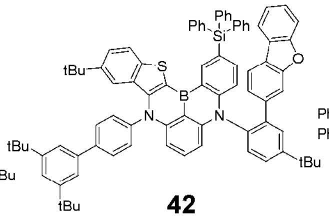
42

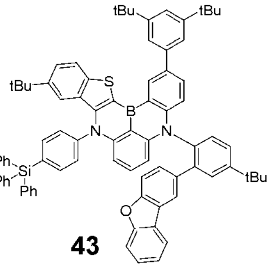
43

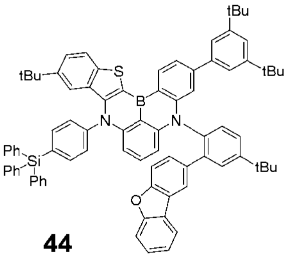
44

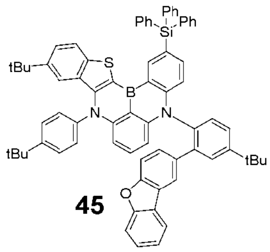
45

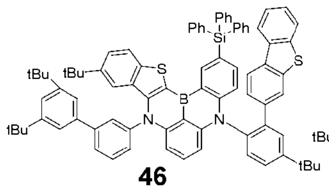
46

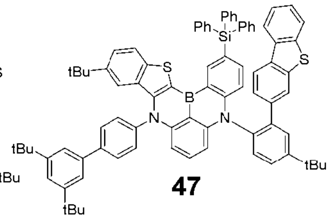
47

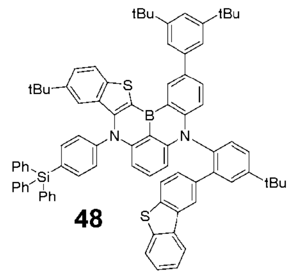
48

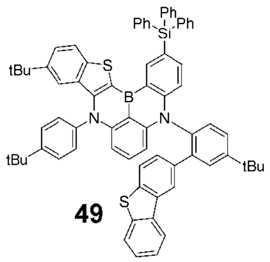
49

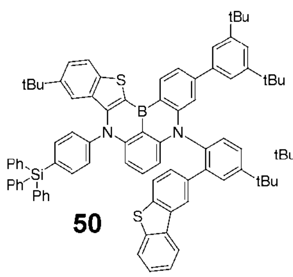
50

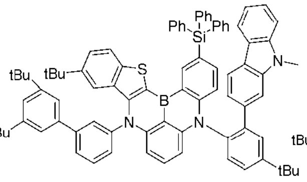
51

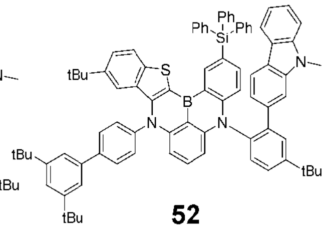
52

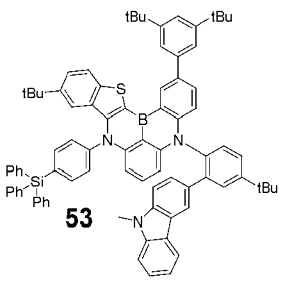
53

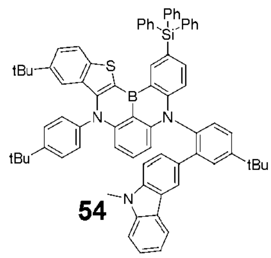
54

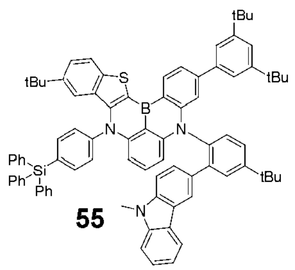
55

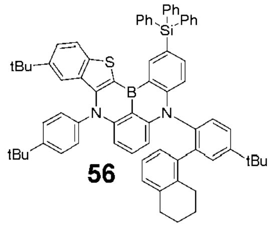
56

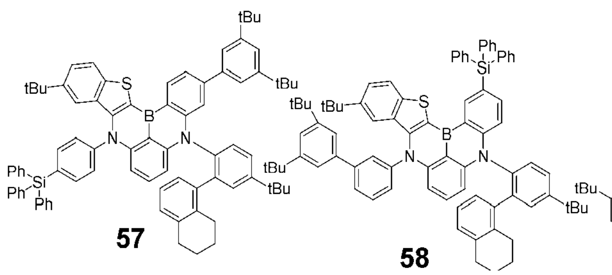
57

58

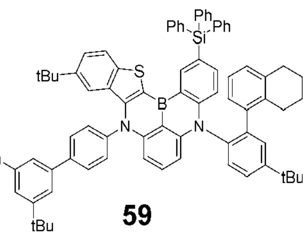
59

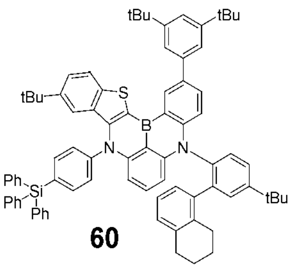
60

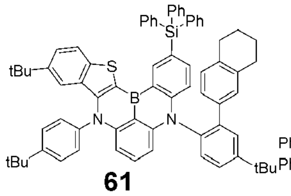
61

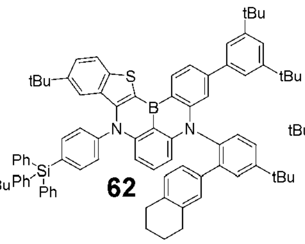
62

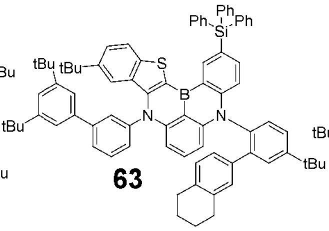
63

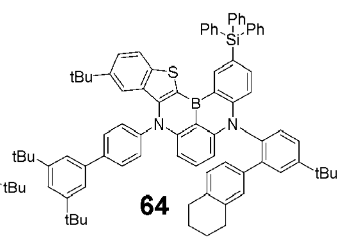
64

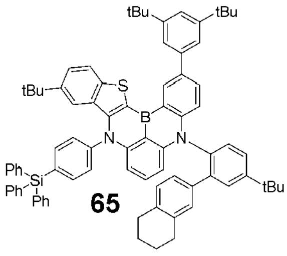
65

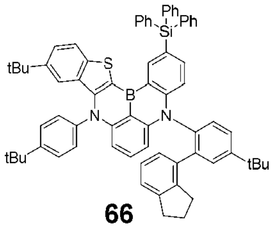
66

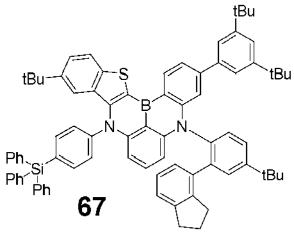
67

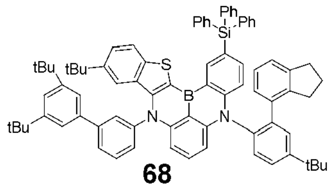
68

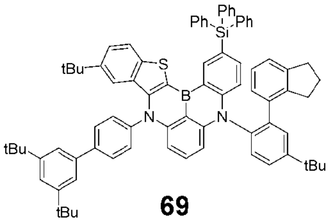
69

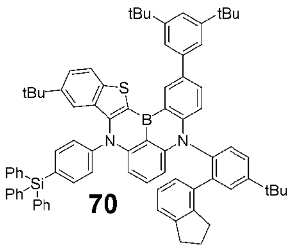
70

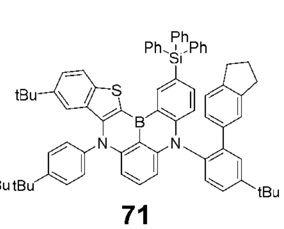
71

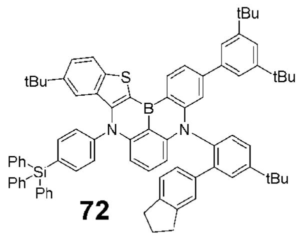
72

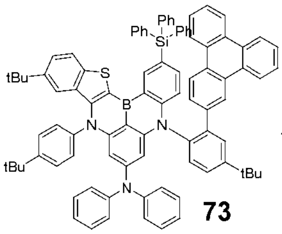
73

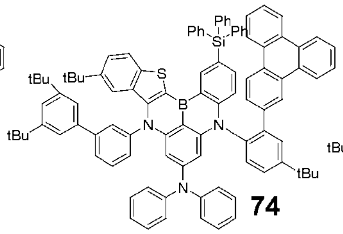
74

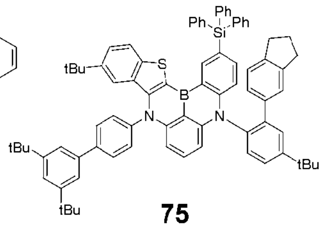
75

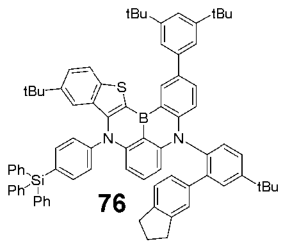
76

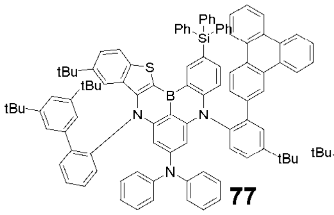
77

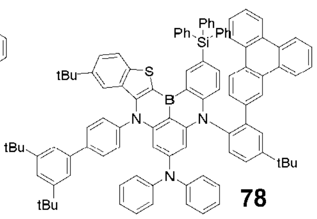
78

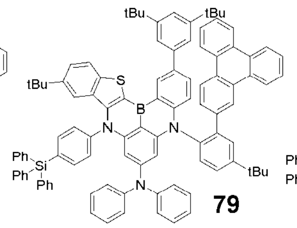
79

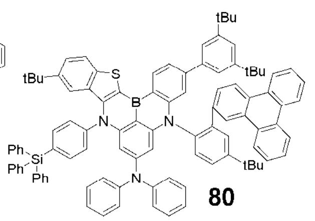
80

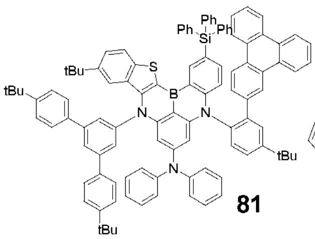
81

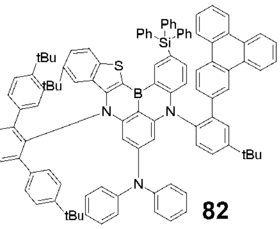
82

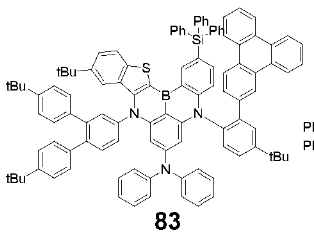
83

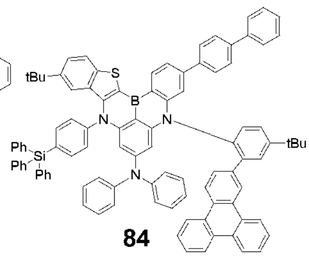
84

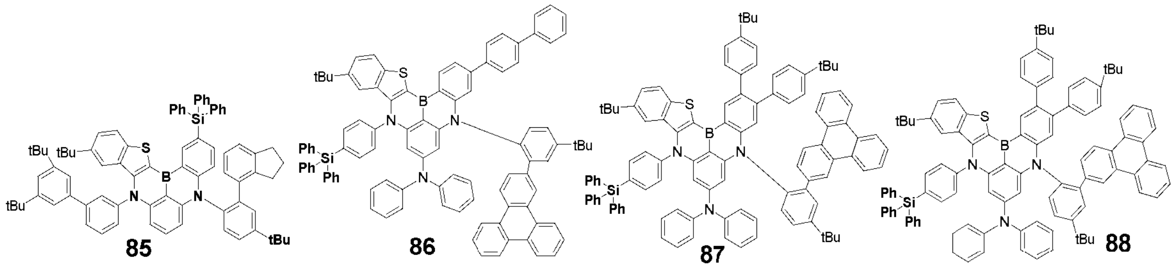

85 86 87 88

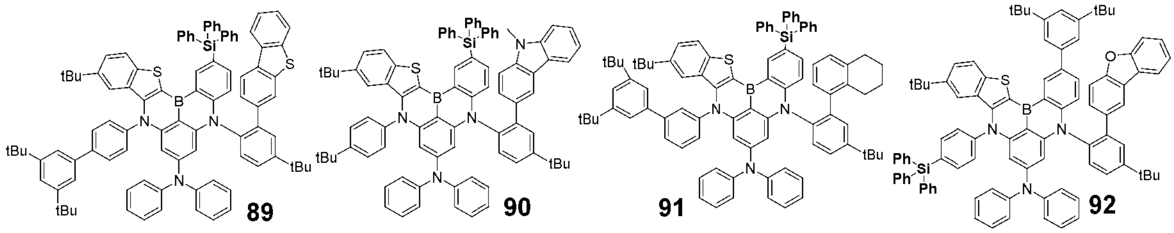

89 90 91 92

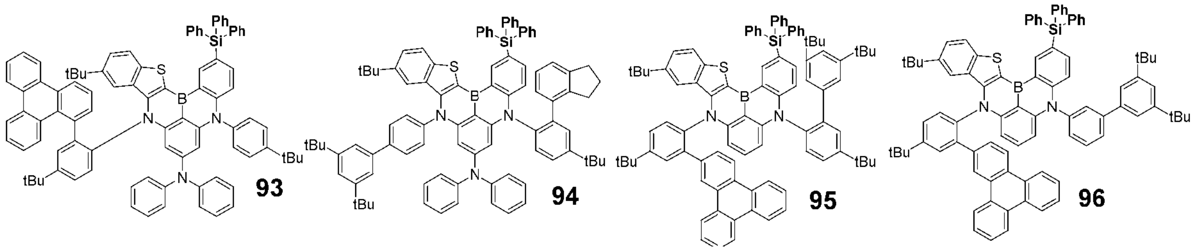

93 94 95 96

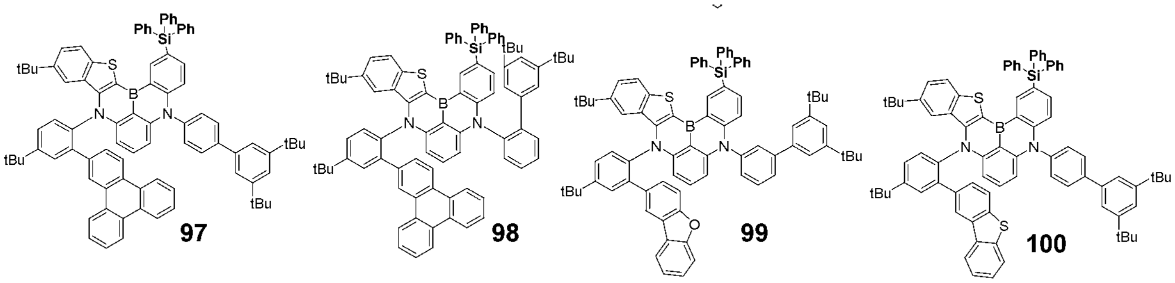

97 98 99 100

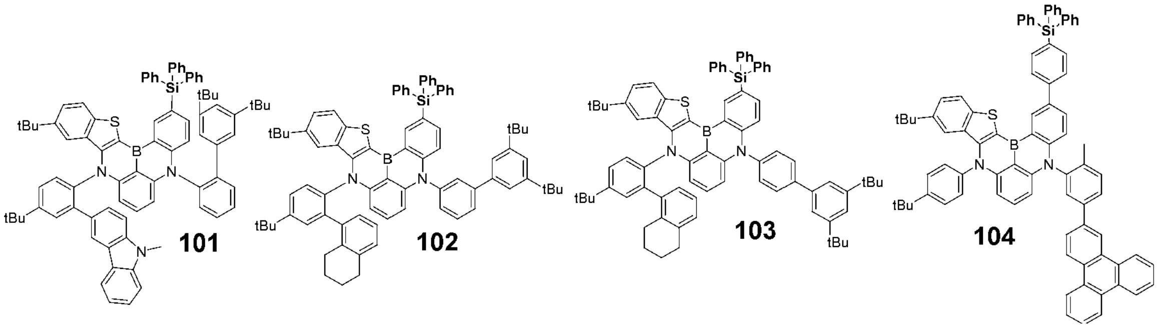

101 102 103 104

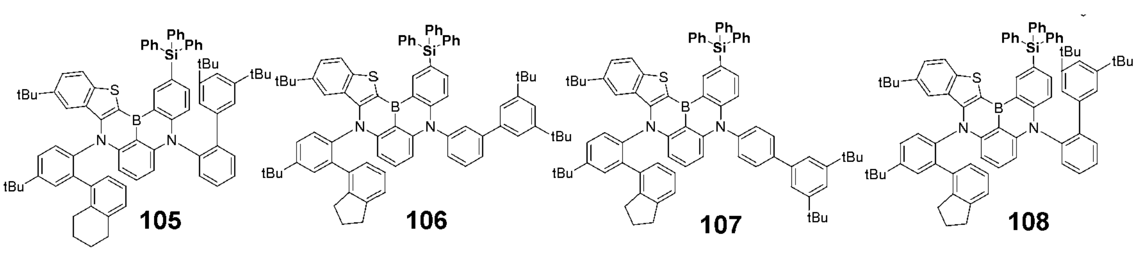

105 106 107 108

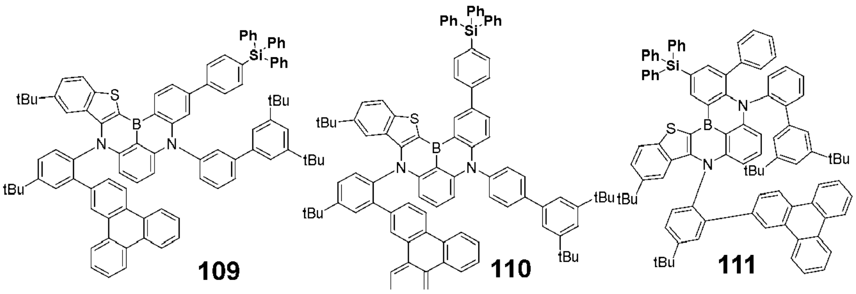

109 110 111

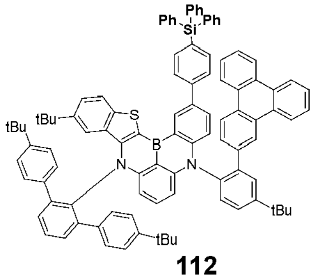

112

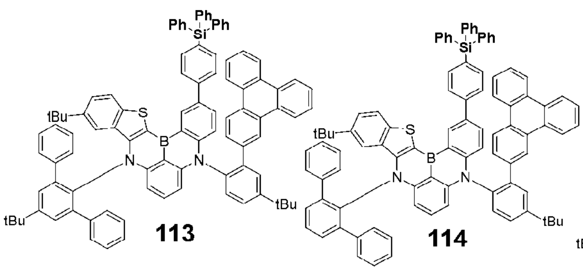

113 114

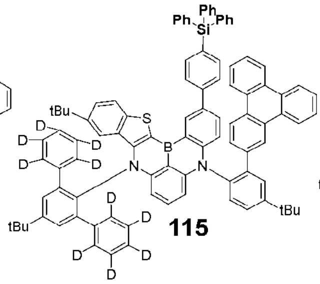

115

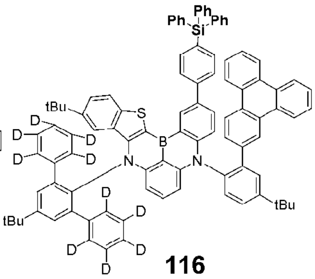

116

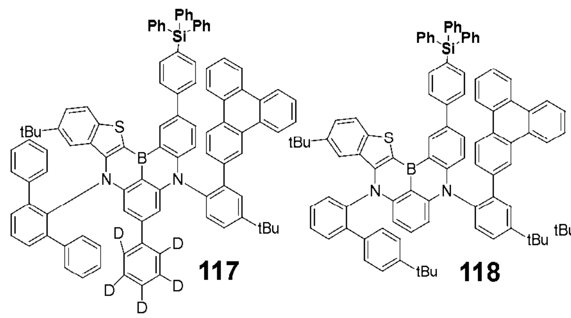

117 118

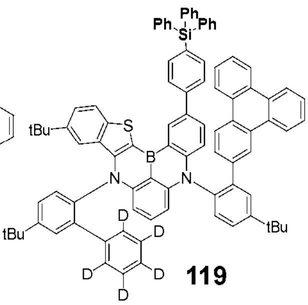

119

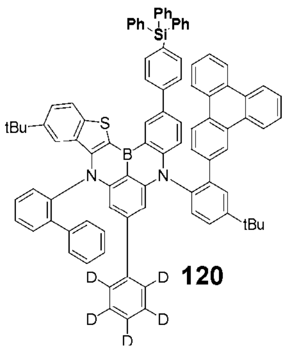

120

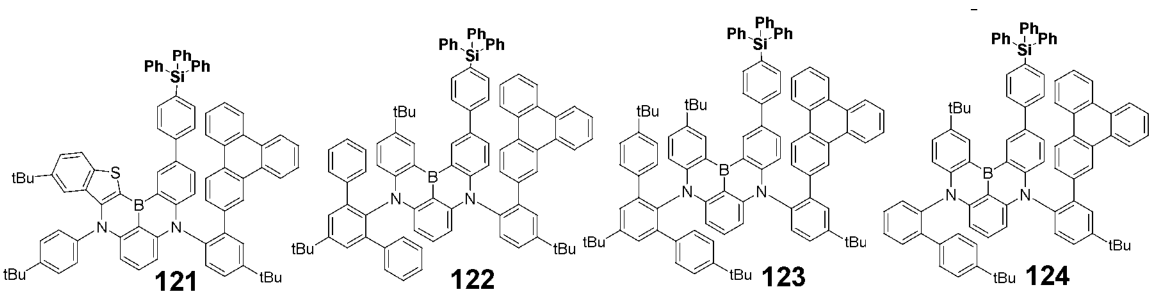

121 122 123 124

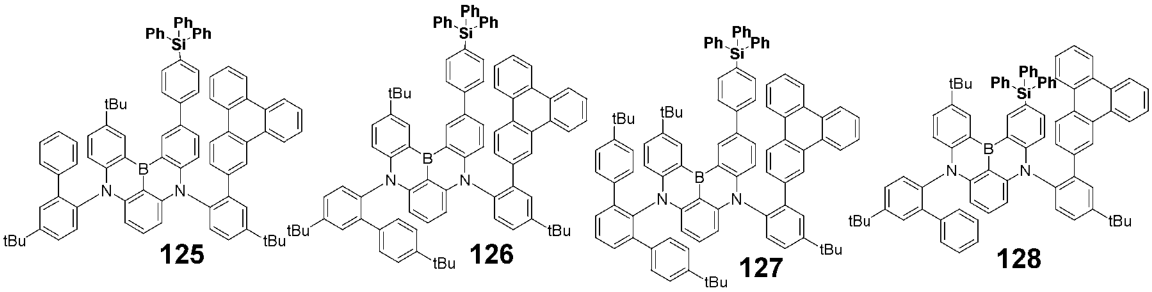

125 126 127 128

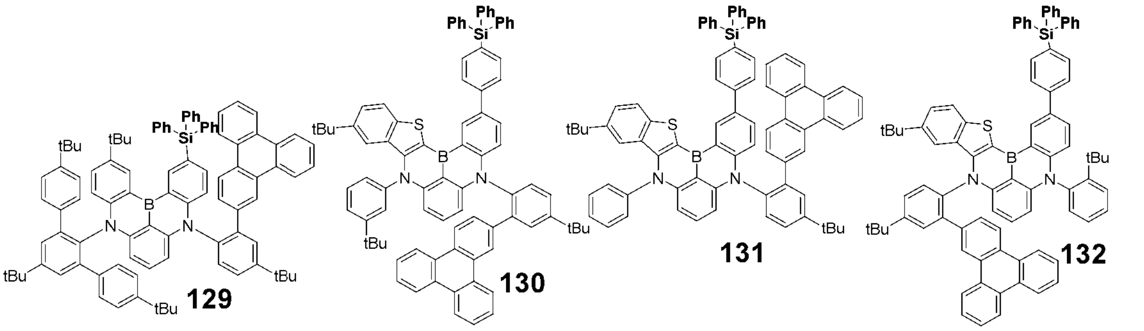

129 130 131 132

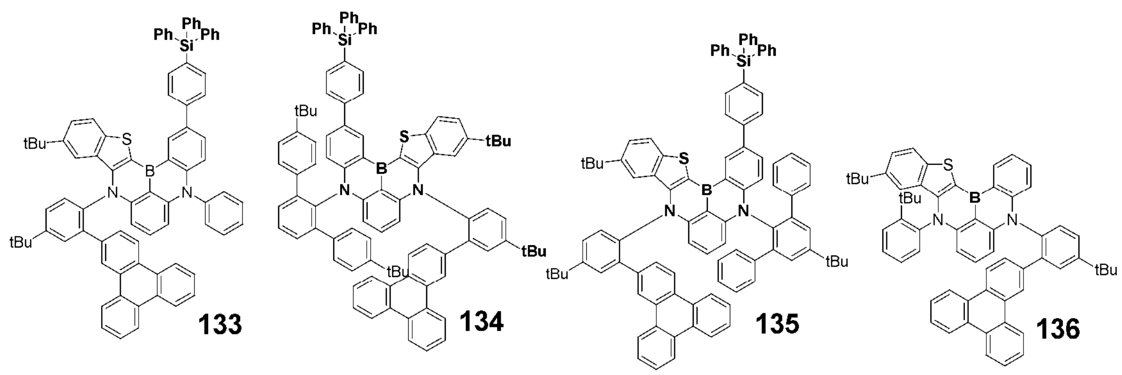

133 134 135 136

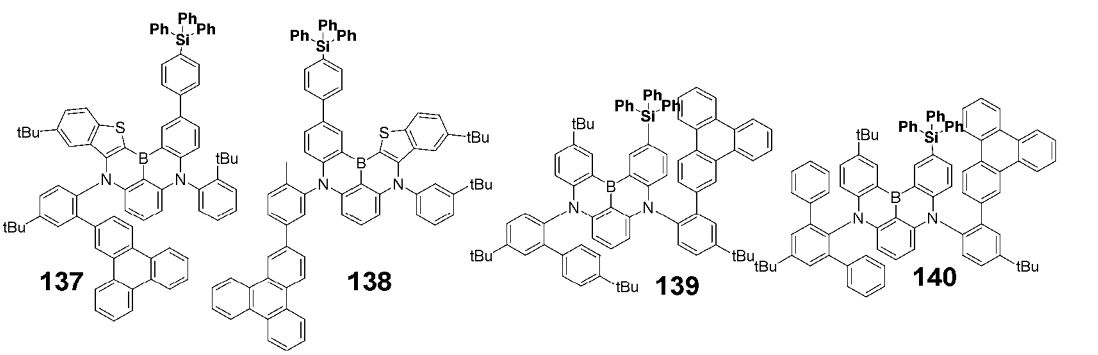

137 138 139 140

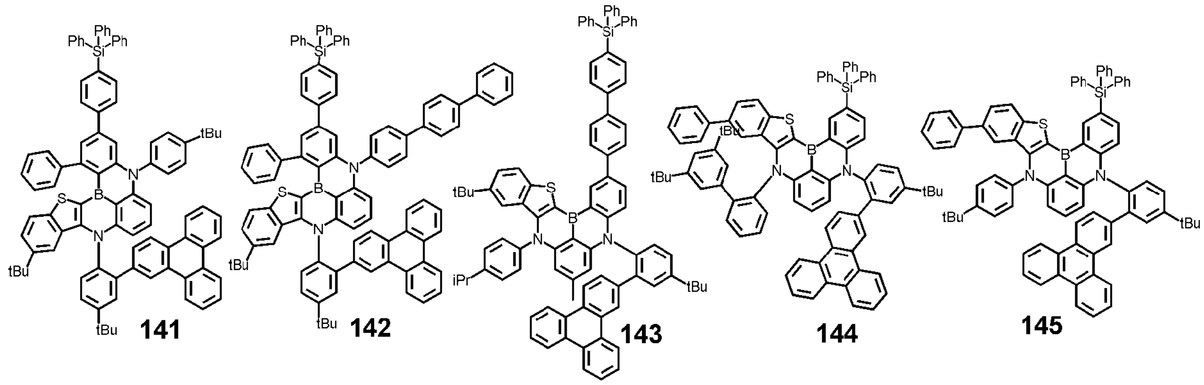

141 142 143 144 145

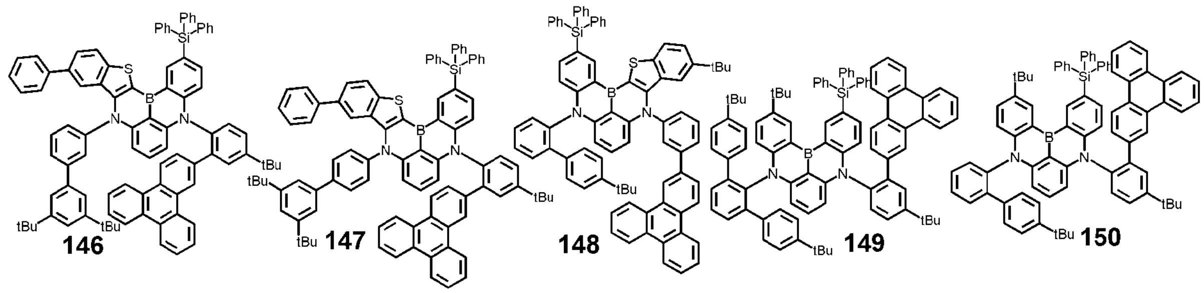

146 147 148 149 150

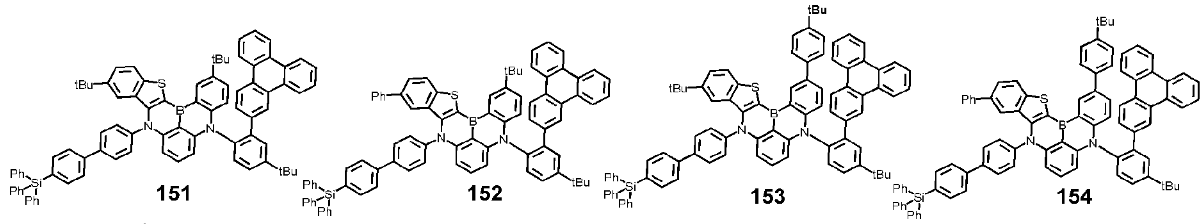

151 152 153 154

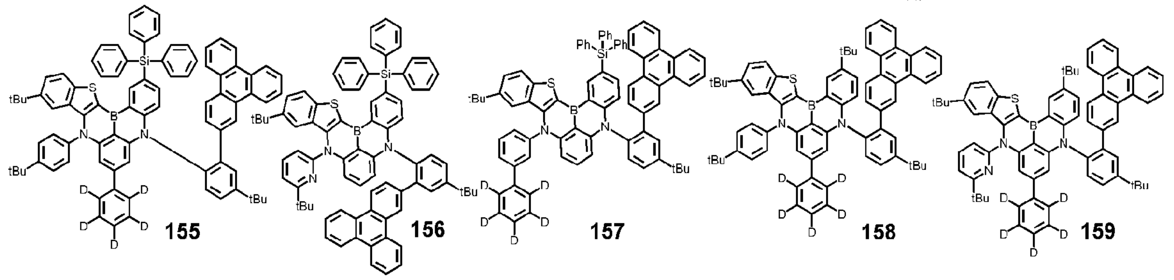

155 156 157 158 159

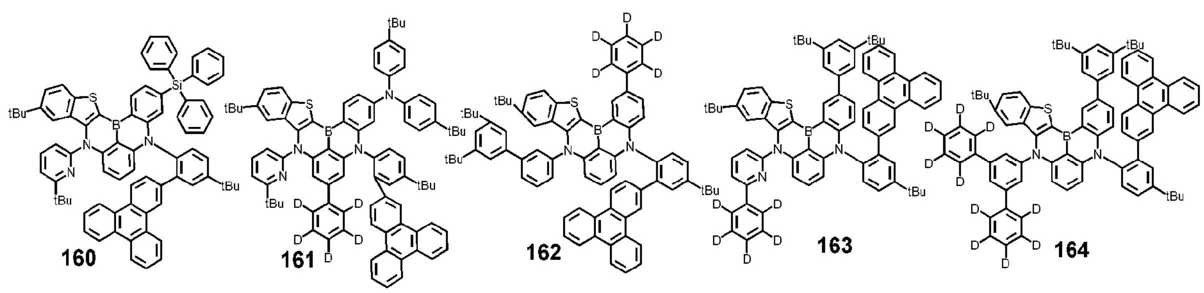

160 161 162 163 164

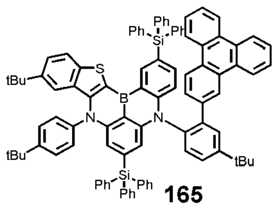
165

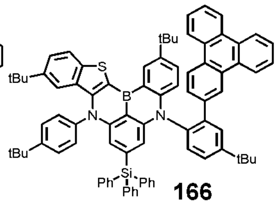
166

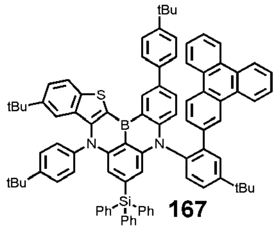
167

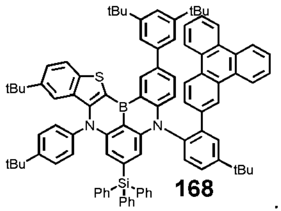
168

.

**11.** A mixture, **characterized in that** the mixture comprises the organic compound as claimed in any one of claims 1 to 10 and at least one organic functional material, and the organic functional material is selected from a group consisting of a hole injection material, a hole transport material, an electron transport material, an electron injection material, an electron blocking material, a hole blocking material, a light-emitting material, a host material, and an organic dye.

**12.** A composition, **characterized in that** the composition comprises the organic compound as claimed in any one of claims 1 to 10 and at least one organic solvent, or the composition comprises the mixture as claimed in claim 10 and the at least one organic solvent.

**13.** An organic light-emitting device, **characterized in that** the organic light-emitting device comprises:

a first electrode;
a second electrode disposed opposite to the first electrode; and
an organic functional layer disposed between the first electrode and the second electrode, wherein the organic functional layer comprises one or more organic compound as claimed in any one of claims 1 to 10, or the organic functional layer comprises the mixture as claimed in claim 11, or the organic functional layer comprises the composition as claimed in claim 12.

**14.** The organic light-emitting device of claim 11, **characterized in that** the organic functional layer further comprises a light-emitting layer comprising a host material and a guest material, wherein the guest material comprises one or more organic compounds.

**15.** A display panel, **characterized in that** the display panel comprises the organic light-emitting device as claimed in claim 13 or 14.

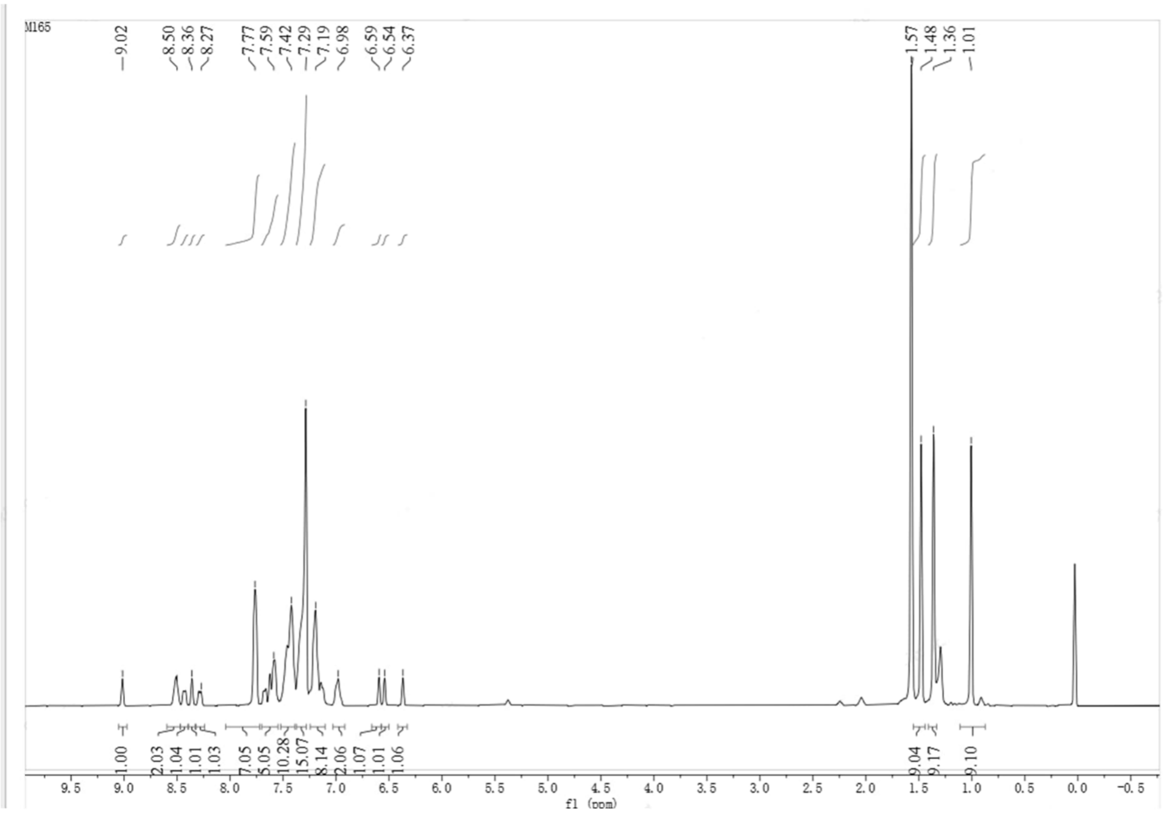
M165
9.02
8.50
8.36
8.27
7.77
7.59
7.42
7.29
7.19
6.98
6.59
6.54
6.37
1.57
1.48
1.36
1.01
1.00
2.03
1.04
1.01
1.03
7.05
5.05
10.28
15.07
8.14
2.06
1.07
1.01
1.06
9.04
9.17
9.10
f1 (ppm)

FIG. 1

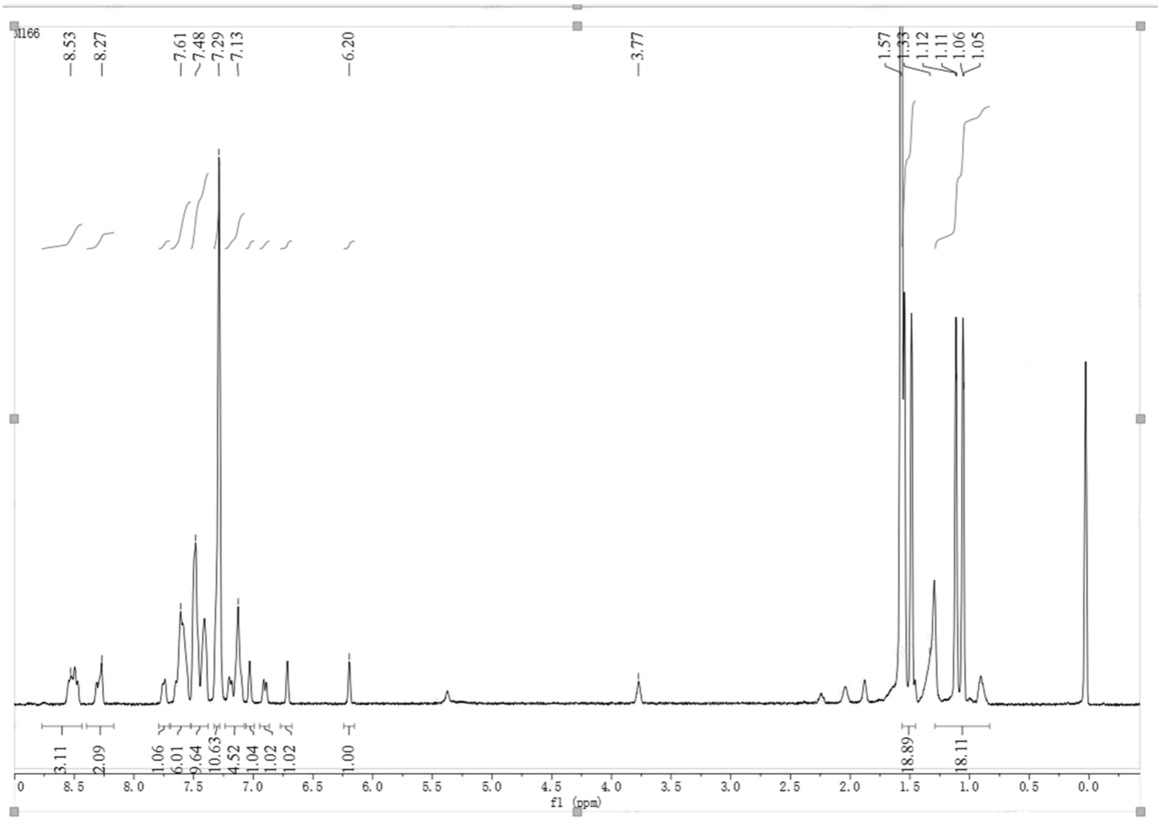
M166
8.53
8.27
7.61
7.48
7.29
7.13
6.20
3.77
1.57
1.33
1.12
1.11
1.06
1.05
3.11
2.09
1.06
6.01
9.64
10.63
4.52
1.04
1.02
1.02
1.00
18.89
18.11
f1 (ppm)

FIG. 2

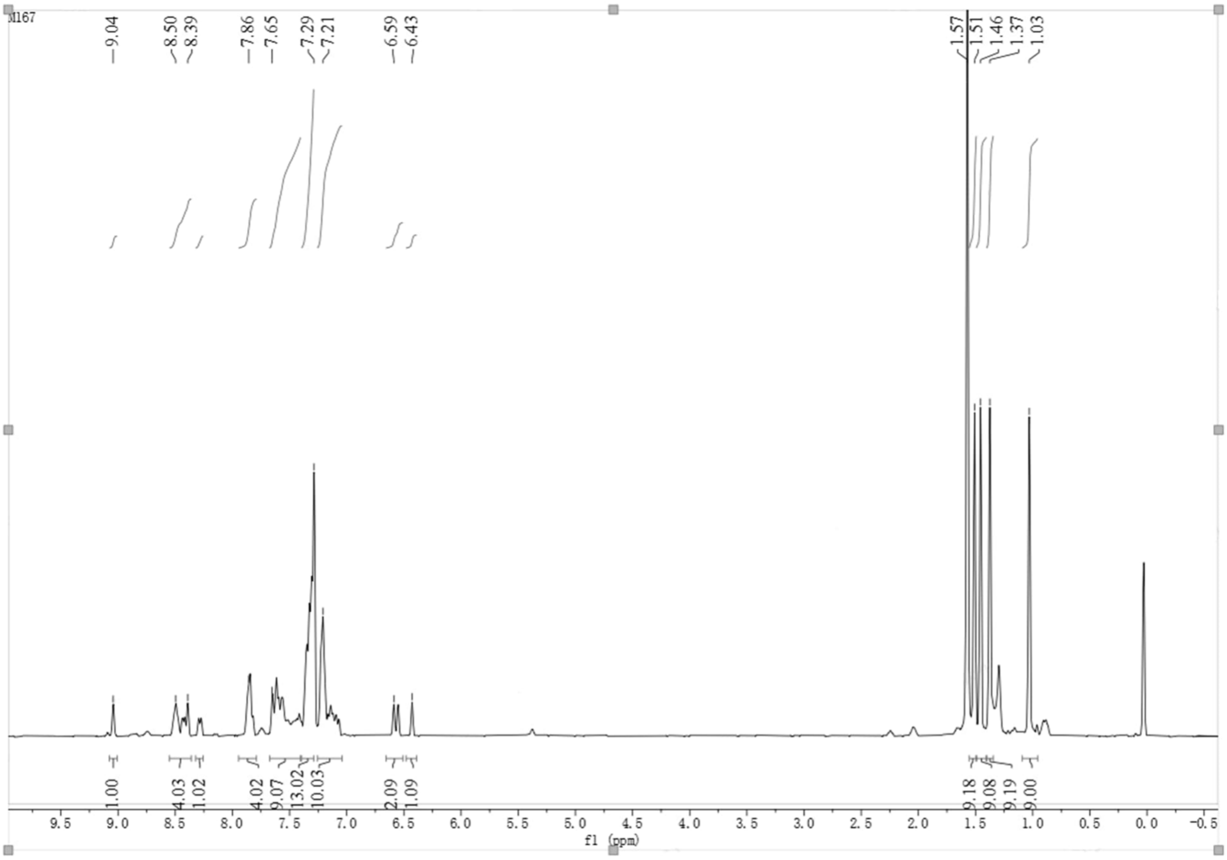
9.04
8.50
8.39
7.86
7.65
7.29
7.21
6.59
6.43
1.57
1.51
1.46
1.37
1.03
1.00
4.03
1.02
4.02
9.07
13.02
10.03
2.09
1.09
9.18
9.08
9.19
9.00
f1 (ppm)

FIG. 3

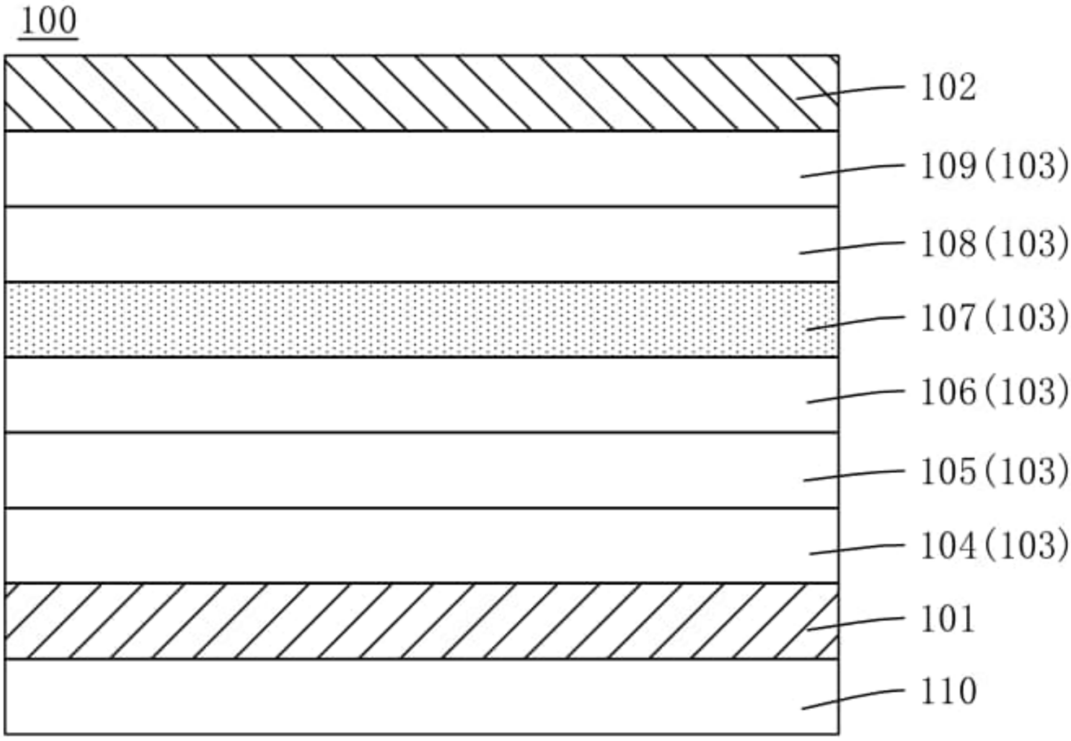
100
102
109(103)
108(103)
107(103)
106(103)
105(103)
104(103)
101
110

FIG. 4

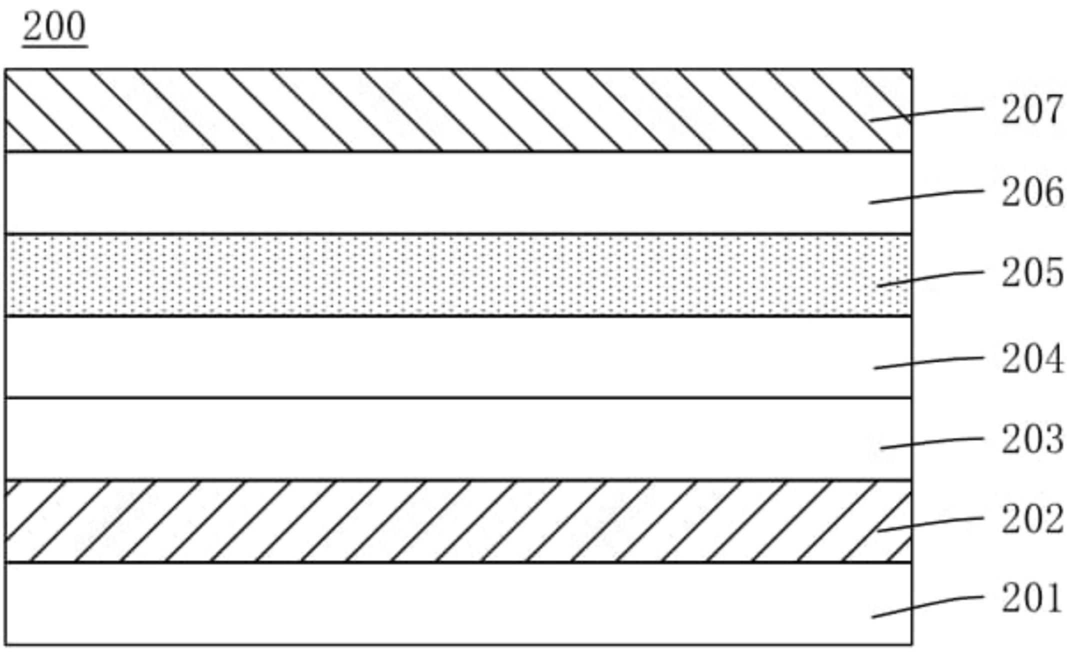


FIG. 5

Europäisches Patentamt
European Patent Office
Office européen des brevets

# EUROPEAN SEARCH REPORT

Application Number
EP 25 21 2713

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | DATABASE REAXYS [Online]<br><br>30 April 2024 (2024-04-30), Zhejiang Huaxian Optoelectronics Technology: "Boron-nitrogen compound containing imidazole and derivative groups, organic electroluminescent device and application - CN117946146 A", XP093353290, Database accession no. XRN 60229700, 60229702, 60229705<br>* abstract *<br>& CN 117 946 146 A (ZHEJIANG UIVOLED PHOTOELECTRIC TECH CO LTD) 30 April 2024 (2024-04-30)<br>----- | 1-5,9, 11-15 | INV.<br>C07F5/02<br>C07F7/08<br>C09K11/06<br>H10K50/11 |
| X | DATABASE REAXYS [Online]<br><br>26 January 2024 (2024-01-26), Shenzhen China Star Optoelectronics Semiconductor Display Tech: "Organic compound, mixture, composition, organic light-emitting device and display panel - CN117447497 A", XP093353289, Database accession no. XRN 60373336 | 1-3,5,9, 11-15 | |
| A | * abstract *<br>& CN 117 447 497 A (SHENZHEN CHINA STAR OPTOELECTRONICS SEMICONDUCTOR DISPLAY TECH CO LTD) 26 January 2024 (2024-01-26)<br>----- | 4,6-8,10 | TECHNICAL FIELDS SEARCHED (IPC)<br>C07F<br>H05B<br>C07B<br>C09K<br>H10K |
| X | US 2022/271226 A1 (HEO DONG UK [KR] ET AL) 25 August 2022 (2022-08-25) | 1,9, 11-15 | |
| A | * claim 12 *<br>* abstract *<br>----- | 2-8,10 | |

The present search report has been drawn up for all claims

| Place of search | Date of completion of the search | Examiner |
|---|---|---|
| The Hague | 14 January 2026 | Eberhard, Michael |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons
& : member of the same patent family, corresponding document

EPO FORM 1503 03.82 (P04C01)

# ANNEX TO THE EUROPEAN SEARCH REPORT ON EUROPEAN PATENT APPLICATION NO.

EP 25 21 2713

This annex lists the patent family members relating to the patent documents cited in the above-mentioned European search report. The members are as contained in the European Patent Office EDP file on
The European Patent Office is in no way liable for these particulars which are merely given for the purpose of information.

14-01-2026

| Patent document cited in search report | Publication date | Patent family member(s) | Publication date |
|---|---|---|---|
| US 2022271226 A1 | 25-08-2022 | CN 113924665 A | 11-01-2022 |
| | | KR 20210067943 A | 08-06-2021 |
| | | KR 20210067944 A | 08-06-2021 |
| | | US 2022271226 A1 | 25-08-2022 |
| | | WO 2021107699 A1 | 03-06-2021 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 201141110 A